(19) Europäisches Patentamt
European Patent Office
Office européen des brevets

(11) **EP 4 596 655 A1**

(12) **EUROPEAN PATENT APPLICATION**

(43) Date of publication:
**06.08.2025 Bulletin 2025/32**

(21) Application number: **25154346.8**

(22) Date of filing: **28.01.2025**

(51) International Patent Classification (IPC):
***C09K 11/62*** *(2006.01)*

(52) Cooperative Patent Classification (CPC):
**C09K 11/621**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **31.01.2024 KR 20240015313**

(71) Applicant: **Samsung Electronics Co., Ltd.**
**Suwon-si, Gyeonggi-do 16677 (KR)**

(72) Inventors:
- **SON, Dae-Yong**
  **16678 Suwon-si (KR)**
- **BAE, Min Jong**
  **16678 Suwon-si (KR)**
- **CHAE, Sue In**
  **16678 Suwon-si (KR)**
- **KIM, Tae-Gon**
  **16678 Suwon-si (KR)**
- **KIM, Taekhoon**
  **16678 Suwon-si (KR)**
- **WON, Nayoun**
  **16678 Suwon-si (KR)**
- **KIM, Seon-Yeong**
  **16678 Suwon-si (KR)**
- **LIM, Mi Hye**
  **16678 Suwon-si (KR)**

(74) Representative: **Elkington and Fife LLP**
**Prospect House**
**8 Pembroke Road**
**Sevenoaks, Kent TN13 1XR (GB)**

(54) **SEMICONDUCTOR NANOPARTICLE, METHOD OF PRODUCING THE SAME AND ELECTRONIC DEVICE INCLUDING THE SAME**

(57) A semiconductor nanoparticle, a method of producing the nanoparticle, and an electronic device including the same. The semiconductor nanoparticle includes silver, indium, gallium, and sulfur, where in the semiconductor nanoparticle, a mole ratio of gallium to indium (Ga:In) is greater than or equal to about 6.7:1 and less than or equal to about 40:1, a mole ratio of silver to indium (Ag:In) is greater than or equal to about 5:1 and less than or equal to about 30:1, the semiconductor nanoparticle is configured to emit light, and a full width at half maximum of a luminescent spectrum of the light is greater than or equal to about 10 nm and less than or equal to about 50 nm.

FIG. 2B

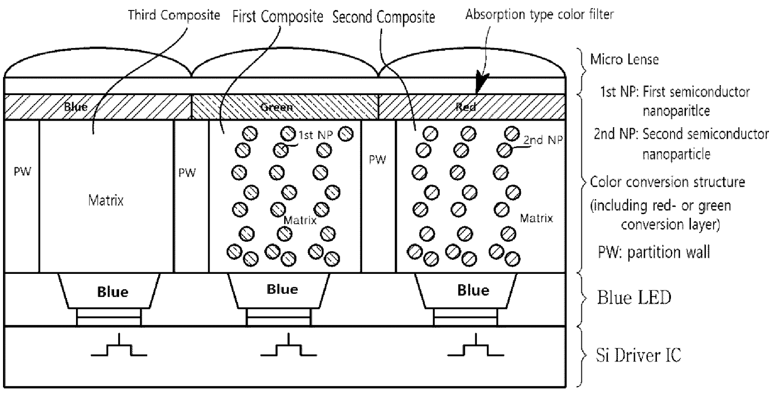


EP 4 596 655 A1

Processed by Luminess, 75001 PARIS (FR)

## Description

FIELD OF THE INVENTION

A semiconductor nanoparticle, a method of producing the nanoparticle, and an electronic device including the semiconductor nanoparticle are disclosed, including a color conversion panel.

BACKGROUND OF THE INVENTION

A semiconductor nanoparticle may exhibit different aspects, characteristics, or properties than a corresponding bulk material having substantially the same composition. For example, the semiconductor nanoparticle may have different physical properties based on the nanostructure (e.g., bandgap energy, a luminescent property, or the like). The semiconductor nanoparticle may be configured to emit light upon excitation by incident light or an applied voltage. The luminescent nanostructure may find applicability in a variety of devices (e.g., a display panel or an electronic device including the display panel). From an environmental point of view, developing a luminescent nanoparticle that does not contain a harmful heavy metal, such as cadmium, and yet achieving an improvement in one or more luminescent or optical properties is desirable.

SUMMARY OF THE INVENTION

An aspect relates to a semiconductor nanoparticle or a population thereof.

An aspect relates to a manufacturing method for manufacturing semiconductor nanoparticles that exhibit improved physical properties and/or with an increase in yield.

An aspect relates to a composition (e.g., an ink composition) including the semiconductor nanoparticle.

An aspect relates to a color conversion panel including the semiconductor nanoparticle.

An aspect relates to an electronic device (e.g., a display device) including the semiconductor nanoparticle or the color conversion panel.

An aspect provides a semiconductor nanoparticle including silver, indium, gallium, and sulfur. In the semiconductor nanoparticle, a mole ratio of gallium to indium (Ga:In) is greater than or equal to about 6.7:1 and less than or equal to about 40:1. A mole ratio of silver to indium (Ag:In) is greater than or equal to about 5:1 and less than or equal to about 30:1. The semiconductor nanoparticle is configured to emit light, and a full width at half maximum of a luminescent spectrum of the light is greater than or equal to about 10 nm and less than or equal to about 50 nm.

The semiconductor nanoparticle may include a Group 11-13-16 compound containing silver, indium, gallium, and sulfur. The semiconductor nanoparticle may include a first semiconductor nanocrystal containing silver, indium, gallium, and sulfur and a second semiconductor nanocrystal containing silver, gallium, and sulfur.

The semiconductor nanoparticle may further include zinc. The semiconductor nanoparticle may include a semiconductor nanocrystal containing zinc, sulfur, and optionally gallium (e.g., a third semiconductor nanocrystal or a fourth semiconductor nanocrystal).

In the semiconductor nanoparticle, a mole ratio of gallium to indium (Ga:In) may be greater than or equal to about 10.5:1, greater than or equal to about 15:1, greater than or equal to about 15.5:1, or greater than or equal to about 20:1. In the semiconductor nanoparticle, a mole ratio of gallium to indium (Ga:In) may be less than or equal to about 37:1, less than or equal to about 36:1, or less than or equal to about 35:1.

In the semiconductor nanoparticle, a mole ratio of silver to indium (Ag:In) may be greater than or equal to about 6.5:1, greater than or equal to about 7:1, greater than or equal to about 10:1, and less than or equal to about 25:1, less than or equal to about 20:1 or less than or equal to about 17:1.

In the semiconductor nanoparticle, a mole ratio of a sum of indium and gallium to silver (In+Ga):Ag) may be greater than or equal to about 1.3:1, greater than or equal to about 1.4:1 or greater than or equal to about 1.45:1, and less than or equal to about 2.5:1, less than or equal to about 2.0:1, or less than or equal to about 1.65:1.

In the semiconductor nanoparticle, a mole ratio of indium to sulfur (In:S) may be greater than or equal to about 0.005:1, or greater than or equal to about 0.01:1, and less than or equal to about 0.1:1, or less than or equal to about 0.08:1.

In the semiconductor nanoparticle, a mole ratio of gallium to sulfur (Ga:S) may be greater than or equal to about 0.3:1, greater than or equal to about 0.4:1, or greater than or equal to about 0.48:1, and less than or equal to about 0.85:1, less than or equal to about 0.65:1, or less than or equal to about 0.55:1.

In the semiconductor nanoparticle, a mole ratio of a sum of indium and gallium to sulfur [(In+Ga):S] may be greater than or equal to about 0.4:1, or greater than or equal to about 0.55:1, and less than or equal to about 0.85:1, less than or equal to about 0.75:1, or less than or equal to about 0.67:1.

In the semiconductor nanoparticle, a mole ratio of silver to sulfur (Ag:S) may be greater than or equal to about 0.33:1, greater than or equal to about 0.35:1, and less than or equal to about 0.45:1, less than or equal to about 0.44:1.

In the semiconductor nanoparticle, a mole ratio of silver to a sum of silver, indium, and gallium [Ag:(Ag+In+Ga)] may be greater than or equal to about 0.31:1, or greater than or equal to about 0.38:1, and less than or equal to about 0.42:1, or less than or equal to about 0.40:1.

In the semiconductor nanoparticle, a mole ratio of sulfur to a sum of silver, indium, and gallium [S:(Ag+In+Ga)] may be greater than or equal to about 0.8:1, or greater than or equal to about 0.92:1, and less than or equal to about 1.12:1, less than or equal to about 1.1:1, less than or equal to about 1.08 :1, or less than or equal to about 1.06:1.

The semiconductor nanoparticle may have a charge balance value defined by the following Equation 1 that is greater than or equal to about 0.95 and less than or equal to about 1.3, or less than or equal to about 1.2:

Equation 1A

$$\text{charge balance value} = \{[Ag] + 3([In]+[Ga])\}/(2[S])$$

wherein, in Equation 1A, [Ag], [In], [Ga], and [S] are molar amounts of silver, indium, gallium, and sulfur in the semiconductor nanoparticle, respectively.

The semiconductor nanoparticle may exhibit a quantum yield (e.g., an absolute quantum yield, hereinafter, "quantum yield") of greater than or equal to about 40 percent (%), or greater than or equal to about 60%. The light or the semiconductor nanoparticle may have a maximum emission wavelength of greater than or equal to about 480 nanometers (nm) to less than or equal to about 650 nm.

The light may be a green light.

A maximum emission wavelength of the (green) light or the semiconductor nanoparticle may be greater than or equal to about 500 nm, greater than or equal to about 505 nm to less than or equal to about 580 nm, or less than or equal to about 550 nm.

The full width at half maximum may be greater than or equal to about 15 nm and less than or equal to about 45 nm.

In an ultraviolet-visible (UV-Vis) absorption spectroscopy, the semiconductor nanoparticle may exhibit a ratio of absorption at 350 nm to absorption at 370 nm that is less than or equal to about 1.2:1, or less than or equal to about 1.1:1. In the UV-Vis absorption spectroscopy, the semiconductor nanoparticle may exhibit a ratio of absorption at 350 nm to absorption at 370 nm that is greater than or equal to about 0.1:1, or greater than or equal to about 0.3:1.

The semiconductor nanoparticle may further include bromine.

In the semiconductor nanoparticle, an amount of bromine may be, based on an amount of indium, greater than or equal to about 0.05 mole percent (mol%), greater than or equal to about 0.1 mol%, greater than or equal to about 0.3 mol%, greater than or equal to about 0.4 mol%, greater than or equal to about 0.5 mol%, greater than or equal to about 1 mol% or greater than or equal to about 3 mol%, and less than or equal to about 3200 mol% (e.g., a ratio of bromine to indium (Br:In) is 32:1), less than or equal to about 3000 mol%, less than or equal to about 2000 mol%, less than or equal to about 1000 mol%, less than or equal to about 500 mol%, less than or equal to about 100 mol%, or less than or equal to about 10 mol%.

In an embodiment, a method of manufacturing the semiconductor nanoparticle includes combining (e.g., adding) (i) a first semiconductor nanocrystal including, silver, a group 13 element, and a chalcogen element (ii) a sulfur precursor; (iii) a gallium precursor, and (e.g., to) (iv) a medium comprising an organic solvent to provide a reaction mixture; and heating the reaction mixture (or the medium) (e.g., at a predetermined temperature).

The gallium precursor includes gallium bromide.

The method includes adding a silver compound to the reaction mixture. The silver compound may be added to the medium in an amount of greater than or equal to about 0.0001 mol%, greater than or equal to about 0.001 mol%, greater than or equal to about 0.003 mol%, greater than or equal to about 0.004 mol%, greater than or equal to about 0.005 mol%, greater than or equal to about 0.01 mol%, greater than or equal to about 0.03 mol%, greater than or equal to about 0.05 mol%, greater than or equal to about 0.052 mol%, greater than or equal to about 0.1 mol%, greater than or equal to about 0.2 mol%, or greater than or equal to about 0.5 mol% and less than or equal to about 50 mol %, for example, less than or equal to about 25 mol%, with respect to the gallium precursor.

The amount of the silver compound may be greater than or equal to about 0.03 mol%, greater than or equal to about 0.05 mol%, or greater than or equal to about 1 mol % and less than or equal to about 12 mol%. The silver compound may include a silver carboxylate, silver acetylacetonate, silver halide, or a combination thereof.

The predetermined temperature may be greater than or equal to about 120°C, for example, greater than or equal to about 180°C, to less than or equal to about 380°C. The medium may be heated at a temperature of greater than or equal to about 220°C to less than or equal to about 280°C.

The method may include adding the first semiconductor nanocrystal and the gallium precursor to the medium including the organic solvent, the sulfur precursor, and the organic ligand.

The gallium precursor may further include or may not include a gallium chloride, a gallium iodide, or a combination thereof.

The gallium precursor may include gallium bromide and gallium chloride (or gallium iodide), and the amount of the

gallium chloride (or gallium iodide), per 1 mole of gallium bromide, may be greater than or equal to about 0.001 moles, greater than or equal to about 0.005 moles, greater than or equal to about 0.01 moles, greater than or equal to about 0.05 moles, greater than or equal to about 0.1 moles, or greater than or equal to about 0.5 moles, and less than or equal to about 0.8 moles.

In an embodiment an ink composition may include the aforementioned semiconductor nanoparticle and a liquid vehicle. A population of the semiconductor nanoparticle may be dispersed within the liquid vehicle. The liquid vehicle may include a liquid monomer, an organic solvent, or a combination thereof. The ink composition may be substantially free of a volatile organic solvent. The ink composition may further include a metal oxide nanoparticle.

In an aspect, a semiconductor nanoparticle composite may include a matrix and the semiconductor nanoparticle, wherein the semiconductor nanoparticle is dispersed in the matrix. The semiconductor nanoparticle composite may be a patterned film. The semiconductor nanoparticle composite may be a sheet in which first semiconductor nanoparticles emitting a first light and second semiconductor nanoparticles emitting a second light are mixed, wherein the first light and the second light may be different.

In an embodiment, the semiconductor nanoparticle composite may exhibit an internal quantum efficiency (IQE) or an external quantum efficiency (EQE) of greater than or equal to about 50% and the IQE and the EQE are defined by Equation 2 and Equation 3, respectively:

Equation 2

$$\text{Internal quantum efficiency (\%)} = [A/(B-B')] \times 100$$

Equation 3

$$\text{External quantum efficiency (\%)} = [A/B] \times 100$$

wherein:

A: amount of a first light emitted from the semiconductor nanoparticle composite
B: amount of irradiated incident light
B': amount of the irradiated incident light passing through the semiconductor nanoparticle-polymer composite.

The semiconductor nanoparticle-polymer composite may be heat-treated at 180°C for 30 minutes, and a process maintenance percentage obtained by the Equation 4 may be greater than or equal to about 50%:

Equation 4

$$\text{Process maintenance percentage (\%)} = [QE2/QE1] \times 100.$$

wherein

QE1: quantum efficiency of the semiconductor nanoparticle composite before the heat treatment
QE2: quantum efficiency of the semiconductor nanoparticle composite after the heat treatment.

In Equation 4, the quantum efficiency may be an internal quantum efficiency or an external quantum efficiency.

An aspect provides a color conversion layer (e.g., a color conversion structure) including a color conversion region including the aforementioned semiconductor nanoparticles. In an embodiment, a color conversion panel may include a color conversion layer (e.g., a color conversion structure) including a color conversion region and optionally a partition wall defining each region of the color conversion layer. The color conversion region may include a first region corresponding to the first pixel. The first region includes a first composite and the first composite may include a matrix and a semiconductor nanoparticle dispersed in the matrix, wherein the first region is configured to emit a first light.

In an embodiment, a display panel (or a display device) may include a light source and the semiconductor nanoparticle composite. In an embodiment, a display panel may include a light emitting panel (or a light source) and the color conversion panel, and optionally a light transmitting layer located between the light emitting panel and the color conversion panel.

The light emitting panel (or a light source) may be configured to provide (or provides) an incident light to the color conversion panel. The incident light may include a blue light, and, optionally, a green light. The blue light may have a peak emission wavelength of about 440 nm to about 460 nm, or about 450 nm to about 455 nm.

The light source may include an organic light emitting diode (OLED), a micro LED, a mini LED, an LED including a nanorod, or a combination thereof.

In an embodiment, an electronic device (or a display device) may include the color conversion panel or the display panel.

The electronic device or the display device may include a virtual reality device, an augmented reality device, a portable terminal device, a monitor, a note PC, a television, an electronic display board, or an electronic part for an automobile or a vehicle.

The semiconductor nanoparticles of an embodiment may exhibit improved process stability. The polymer composite including the semiconductor nanoparticle of an embodiment can minimize an increase in a trap light emission and a decrease in luminous efficiency caused by high-temperature treatment.

## BRIEF DESCRIPTION OF THE DRAWINGS

The above and other aspects, features, and advantages of certain exemplary embodiments will be more apparent from the following detailed description taken in conjunction with the accompanying drawings.

FIG. 1A is a flowchart showing pattern formation process (photolithography method) using the ink composition of an embodiment.
FIG. 1B is a flowchart showing a pattern forming process (inkjet method) using the ink composition of an embodiment.
FIG. 2A is a schematic cross-sectional view of a color conversion panel according to an embodiment.
FIG. 2B is a cross-sectional view of an electronic device (display device) including a color conversion panel according to an embodiment.
FIG. 3A is a perspective view illustrating a display panel including a color conversion panel according to an embodiment.
FIG. 3B is an exploded view of a display device according to an embodiment.
FIG. 3C is a cross-sectional view of the display panel of FIG. 3A.
FIG. 4 is an exploded view of a display device according to an embodiment.
FIG. 5A is a plan view illustrating a pixel arrangement of the display panel of FIG. 3A.
FIGS. 5B, 5C, 5D, and 5E are cross-sectional views showing light emitting devices, respectively, according to an embodiment.
FIG. 6 is a cross-sectional view of the display panel of FIG. 5A taken along line IV-IV.
FIG. 7A is a schematic cross-sectional view of a display device (e.g., a liquid crystal display device) according to an embodiment.
FIG. 7B is a schematic cross-sectional view of an electronic device (e.g., a light emitting device) according to an embodiment.
FIG. 8 is an UV-Vis absorption spectrum of the semiconductor nanoparticle prepared in Example 5

## DETAILED DESCRIPTION OF THE EMBODIMENTS

Advantages and features of the techniques described hereinafter, and methods of achieving them, will become apparent with reference to the exemplary embodiments described below in further detail in conjunction with the accompanying drawings. However, the embodiments should not be construed as being limited to the exemplary embodiments set forth herein. If not defined otherwise, all terms (including technical and scientific terms) as used herein may be defined as commonly understood by one having ordinary skill in the art. The terms defined in a generally-used dictionary may not be interpreted ideally or exaggeratedly unless clearly defined. In addition, unless explicitly described to the contrary, the word "comprise" and variations such as "comprises" or "comprising," will be understood to imply the inclusion of stated elements but not the exclusion of any other elements.

In the drawings, the thickness of layers, films, panels, regions, etc., are exaggerated for clarity. Like reference numerals designate like elements throughout the specification.

It will be understood that when an element such as a layer, film, region, or substrate is referred to as being "on" another element, it can be directly on the other element or intervening elements may also be present. In contrast, when an element is referred to as being "directly on" another element, there are no intervening elements present.

As used herein, the singular forms "a," "an," and "the" are intended to include the plural forms, including "at least one," unless the context clearly indicates otherwise. For example, the wording "semiconductor nanoparticle" may refer to a single semiconductor nanoparticle or may refer to a plurality of semiconductor nanoparticles. "At least one" is not to be construed as being limited to "a" or "an." "Or" means "and/or." As used herein, the term "and/or" includes any and all combinations of one or more of the associated listed items.

It will be understood that, although the terms "first," "second," "third" etc. may be used herein to describe various

elements, components, regions, layers, and/or sections, these elements, components, regions, layers, and/or sections should not be limited by these terms. These terms are only used to distinguish one element, component, region, layer, or section from another element, component, region, layer, or section. Thus, "a first element," "component," "region," "layer", or "section" discussed below could be termed a second element, component, region, layer, or section without departing from the teachings of the present embodiments.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within $\pm$ 10%, 5% of the stated value.

As used herein, the expression "not including cadmium (or other harmful heavy metal)" may refer to the case in which a concentration of cadmium (or other harmful heavy metal) may be less than or equal to about 100 parts per million by weight (ppmw), less than or equal to about 50 ppmw, less than or equal to about 10 ppmw, less than or equal to about 1 ppmw, less than or equal to about 0.1 ppmw, less than or equal to about 0.01 ppmw, or about zero. In one or more embodiments, substantially no amount of cadmium (or other harmful heavy metal) may be present or, if present, an amount of cadmium (or other harmful heavy metal) may be less than or equal to a detection limit or as an impurity level of a given analysis tool.

Hereinafter, as used herein, when a definition is not otherwise provided, "substituted" refers to replacement of at least one hydrogen of a compound by a substituent selected from a C1 to C30 alkyl group, a C2 to C30 alkenyl group, a C2 to C30 alkynyl group, a C6 to C30 aryl group, a C7 to C30 alkylaryl group, a C7 to C30 arylalkyl group, a C6 to C30 aryloxy group, a C6 to C30 arylthio group, a C1 to C30 alkoxy group, a C1 to C30 alkylthio group, a C1 to C30 heteroalkyl group, a C3 to C30 heteroalkylaryl group, a C2 to C30 alkylheteroaryl group, a C2 to C30 heteroarylalkyl group, a C1 to C30 heteroaryloxy group, a C1 to C30 heteroarylthio group, a C3 to C30 cycloalkyl group, a C3 to C15 cycloalkenyl group, a C6 to C30 cycloalkynyl group, a C2 to C30 heterocycloalkyl group, a halogen (-F, -Cl, -Br, or -I), a hydroxy group (-OH), a nitro group ($-NO_2$), a cyano group (-CN), an amino group or an amine group (-NRR' wherein R and R' are each independently hydrogen or a C1 to C6 alkyl group), an azido group ($-N_3$), an amidino group ($-C(=NH)NH_2$), a hydrazino group ($-NHNH_2$), a hydrazono group ($=N(NH_2)$), an aldehyde group (-C(=O)H), a carbamoyl group ($-C(O)NH_2$), a thiol group (-SH), an ester group (-C(=O)OR, wherein R is a C1 to C6 alkyl group or a C6 to C12 aryl group), a carboxyl group (-COOH) or a salt thereof (-C(=O)OM, wherein M is an organic or inorganic cation, a sulfonic acid group (-SOsH) or a salt thereof (-SOsM, wherein M is an organic or inorganic cation), a phosphoric acid group ($-PO_3H_2$) or a salt thereof (-POsMH or $-PO_3M_2$, wherein M is an organic or inorganic cation), or a combination thereof. The specified number or range of carbon atoms in a group is exclusive of any substituents.

In addition, when a definition is not otherwise provided below, "hetero" means a case including 1 to 3 heteroatoms such as N, O, P, Si, S, Se, Ge, or B.

In addition, the term "aliphatic hydrocarbon group" as used herein refers to a C1 to C30 linear or branched alkyl group, a C1 to C30 linear or branched alkenyl group, or a C1 to C30 linear or branched alkynyl group, and the term "aromatic organic group" as used herein refers to a C6 to C30 aryl group or a C2 to C30 heteroaryl group.

As used herein, the term "(meth)acrylate" refers to acrylate and/or methacrylate.

As used herein, the term "Group" refers to a Group of Periodic Table.

As used herein, the terms "a nanoparticle" and "a nanostructure" refer to a structure having at least one region or characteristic dimension with a nanoscale dimension. In one or more embodiments, the dimension of the nanoparticle or the nanostructure may be less than about 500 nm, less than about 300 nm, less than about 250 nm, less than about 150 nm, less than about 100 nm, less than about 50 nm, or less than about 30 nm. The nanoparticle or nanostructure may have any shape, such as a nanowire, a nanorod, a nanotube, a multi-pod type shape having two or more pods, a nanodot, or the like, but embodiments are not limited thereto. The nanoparticle or nanostructure may be, for example, substantially crystalline, substantially monocrystalline, polycrystalline, amorphous, or a combination thereof.

A quantum dot may be, for example, a semiconductor-containing nanocrystal particle that can exhibit a quantum confinement or exciton confinement effect, and is a type of a luminescent nanostructure (e.g., capable of emitting light by energy excitation). Herein, a shape of the "quantum dot" or the nanoparticle is not limited unless otherwise expressly defined.

As used herein, the term "dispersion" refers to a dispersion in which a dispersed phase is a solid, and a

continuous medium includes a liquid or a solid different from the dispersed phase. It is to be understood that the "dispersion" may be a colloidal dispersion in which the dispersed phase has a dimension of greater than or equal to about 1 nm, for example, greater than or equal to about 2 nm, greater than or equal to about 3 nm, or greater than or equal to about 4 nm and less than or equal to several micrometers (μm), (e.g., less than or equal to about 2 μm, less than or equal to about 1 μm, less than or equal to about 900 nm, less than or equal to about 800 nm, less than or equal to about 700 nm, less than or equal to about 600 nm, or less than or equal to about 500 nm).

Herein, a dimension (a size, a diameter, or a thickness, etc.) may be a value for a single entity or an average value for a plurality of nanoparticles. As used herein, the term "average" (e.g., an average size of the quantum dot) may be a mean value or a median value. In one or more embodiments, the average may be "mean" average.

As used herein, the term "maximum emission wavelength" is the wavelength at which a given emission spectrum of the light reaches its maximum.

In one or more embodiments, a quantum efficiency may be readily and reproducibly determined using commercially available equipment (e.g., from Hitachi or Hamamatsu, etc.) and referring to manuals provided by, for example, respective equipment manufacturers. The quantum efficiency (which can be interchangeably used with the term "quantum yield" (QY)) may be measured in a solution state or a solid state (i.e., in a composite). In one or more embodiments, the quantum efficiency (or the quantum yield) is the ratio of photons emitted to photons absorbed by the nanostructure or population thereof. In one or more embodiments, the quantum efficiency may be measured by any method. For example, there may be two methods for measuring the fluorescence quantum yield or efficiency: the absolute method and the relative method. The quantum efficiency measured by the absolute method may be referred to as an absolute quantum efficiency.

In the absolute method, the quantum efficiency may be obtained by detecting the fluorescence of all samples through an integrating sphere. In the relative method, the quantum efficiency of the unknown sample may be calculated by comparing the fluorescence intensity of a standard dye (a standard sample) with the fluorescence intensity of the unknown sample. Coumarin 153, Coumarin 545, Rhodamine 101 inner salt, Anthracene and Rhodamine 6G may be used as standard dyes according to their photoluminescence (PL) wavelengths, but embodiments are not limited thereto.

A full width at half maximum (FWHM) and a maximum emission (e.g., photoluminescence (PL) or electroluminescence (EL)) wavelength may be measured, for example, from a luminescence spectrum (for example, a photoluminescence spectrum or an electroluminescent spectrum) obtained by a spectrophotometer such as a fluorescence spectrophotometer or the like.

As used herein, the term "first absorption peak wavelength" refers to a wavelength at which a main peak first appears in a lowest energy region in the ultraviolet-visible (UV-Vis) absorption spectrum.

A semiconductor nanoparticle may be included in a variety of electronic devices. An electrical and/or an optical property of the semiconductor nanoparticle may be controlled for example, by the elemental composition of the semiconductor nanoparticle, the size of the semiconductor nanoparticle, and/or the shape of the semiconductor nanoparticle. In one or more embodiments, the semiconductor nanoparticle may be a semiconductor nanocrystal particle. The semiconductor nanoparticle such as a quantum dot may have a relatively large surface area per a unit volume, and thus, may exhibit a quantum confinement effect, exhibiting physical optical properties different from a corresponding bulk material having the same composition. Therefore, a semiconductor nanoparticle such as a quantum dot may absorb energy (e.g., incident light) supplied from an excitation source to form an excited state, which upon relaxation is capable of emitting an energy corresponding to its energy bandgap.

The semiconductor nanoparticle may also be used in a color conversion panel (e.g., a photoluminescent color filter). Unlike a white light-emitting back light unit used in a liquid crystal display device, in a display device including a quantum dot-containing color conversion panel or a luminescent type color filter, a quantum dot layer is used as a luminescent material and is disposed in a relatively front part of a device to convert an incident light (e.g., a blue light) provided from a light source to light of a different spectrum (for example, a green light or a red light). In such a color conversion panel, the color conversion of the excitation light may occur in a relatively front part of the device, the light may be scattered in all directions, which may address a viewing angle problem of the liquid crystal display, and a light loss problem caused by using an absorption type color filter may be addressed as well. As used herein, the term "color conversion panel" refers to an electronic device including a color conversion layer (or a color conversion structure).

In the display device including the color conversion panel, properties (e.g., an optical property, stability, or the like) of a luminescent nanostructure may have a direct effect on a displaying quality of the device. It may be desired for the luminescent material included in the color conversion panel disposed in a relatively front portion of the device to exhibit not only a relatively high luminous efficiency but also a relatively high absorbance with respect to an incident light. When a patterned film (e.g., a color filter) is used in the display device, a decreased absorbance to the incident light may be a direct cause of a blue light leakage, having an adversely effect on a color reproducibility (e.g., DCI match rate) of the device. An adoption of an absorption type color filter for preventing a blue leakage problem may lead to an additional decrease in a luminous efficiency. Such a lowered absorbance of the semiconductor nanoparticle may result in a reduced luminance in a device including the same.

Semiconductor nanoparticles may exhibit properties (e.g., optical properties and/or stability) that may be applicable to a device, but many of them may include a cadmium-containing compounds (e.g., a cadmium chalcogenide). The cadmium causes a serious environment/health problem and thus is one of the restricted elements in many countries. Therefore, in order to develop cadmium-free environment-friendly nanoparticles, in-depth research on nanocrystals based on Group III-V compounds has been conducted. However, cadmium-free nanoparticles including a Group III-V compound (e.g., indium phosphide) may come across a technological limit in the incident light absorbance and the full width at half maximum. Accordingly, there remains a technological need to develop an environmentally friendly nanoparticle that can exhibit a higher absorbance, a narrower the full width at half maximum, and a higher luminous efficiency in comparison with a cadmium-free nanoparticle based on a Group III-V compound, such as an indium phosphide.

In an embodiment, the semiconductor nanoparticle may not contain cadmium. The semiconductor nanoparticle may not contain mercury, lead, or a combination thereof. In an embodiment, the semiconductor nanoparticles may contain (a group 11-13-16 compound including) silver, indium, gallium, and sulfur. The semiconductor nanoparticle may have a size of greater than or equal to about 2 nanometers (nm), or greater than or equal to about 5 nm and less than or equal to about 50 nm, less than or equal to about 10 nm, or less than or equal to about 8 nm.

In an embodiment, the semiconductor nanoparticle may include a first semiconductor nanocrystal including (a group 11-13-16 compound including) silver, a group 13 element, and a chalcogen element. The first semiconductor nanocrystal may or may not further include zinc. The group 13 element may include indium, gallium, or a combination thereof. The chalcogen element may contain sulfur and optionally selenium. The first semiconductor nanocrystal may include silver, a Group 13 metal (e.g., indium, gallium, or a combination thereof), and a Group 16 element (e.g., sulfur, and optionally selenium). The first semiconductor nanocrystal may include a quaternary alloy semiconductor material based on a Group 11-13-16 compound including silver, indium, gallium, and sulfur. The semiconductor nanoparticle or the first semiconductor nanocrystal may include a silver indium gallium sulfide (hereinafter, abbreviated as AIGS). The first semiconductor nanocrystals may include $Ag(In_xGa_{1-x})S_2$ (x is greater than 0 and less than or equal to 1). The mole ratios between the components in the first semiconductor nanocrystal may be adjusted so that the final semiconductor nanoparticle may have a desired composition and an optical property (e.g., a maximum emission wavelength).

The semiconductor nanoparticle may further include a second semiconductor nanocrystal including gallium, sulfur, and optionally silver and having a composition different from that of the first semiconductor nanocrystal; an additional semiconductor nanocrystal (e.g., a third semiconductor nanocrystals and/or a fourth semiconductor nanocrystals); or a combination thereof. The second semiconductor nanocrystal may include a Group 13-16 compound, a Group 11-13-16 compound, or a combination thereof. The Group 13-16 compound may include a gallium sulfide, a gallium selenide, an indium sulfide, an indium selenide, an indium gallium sulfide, an indium gallium selenide, an indium gallium selenide sulfide, or a combination thereof. The second semiconductor nanocrystal may include gallium and a chalcogen element (sulfur, and optionally selenium). The second semiconductor nanocrystal may include a ternary alloy semiconductor material containing silver, gallium, and sulfur. The molar ratio between each component in the second semiconductor nanocrystal can be adjusted to achieve the desired composition and optical properties of the final semiconductor nanoparticle.

The additional semiconductor nanocrystal may include zinc, sulfur, and optionally gallium. In an embodiment, a third semiconductor nanocrystal may include zinc, gallium, and sulfur. A fourth semiconductor nanocrystal may include zinc and sulfur. The third semiconductor nanocrystal may include a zinc gallium sulfide. The fourth semiconductor nanocrystal may include a zinc sulfide.

The second semiconductor nanocrystal may cover at least a portion of the first semiconductor nanocrystal. The bandgap energy of the second semiconductor nanocrystal may differ from that of the first semiconductor nanocrystal. The bandgap energy of the second semiconductor nanocrystal may be greater than the bandgap energy of the first semiconductor nanocrystal. The bandgap energy of the second semiconductor nanocrystal may be less than the bandgap energy of the first semiconductor nanocrystal. The bandgap energy of the additional semiconductor nanocrystal (e.g., a third semiconductor nanocrystal or a fourth semiconductor nanocrystal) may be greater than the bandgap energy of the second semiconductor nanocrystal. The bandgap energy of an additional semiconductor nanocrystal (e.g., a third semiconductor nanocrystal or a fourth semiconductor nanocrystal) may be greater than the bandgap energy of the first semiconductor nanocrystal. A layer including the third semiconductor nanocrystal or the fourth semiconductor nanocrystal may be an outermost layer of the semiconductor nanoparticle.

The semiconductor nanoparticle may have a core-shell structure with a core and a shell disposed on the core. The core may include a first semiconductor nanocrystal, and the shell may include a second semiconductor nanocrystal. The shell may be a multi-layered shell, and the multi-layered shell may include a first shell layer disposed on the core, a second shell layer disposed on the first shell layer, and a third shell layer disposed on the second shell layer. The first shell layer may include a second semiconductor nanocrystal or a third semiconductor nanocrystal. The second shell layer may include a second semiconductor nanocrystal or a third semiconductor nanocrystal. The third shell layer may include an additional semiconductor nanocrystal (e.g., a third semiconductor nanocrystal and/or a fourth semiconductor nanocrystal)

including zinc, sulfur, and optionally gallium (including zinc chalcogenide or zinc gallium chalcogenide).

In an embodiment, the semiconductor nanoparticle may have a core multi-layer shell structure, such as AgInGaS/AgGaS, AgInGaS/AgGaS/GaS, AgInGaS/AgGaS/ZnGaS, AgInGaS/AgGaS/ZnS, or AgInGaS/AgGaS/ZnGaS/ZnS.

In the semiconductor nanoparticle, a concentration of indium may vary radially. In the semiconductor nanoparticle, the indium amount or concentration in an inner part of the semiconductor nanoparticle may differ from that in an outer part of the particle. In an embodiment, the indium amount or concentration in the portion adjacent to the surface (e.g., the outermost layer or shell) of the semiconductor nanoparticle may be lower than the indium amount or concentration in the inner part of the particle (or core). In an embodiment, the zinc amount or concentration in the portion adjacent to the surface (e.g., in an outermost layer) of the semiconductor nanoparticle may be higher than the zinc amount or concentration in an inner part of the particle (or core). In the semiconductor nanoparticle, the concentration of zinc may be higher in the outer part of the particle than in the inner part thereof. The core or the first semiconductor nanocrystal may not include zinc. In the shell, gallium may exhibit a radial concentration gradient (e.g., increasing or decreasing). In the shell, the concentration of gallium in the portion adjacent to the particle surface may be higher than the concentration of gallium in the portion adjacent to the core.

In an embodiment, a semiconductor nanoparticle including a Group 13 metal (indium, gallium) and a chalcogen element (sulfur) along with silver (Ag) can achieve the desired luminescent properties (e.g., an increased quantum yield with a reduced full width at half maximum) without containing cadmium, and can exhibit enhanced stability in subsequent processes (e.g., heat treatment). The group 11-13-16 compoundcontaining semiconductor nanoparticle according to an embodiment can achieve an improved optical property and stability by adjusting its composition (e.g., a molar ratio or a charge balance value of the elements as described herein) as described herein.

A display device containing a color conversion layer that includes semiconductor nanoparticles as a color conversion material may include or may not include a light source providing incident light of relatively short wavelengths (e.g., a blue LED or blue OLED). If present, the incident light (e.g., blue light) may have higher energy (e.g., approximately ~2.75 electron volt (eV) or less) compared to the colorconverted light such as red or green. It is desired to provide a color conversion layer that can maintain photoconversion efficiency and color purity despite repeated exposure to incident light to the color conversion layer. The preparation of the color conversion layer may involve a process of forming a composite that includes semiconductor nanoparticles, such as a polymer composite or a pattern of the composite, which may involve high-temperature processes. The inventors have found that when the AIGS-containing semiconductor nanoparticle is exposed to such high-temperature processes, it can exhibit a substantial decrease in photoconversion efficiency and a significant increase in trap emission (i.e., long-wavelength emission), for example, compared to its initial property before exposure.

For AIGS-containing semiconductor nanoparticles to be used as a color conversion layer, it may be necessary to ensure the stability of the AIGS semiconductor nanoparticles (e.g., process retention in terms of luminescent properties and trap emission). A semiconductor nanoparticle according to an embodiment may be manufactured by the method described herein and may include an inorganic layer (e.g., semiconductor nanocrystal shell coating) to provide the composition described herein. The inventors have found that, compared to semiconductor nanoparticles produced by a currently known shell coating process, the semiconductor nanoparticle produced by the method described herein may have the molar ratios and structures of the elements described herein and can exhibit maintenance of a desired level of a light emitting efficiency even after it undergoes film formation involving relatively high-temperature baking processes, and it can also show a suppressed trap emission to the desired level.

In an embodiment, the semiconductor nanoparticle includes silver, indium, gallium, and sulfur, and in the semiconductor nanoparticle, a molar ratio of gallium to indium (Ga:In) is greater than or equal to about 6.7:1, greater than or equal to about 19:1, or greater than or equal to about 20:1 and less than or equal to about 40:1, and a molar ratio of silver to indium (Ag:In) is greater than or equal to about 5:1 and less than or equal to about 20:1. The semiconductor nanoparticle may be configured to emit light (e.g., green light). The light may have a full width at half maximum of greater than or equal to about 10 nm and less than or equal to about 50 nm. The semiconductor nanoparticle may include a Group 11-13-16 compound containing silver, indium, gallium, and sulfur. The semiconductor nanoparticle may include a first semiconductor nanocrystal containing silver, indium, gallium, and sulfur, and a second semiconductor nanocrystal containing silver, gallium, and sulfur. The semiconductor nanoparticle may further include zinc. The semiconductor nanoparticle may further include a third semiconductor nanocrystal containing zinc, sulfur, and optionally gallium, a fourth semiconductor nanocrystal containing zinc and sulfur, or combinations thereof. The semiconductor nanoparticle may have a core-shell structure. The details of the first semiconductor nanocrystal, the second semiconductor nanocrystal, the third semiconductor nanocrystal, the fourth semiconductor nanocrystal, and the structure of the semiconductor nanoparticle are as described herein.

The semiconductor nanoparticle may further include or may not include lithium. The semiconductor nanoparticle may further include or may not include an alkali metal (e.g., lithium, sodium, potassium, etc.).

In the semiconductor nanoparticle, a mole ratio of gallium to indium (Ga:In) may be greater than or equal to about

7:1, greater than or equal to about 7.3:1, greater than or equal to about 7.5:1, greater than or equal to about 8:1, greater than or equal to about 8.5:1, greater than or equal to about 9:1, greater than or equal to about 9.5:1, greater than or equal to about 10:1, greater than or equal to about 10.5:1, greater than or equal to about 11:1, greater than or equal to about 12:1, greater than or equal to about 13:1, greater than or equal to about 14:1, greater than or equal to about 15:1, greater than or equal to about 15.5:1, greater than or equal to about 16:1, greater than or equal to about 16.5:1, greater than or equal to about 17:1, greater than or equal to about 17.5:1, greater than or equal to about 18:1, greater than or equal to about 18.5:1, greater than or equal to about 19:1, greater than or equal to about 19.5:1, or greater than or equal to about 20:1. In the semiconductor nanoparticle, a mole ratio of gallium to indium (Ga:In) may be less than or equal to about 40:1, less than or equal to about 38:1, less than or equal to about 37:1, less than or equal to about 36:1, less than or equal to about 35:1, less than or equal to about 34:1, less than or equal to about 33:1, less than or equal to about 32:1, less than or equal to about 31:1, less than or equal to about 30:1, less than or equal to about 29:1, less than or equal to about 28:1, less than or equal to about 27:1, less than or equal to about 26:1, less than or equal to about 25:1, less than or equal to about 24:1, less than or equal to about 23:1, less than or equal to about 22:1, less than or equal to about 21:1, less than or equal to about 20.3:1, or less than or equal to about 19.4:1.

In the semiconductor nanoparticle, a mole ratio of silver to indium (Ag:In) may be greater than or equal to about 4.9:1, greater than or equal to about 5:1, greater than or equal to about 5.05:1, greater than or equal to about 5.1:1, greater than or equal to about 5.2:1, greater than or equal to about 5.5:1, greater than or equal to about 5.7:1, greater than or equal to about 5.9:1, greater than or equal to about 6:1, greater than or equal to about 6.5:1, greater than or equal to about 7:1, greater than or equal to about 7.5:1, greater than or equal to about 8:1, greater than or equal to about 8.5:1, greater than or equal to about 9:1, greater than or equal to about 9.5:1, greater than or equal to about 10:1, greater than or equal to about 10.5:1, greater than or equal to about 11:1, greater than or equal to about 11.5:1, greater than or equal to about 12:1, greater than or equal to about 12.5:1, greater than or equal to about 13:1, greater than or equal to about 13.5:1, greater than or equal to about 14:1, greater than or equal to about 14.5:1, greater than or equal to about 15:1, greater than or equal to about 15.5:1, greater than or equal to about 16:1, greater than or equal to about 16.5:1, greater than or equal to about 17:1, greater than or equal to about 17.5:1, greater than or equal to about 18:1, greater than or equal to about 18.5:1, greater than or equal to about 19:1, greater than or equal to about 19.5:1, or greater than or equal to about 20:1. In the semiconductor nanoparticle, a mole ratio of silver to indium (Ag:In) may be less than or equal to about 30:1, less than or equal to about 29.5:1, less than or equal to about 29:1, less than or equal to about 28:1, less than or equal to about 27:1, less than or equal to about 26:1, less than or equal to about 25:1, less than or equal to about 24:1, less than or equal to about 23:1, less than or equal to about 22:1, less than or equal to about 21:1, less than or equal to about 20:1, less than or equal to about 19.4:1, less than or equal to about 18.2:1, less than or equal to about 17.3:1, less than or equal to about 17:1, less than or equal to about 16.2:1, less than or equal to about 15.7:1, less than or equal to about 14.4:1, less than or equal to about 12.2:1, less than or equal to about 12:1, less than or equal to about 11.9:1, less than or equal to about 11.5:1, less than or equal to about 11.2:1, less than or equal to about 10.5:1, or less than or equal to about 10.3:1.

In the semiconductor nanoparticle, the mole ratio of gallium to silver (Ga:Ag) may be greater than or equal to about 1:1, greater than or equal to about 1.1:1, greater than or equal to about 1.15:1, greater than or equal to about 1.2:1, greater than or equal to about 1.22:1, greater than or equal to about 1.29:1, greater than or equal to about 1.3:1, greater than or equal to about 1.33:1, greater than or equal to about 1.34:1, greater than or equal to about 1.36:1, greater than or equal to about 1.4:1, greater than or equal to about 1.46:1, greater than or equal to about 1.48:1, greater than or equal to about 1.5:1, greater than or equal to about 1.54:1, greater than or equal to about 1.6:1, or greater than or equal to about 1.65:1; less than or equal to about 3:1, less than or equal to about 2.9:1, less than or equal to about 2.8:1, less than or equal to about 2.75:1, less than or equal to about 2.5:1, less than or equal to about 2.2:1, less than or equal to about 2:1, less than or equal to about 1.9:1, less than or equal to about 1.8:1, less than or equal to about 1.75:1, less than or equal to about 1.7:1, less than or equal to about 1.65:1, less than or equal to about 1.6:1, less than or equal to about 1.58:1, less than or equal to about 1.55:1, less than or equal to about 1.5:1, less than or equal to about 1.45:1, less than or equal to about 1.4:1, or less than or equal to about 1.35:1; or a combination thereof.

In the semiconductor nanoparticle, a mole ratio of a sum of indium and gallium to silver [(In+Ga):Ag] may be greater than or equal to about 1.2:1, greater than or equal to about 1.3:1, greater than or equal to about 1.4:1, greater than or equal to about 1.41:1, greater than or equal to about 1.43:1, greater than or equal to about 1.45:1, greater than or equal to about 1.46:1, greater than or equal to about 1.48:1, greater than or equal to about 1.5:1, greater than or equal to about 1.63:1, greater than or equal to about 1.7:1, greater than or equal to about 1.83:1, greater than or equal to about 1.9:1, greater than or equal to about 1.94:1, or greater than or equal to about 2:1; less than or equal to about 3.5:1, less than or equal to about 3:1, less than or equal to about 2.4:1, less than or equal to about 2.37:1, less than or equal to about 2:1, less than or equal to about 1.96:1, less than or equal to about 1.95:1, less than or equal to about 1.9 :1, or less than or equal to about 1.65 :1; or a combination thereof.

In the semiconductor nanoparticle, a mole ratio of indium to sulfur (In:S) may be greater than or equal to about 0.005:1, greater than or equal to about 0.01:1, greater than or equal to about 0.015:1, greater than or equal to about 0.019:1, greater than or equal to about 0.02:1, greater than or equal to about 0.025:1, greater than or equal to about

0.029:1, greater than or equal to about 0.03:1, greater than or equal to about 0.035:1, greater than or equal to about 0.04:1, greater than or equal to about 0.045:1, greater than or equal to about 0.05:1, greater than or equal to about 0.055:1, greater than or equal to about 0.06:1, greater than or equal to about 0.065:1, or greater than or equal to about 0.07:1. In the semiconductor nanoparticle, a mole ratio of indium to sulfur (In:S) may be less than or equal to about 0.13:1, less than or equal to about 0.11:1, less than or equal to about 0.105:1, less than or equal to about 0.1:1, less than or equal to about 0.09:1, less than or equal to about 0.085:1, less than or equal to about 0.08:1, less than or equal to about 0.075:1, less than or equal to about 0.072:1, less than or equal to about 0.069:1, less than or equal to about 0.064:1, less than or equal to about 0.061:1, less than or equal to about 0.058:1, less than or equal to about 0.054:1, less than or equal to about 0.052:1, less than or equal to about 0.049:1, less than or equal to about 0.045:1, less than or equal to about 0.042:1, less than or equal to about 0.038:1, less than or equal to about 0.035:1, or less than or equal to about 0.032:1.

In the semiconductor nanoparticle, the mole ratio of gallium to sulfur (Ga:S) may be greater than or equal to about 0.3:1, greater than or equal to about 0.35:1, greater than or equal to about 0.4:1, greater than or equal to about 0.45:1, greater than or equal to about 0.48:1, greater than or equal to about 0.49:1, greater than or equal to about 0.51:1, greater than or equal to about 0.52:1, greater than or equal to about 0.53:1, greater than or equal to about 0.54:1, greater than or equal to about 0.55:1, greater than or equal to about 0.56:1, greater than or equal to about 0.57:1, greater than or equal to about 0.58:1, greater than or equal to about 0.59:1, greater than or equal to about 0.6:1, greater than or equal to about 0.63:1, greater than or equal to about 0.65:1, greater than or equal to about 0.67:1, greater than or equal to about 0.69:1, greater than or equal to about 0.7:1, or greater than or equal to about 0.72:1. In the semiconductor nanoparticle, the mole ratio of gallium to sulfur (Ga:S) may be less than or equal to about 1:1, less than or equal to about 0.95:1, less than or equal to about 0.9:1, less than or equal to about 0.85:1, less than or equal to about 0.8:1, less than or equal to about 0.79:1, less than or equal to about 0.75:1, less than or equal to about 0.77:1, less than or equal to about 0.73:1, less than or equal to about 0.71:1, less than or equal to about 0.7:1, less than or equal to about 0.69:1, less than or equal to about 0.68:1, less than or equal to about 0.65:1, less than or equal to about 0.64:1, less than or equal to about 0.61:1, less than or equal to about 0.6:1, less than or equal to about 0.56:1, less than or equal to about 0.55:1, less than or equal to about 0.54:1, less than or equal to about 0.52:1, or less than or equal to about 0.5:1.

In the semiconductor nanoparticle, the mole ratio of the sum of indium and gallium to sulfur [(In+Ga):S] may be greater than or equal to about 0.4:1, greater than or equal to about 0.45:1, greater than or equal to about 0.5:1, greater than or equal to about 0.52:1, greater than or equal to about 0.53:1, greater than or equal to about 0.54:1, greater than or equal to about 0.55:1, greater than or equal to about 0.57:1, greater than or equal to about 0.58:1, greater than or equal to about 0.59:1, greater than or equal to about 0.6:1, greater than or equal to about 0.62:1, greater than or equal to about 0.64:1, greater than or equal to about 0.68:1, greater than or equal to about 0.7:1, greater than or equal to about 0.72:1, greater than or equal to about 0.75:1, greater than or equal to about 0.77:1, greater than or equal to about 0.79:1, or greater than or equal to about 0.81:1; less than or equal to about 0.9:1, less than or equal to about 0.88:1, less than or equal to about 0.86:1, less than or equal to about 0.84:1, less than or equal to about 0.82:1, less than or equal to about 0.78:1, less than or equal to about 0.73:1, less than or equal to about 0.71:1, less than or equal to about 0.69:1, or less than or equal to about 0.67:1; or a combination thereof.

In the semiconductor nanoparticle, the mole ratio of silver to sulfur (Ag:S) may greater than or equal to about 0.33:1, greater than or equal to about 0.35:1, greater than or equal to about 0.38:1, greater than or equal to about 0.39:1, greater than or equal to about 0.4:1 or greater than or equal to about 0.41:1; less than or equal to about 0.5:1, less than or equal to about 0.45:1, less than or equal to about 0.44:1, less than or equal to about 0.43:1, less than or equal to about 0.42:1, less than or equal to about 0.41:1, less than or equal to about 0.4:1, less than or equal to about 0.39:1, less than or equal to about 0.37:1, less than or equal to about 0.36:1, or less than or equal to about 0.33:1; or a combination thereof.

In the semiconductor nanoparticle, the mole ratio of sulfur to indium (S:In) may be greater than or equal to about 9:1, greater than or equal to about 10:1, greater than or equal to about 11:1, greater than or equal to about 12:1, greater than or equal to about 13:1, greater than or equal to about 14:1, greater than or equal to about 15:1, greater than or equal to about 16:1, greater than or equal to about 17:1, greater than or equal to about 18:1, greater than or equal to about 19:1, greater than or equal to about 20:1, greater than or equal to about 21:1, greater than or equal to about 22:1, greater than or equal to about 23:1, greater than or equal to about 24:1, greater than or equal to about 25:1, greater than or equal to about 26:1, greater than or equal to about 27:1, greater than or equal to about 28:1, greater than or equal to about 29:1, or greater than or equal to about 30:1; less than or equal to about 48:1, less than or equal to about 45:1, less than or equal to about 42:1, less than or equal to about 41:1, less than or equal to about 40:1, less than or equal to about 39:1, less than or equal to about 38:1, less than or equal to about 37:1, less than or equal to about 36:1, less than or equal to about 35:1, less than or equal to about 34:1, or less than or equal to about 32:1; or a combination thereof.

In the semiconductor nanoparticle, a mole ratio of silver to a sum of silver, indium, and gallium [Ag:(Ag+In+Ga)] may be greater than or equal to about 0.31:1, greater than or equal to about 0.33:1, greater than or equal to about 0.34:1, greater than or equal to about 0.35:1, greater than or equal to about 0.37:1, greater than or equal to about 0.38:1, greater than or equal to about 0.39:1, greater than or equal to about 0.4:1, greater than or equal to about 0.41:1, greater than or equal to about 0.43:1, or greater than or equal to about 0.44:1; less than or equal to about 0.45:1, less than or equal to about

0.42:1, less than or equal to about 0.40:1, less than or equal to about 0.36:1, less than or equal to about 0.33:1, less than or equal to about 0.32:1, or less than or equal to about 0.28:1; or a combination thereof.

In the semiconductor nanoparticles, a mole ratio of gallium to a sum of gallium, indium, and silver (Ga:(Ga+In+Ag)) may be greater than or equal to about 0.45:1, greater than or equal to about 0.46:1, greater than or equal to about 0.47:1, greater than or equal to about 0.48:1, greater than or equal to about 0.49:1, greater than or equal to about 0.5:1, greater than or equal to about 0.51:1, greater than or equal to about 0.52:1, greater than or equal to about 0.53:1, greater than or equal to about 0.55:1, greater than or equal to about 0.58:1, greater than or equal to about 0.59:1, greater than or equal to about 0.6:1, greater than or equal to about 0.61:1, greater than or equal to about 0.63:1, greater than or equal to about 0.64:1, or greater than or equal to about 0.65:1; less than or equal to about 0.85:1, less than or equal to about 0.8:1, less than or equal to about 0.77:1, less than or equal to about 0.74:1, less than or equal to about 0.73:1, less than or equal to about 0.72:1, less than or equal to about 0.71:1, less than or equal to about 0.69:1, less than or equal to about 0.65:1, less than or equal to about 0.64:1, less than or equal to about 0.62:1, less than or equal to about 0.61:1, less than or equal to about 0.59:1, less than or equal to about 0.56:1, less than or equal to about 0.54:1, less than or equal to about 0.53:1, less than or equal to about 0.49:1, or less than or equal to about 0.485:1; or a combination thereof.

In the semiconductor nanoparticles, a mole ratio of sulfur to a sum of gallium, indium, and silver (S:(Ag+In+Ga)) may be greater than or equal to about 0.8:1, greater than or equal to about 0.92:1, greater than or equal to about 1:1, greater than or equal to about 1.05:1, greater than or equal to about 1.12:1, or greater than or equal to about 1.3:1; less than or equal to about 1.5:1, less than or equal to about 1.45:1, less than or equal to about 1.35:1, less than or equal to about 1.15:1, less than or equal to about 1.13:1, less than or equal to about 1.12:1, less than or equal to about 1.1:1, less than or equal to about 1.09:1, less than or equal to about 1.08:1, or less than or equal to about 1.06:1; or a combination thereof.

In an embodiment, the semiconductor nanoparticle may have a charge balance value defined by the following equation (Equation 1) that may be greater than or equal to about 0.95, greater than or equal to about 0.98 or greater than or equal to about 1, and/or may be less than or equal to about 1.35, less than or equal to about 1.3, less than or equal to about 1.25, less than or equal to about 1.2, or less than or equal to about 1.1:

Equation 1

$$\text{charge balance value} = \{[Ag] + 3([In]+[Ga])+2[Zn]\}/(2[S])$$

wherein, in Equation 1, [Ag], [In], [Ga], [Zn], and [S] are molar amounts of silver, indium, gallium, zinc, and sulfur in the semiconductor nanoparticle, respectively.

The semiconductor nanoparticle may further include bromine. In the semiconductor nanoparticle, an amount of the bromine may be less than or equal to about 3200 mol% (Br:In ~ 32 times) based on indium. In the semiconductor nanoparticles, the amount of bromine may be greater than or equal to about 0.01 mol% (for example, greater than or equal to about 0.0001 mol), greater than or equal to about 0.03 mol%, greater than or equal to about 0.05 mol%, greater than or equal to about 0.08 mol%, greater than or equal to about 0.1 mol%, greater than or equal to about 0.15 mol%, greater than or equal to about 0.25 mol%, greater than or equal to about 0.3 mol%, greater than or equal to about 0.35 mol%, greater than or equal to about 0.4 mol%, greater than or equal to about 0.45 mol%, greater than or equal to about 0.5 mol%, greater than or equal to about 0.6 mol%, greater than or equal to about 0.7 mol%, greater than or equal to about 0.8 mol%, greater than or equal to about 0.9 mol%, greater than or equal to about 1 mol%, greater than or equal to about 1.5 mol%, greater than or equal to about 2 mol%, greater than or equal to about 2.5 mol%, greater than or equal to about 3 mol%, greater than or equal to about 3.5 mol%, greater than or equal to about 4 mol%, greater than or equal to about 4.5 mol%, greater than or equal to about 5 mol%, greater than or equal to about 5.5 mol%, greater than or equal to about 6 mol%, greater than or equal to about 6.5 mol%, greater than or equal to about 7 mol%, greater than or equal to about 7.5 mol%, greater than or equal to about 8 mol%, greater than or equal to about 8.5 mol%, greater than or equal to about 9 mol%, greater than or equal to about 10 mol%, greater than or equal to about 13 mol%, greater than or equal to about 15 mol%, greater than or equal to about 17 mol%, greater than or equal to about 20 mol%, greater than or equal to about 25 mol%, greater than or equal to about 30 mol%, greater than or equal to about 35 mol%, greater than or equal to about 40 mol%, greater than or equal to about 45 mol%, greater than or equal to about 50 mol%, greater than or equal to about 60 mol%, greater than or equal to about 70 mol%, greater than or equal to about 80 mol%, greater than or equal to about 90 mol%, greater than or equal to about 100 mol%, greater than or equal to about 150 mol%, greater than or equal to about 200 mol%, greater than or equal to about 250 mol%, greater than or equal to about 300 mol%, greater than or equal to about 350 mol%, greater than or equal to about 400 mol%, or greater than or equal to about 450 mol% based on indium (e.g., with respect to indium or per one mole of indium). The amount of bromine may be less than or equal to about 3200 mol% (for example, less than or equal to about 32 mol) (Br:In ~ 32 times), less than or equal to about 3000 mol%, less than or equal to about 2500 mol%, less than or equal to about 2000 mol%, less than or equal to about 1500 mol%, less than or equal to about 1000 mol%, less than or equal to about 900 mol%, less than or equal to about 800 mol%, less than or equal to about 700 mol%, less than or equal to about 600 mol%, less than or equal to about 500 mol%, less than or equal to about 380 mol%, less than or equal to about

230 mol%, less than or equal to about 120 mol%, less than or equal to about 110 mol%, less than or equal to about 100 mol%, less than or equal to about 85 mol%, less than or equal to about 75 mol%, less than or equal to about 65 mol%, less than or equal to about 55 mol%, less than or equal to about 44 mol%, less than or equal to about 42 mol%, less than or equal to about 37 mol%, less than or equal to about 23 mol%, less than or equal to about 19 mol%, less than or equal to about 14 mol%, less than or equal to about 7.2 mol%, less than or equal to about 6.8 mol%, less than or equal to about 4.3 mol%, less than or equal to about 3.9 mol%, or less than or equal to about 2.3 mol% based on indium (e.g., with respect to indium or per one mole of indium).

A size or an average size (hereinafter, can be simply referred to as "size") of the first semiconductor nanocrystal or the core may be greater than or equal to about 0.5 nm, greater than or equal to about 1 nm, greater than or equal to about 1.5 nm, greater than or equal to about 1.7 nm, greater than or equal to about 1.9 nm, greater than or equal to about 2 nm, greater than or equal to about 2.1 nm, greater than or equal to about 2.3 nm, greater than or equal to about 2.5 nm, greater than or equal to about 2.7 nm, greater than or equal to about 2.9 nm, greater than or equal to about 3 nm, greater than or equal to about 3.1 nm, greater than or equal to about 3.3 nm, greater than or equal to about 3.5 nm, greater than or equal to about 3.7 nm, or greater than or equal to about 3.9 nm. The size of the first semiconductor nanocrystal or the core may be less than or equal to about 5 nm, less than or equal to about 4.5 nm, less than or equal to about 4 nm, less than or equal to about 3.5 nm, less than or equal to about 3 nm, less than or equal to about 2.5 nm, less than or equal to about 2 nm, or less than or equal to about 1.5 nm.

A thickness of the second semiconductor nanocrystal or a layer containing the same (e.g., a shell thickness) may be greater than or equal to about 0.1 nm, or greater than or equal to about 0.2 nm, or greater than or equal to about 0.3 nm. A thickness of the second semiconductor nanocrystal or a layer containing the same (e.g., a shell thickness) may be less than or equal to about 4 nm, less than or equal to about 3.5 nm, less than or equal to about 3 nm, less than or equal to about 2.5 nm, less than or equal to about 2 nm, less than or equal to about 1.5 nm, less than or equal to about 1 nm, or less than or equal to about 0.8 nm.

If present, the dimension (e.g., a thickness) of the third semiconductor nanocrystal and/or the fourth semiconductor nanocrystal or a layer containing the same (a thickness of an additional shell layer) may be greater than or equal to about 0.1 nm, greater than or equal to about 0.3 nm, greater than or equal to about 0.5 nm, greater than or equal to about 0.7 nm, or greater than or equal to about 1 nm. The dimension (e.g., thickness) of the third semiconductor nanocrystal may be less than or equal to about 2 nm, less than or equal to about 1.5 nm, less than or equal to about 1 nm, or less than or equal to about 0.8 nm. The thickness of the third semiconductor nanocrystal layer may be in the range of about 0.1 nm to about 5 nm, about 0.2 nm to about 4 nm, about 0.3 nm to about 3.5 nm, about 0.4 nm to about 3 nm, about 0.5 nm to about 2.5 nm, about 0.6 nm to about 2 nm, about 0.7 nm to about 1.5 nm, about 0.8 nm to about 1.2 nm, about 0.9 nm to about 1 nm, or a combination thereof.

In an embodiment, a size (or an average size, hereinafter, simply referred to as "size") of the semiconductor nanoparticle may be greater than or equal to about 1 nm, greater than or equal to about 1.5 nm, greater than or equal to about 2 nm, greater than or equal to about 2.5 nm, greater than or equal to about 3 nm, greater than or equal to about 3.5 nm, greater than or equal to about 4 nm, greater than or equal to about 4.5 nm, greater than or equal to about 5 nm, greater than or equal to about 5.5 nm, greater than or equal to about 6 nm, greater than or equal to about 6.5 nm, greater than or equal to about 7 nm, greater than or equal to about 7.5 nm, greater than or equal to about 8 nm, greater than or equal to about 8.5 nm, greater than or equal to about 9 nm, greater than or equal to about 9.5 nm, greater than or equal to about 10 nm, or greater than or equal to about 10.5 nm. The size of the semiconductor nanoparticle may be less than or equal to about 50 nm, less than or equal to about 48 nm, less than or equal to about 46 nm, less than or equal to about 44 nm, less than or equal to about 42 nm, less than or equal to about 40 nm, less than or equal to about 35 nm, less than or equal to about 30 nm, less than or equal to about 25 nm, less than or equal to about 20 nm, less than or equal to about 18 nm, less than or equal to about 16 nm, less than or equal to about 14 nm, less than or equal to about 12 nm, less than or equal to about 11 nm, less than or equal to about 10 nm, less than or equal to about 8 nm, less than or equal to about 6 nm, or less than or equal to about 4 nm.

In this specification, the size of the semiconductor nanoparticle may be a particle diameter (e.g., an equivalent diameter). The size of the semiconductor nanoparticle can be obtained from images confirmed by electron microscopy (e.g., transmission electron microscopy). The size of the semiconductor nanoparticle may be an equivalent diameter obtained by a calculation involving converting the twodimensional area of the particles obtained from electron microscope images into a circle. This particle size can be reproducibly and easily obtained from microscope images using various image processing programs (e.g., ImageJ or an in-house program that can be created using coding languages). The particle size may be a value (e.g., a nominal particle size) calculated from the composition of the semiconductor nanoparticles and the emission peak wavelength.

The semiconductor nanoparticle may have a size or an average size of greater than or equal to about 5 nm, greater than or equal to about 5.1 nm, or greater than or equal to about 5.2 nm, and less than or equal to about 10 nm, less than or equal to about 7 nm, less than or equal to about 6.5 nm, less than or equal to about 6 nm, or less than or equal to about 5.4 nm. The semiconductor nanoparticle (population) may exhibit a size distribution, represented by a standard

deviation, of less than or equal to about 20%, less than or equal to about 19%, less than or equal to about 18%, less than or equal to about 17%, less than or equal to about 16%, less than or equal to about 15%, less than or equal to about 14%, less than or equal to about 13%, less than or equal to about 12%, less than or equal to about 11%, or less than or equal to about 10% of the average size. The standard deviation may be greater than or equal to about 5%, greater than or equal to about 10%, or greater than or equal to about 12%.

The semiconductor particles can be configured to emit green light. The emission peak wavelength of the green light can be in the range of greater than or equal to about 500 nm, or greater than or equal to about 505 nm and less than or equal to about 580 nm, or less than or equal to about 550 nm.

The semiconductor nanoparticle of an embodiment may be configured to emit green light. A peak emission wavelength of the light or a peak emission wavelength of the semiconductor nanoparticle in a luminescence spectrum may be greater than or equal to about 500 nm, greater than or equal to about 505 nm, greater than or equal to about 510 nm, greater than or equal to about 515 nm, greater than or equal to about 520 nm, greater than or equal to about 525 nm, greater than or equal to about 530 nm, greater than or equal to about 535 nm, greater than or equal to about 540 nm, greater than or equal to about 545 nm, greater than or equal to about 550 nm, greater than or equal to about 555 nm, greater than or equal to about 560 nm, greater than or equal to about 565 nm, greater than or equal to about 570 nm, greater than or equal to about 575 nm, greater than or equal to about 580 nm, greater than or equal to about 585 nm, greater than or equal to about 590 nm, or greater than or equal to about 600 nm. The peak emission wavelength of the light or the peak emission wavelength of the semiconductor nanoparticle in the luminescence spectrum may be less than or equal to about 580 nm or less than or equal to about 550 nm.

The semiconductor nanoparticle of an embodiment may be configured to emit red light. A peak emission wavelength of the light or a peak emission wavelength of the semiconductor nanoparticle in a luminescence spectrum may be greater than or equal to about 600 nm, greater than or equal to about 605 nm, greater than or equal to about 610 nm, and less than or equal to about 650 nm, or less than or equal to about 640 nm, or less than or equal to about 630 nm.

The semiconductor nanoparticle may exhibit a quantum yield of greater than or equal to about 50%. The quantum yield may be an absolute quantum yield. The quantum yield may be greater than or equal to about 40%, greater than or equal to about 45%, greater than or equal to about 50%, greater than or equal to about 55%, greater than or equal to about 60%, greater than or equal to about 65%, greater than or equal to about 70%, greater than or equal to about 75%, greater than or equal to about 80%, greater than or equal to about 85%, greater than or equal to about 90%, or greater than or equal to about 95%. The quantum yield may be less than or equal to about 100%, less than or equal to about 99.5%, less than or equal to about 99%, less than or equal to about 98%, or less than or equal to about 97%.

The semiconductor nanoparticle may be configured to emit light (e.g., green light or red light). A full width at half maximum (FWHM) of the peak of the first light or a FWHM of the peak of the semiconductor nanoparticle in the luminescence spectrum may be greater than or equal to about 5 nm, greater than or equal to about 10 nm, greater than or equal to about 15 nm, greater than or equal to about 20 nm, greater than or equal to about 25 nm, or greater than or equal to about 30 nm. The full width at half maximum may be less than or equal to about 70 nm, less than or equal to about 65 nm, less than or equal to about 60 nm, less than or equal to about 55 nm, less than or equal to about 50 nm, less than or equal to about 45 nm, less than or equal to about 40 nm, less than or equal to about 38 nm, less than or equal to about 36 nm, less than or equal to about 35 nm, less than or equal to about 34 nm, less than or equal to about 33 nm, less than or equal to about 32 nm, less than or equal to about 31 nm, less than or equal to about 30 nm, less than or equal to about 29 nm, less than or equal to about 28 nm, less than or equal to about 27 nm, less than or equal to about 26 nm, or less than or equal to about 25 nm.

The semiconductor nanoparticle may exhibit a ratio of absorption at 350 nm to absorption at 370 nm of less than or equal to about 1.2, or less than or equal to about 1.1, or less than or equal to about 1 in an UV-Vis absorption spectroscopy. The semiconductor nanoparticle may exhibit a ratio of absorption at 350 nm to absorption at 370 nm of greater than or equal to about 0.1 or greater than or equal to about 0.3 in the UV-Vis absorption spectroscopy.

The shape of the semiconductor nanoparticle is not particularly limited and may include, for example, spherical, polyhedral, pyramidal, multipod, cubic, nanotube, nanowire, nanofiber, nanosheet, or combinations thereof, but is not limited thereto.

The semiconductor nanoparticle may include an organic ligand and/or an organic solvent on a surface thereof. The organic ligand and/or organic solvent may be bound to the surface of the semiconductor nanoparticles in one embodiment. The organic ligands and organic solvents are as described herein.

An embodiment relates to a preparation method of the semiconductor nanoparticle. In an embodiment, the method for preparing the semiconductor nanoparticle may include contacting a sulfur precursor; a first semiconductor nanocrystal containing silver, a group 13 element, and a chalcogen element; and a gallium precursor in a medium containing an organic solvent. The method of an embodiment may include adding an organic ligand, a sulfur precursor, a first semiconductor nanocrystal including silver, a group 13 element, and a chalcogen element, and a gallium precursor to a medium containing an organic solvent. The method may include adding the first semiconductor nanocrystal and the gallium precursor to the medium containing the organic solvent, the sulfur precursor, and the organic ligand.

The method of an embodiment may include heating the medium to a predetermined temperature (or a reaction temperature). In an embodiment, the gallium precursor may include a gallium halide, and the gallium halide may include a gallium bromide. The method may further include adding a silver compound to the medium. The heating may cause a reaction to yield a semiconductor nanoparticle or a crude solution containing the same. The predetermined temperature may be greater than or equal to about 120°C and less than or equal to about 380°C. The predetermined temperature may be the reaction temperature. The predetermined temperature or the reaction temperature may be greater than or equal to about 220°C, or greater than or equal to about 260°C and less than or equal to about 340°C, less than or equal to about 320°C, or less than or equal to about 280°C.

The gallium precursor or the gallium halide may include a gallium bromide; The gallium precursor or the gallium halide may further include gallium chloride. In the gallium precursor, the amount of the gallium chloride relative to 1 mol of gallium bromide may be greater than or equal to about 0 mol, greater than or equal to about 0.005 mol, greater than or equal to about 0.01 mol, greater than or equal to about 0.05 mol, greater than or equal to about 0.1 mol, greater than or equal to about 0.15 mol, greater than or equal to about 0.2 mol, greater than or equal to about 0.25 mol, greater than or equal to about 0.3 mol, or greater than or equal to about 0.35 mol. In the gallium precursor, the amount of the gallium chloride relative to 1 mol of gallium bromide may be less than or equal to about 1 mol, less than or equal to about 0.8 mol, less than or equal to about 0.7 mol, less than or equal to about 0.5 mol, less than or equal to about 0.4 mol, less than or equal to about 0.35 mol, less than or equal to about 0.34 mol, less than or equal to about 0.3 mol, or less than or equal to about 0.2 mol.

An AIGS-containing semiconductor nanoparticle may exhibit desirable optical properties (e.g., relatively high absorbance) for applications in the color conversion layer of the semiconductor nanoparticle. Such an AIGS-containing semiconductor nanoparticle has room for improvement in terms of stability, such as process stability. Surprisingly, the inventors have found that the method of an embodiment can provide the semiconductor nanoparticle described herein, exhibiting the atomic molar ratio(s) described herein (e.g., the molar ratio of gallium to indium and the molar ratio of silver to indium), which can contribute for the semiconductor nanoparticle to exhibit a desired level of stability and a property (e.g., an increased photoconversion efficiency and/or a controlled or suppressed trap emission) within a composite or a pattern thereof.

Without wishing to be bound by any particular theory, it is believed that in the method of an embodiment, the use of the gallium bromide as the gallium precursor (and optionally, the addition of a silver compound as described herein) can contribute to controlling the composition of the final semiconductor nanoparticle as described herein (for example, using GaBrs can suppress the trap ratio by removing excess Ag from the surface). Accordingly, the resulting final nanoparticle can exhibit enhanced stability and a suppressed trap ratio in comparison to semiconductor nanoparticles prepared by conventional techniques. Without wishing to be bound by any particular theory, it is believed that a gallium precursor containing bromide can provide a better balance between the metal components (e.g., silver, gallium, and indium) on a surface of the forming semiconductor nanoparticle compared to other halides (e.g., precursors containing iodide or chloride).

The method of an embodiment may include adding a sulfur precursor to a medium (e.g., containing an organic solvent and optionally an organic ligand). The medium may be vacuum-treated as described herein. In an embodiment, the method may include adding a gallium bromide to the medium. In an embodiment, the method may include adding a first semiconductor nanocrystal containing silver, a group 13 element, and a chalcogen element to the medium. In the method of an embodiment, the gallium bromide may be added prior to or after adding the first semiconductor nanocrystal. The method may further include heating the medium (e.g., containing a sulfur precursor, the gallium bromide, the first semiconductor nanocrystal, or a combination thereof) to a predetermined temperature (e.g., a reaction temperature or below the reaction temperature). The method may further include adding a silver compound to the medium. The method may further include facilitating precipitation of the semiconductor nanoparticle (e.g., coordinated with the organic ligand) as formed in the medium by adding a poor solvent to a resulting reaction solution (obtained by cooling it after the heating).

In an embodiment, the formation of the semiconductor nanoparticle may include performing a reaction between a gallium precursor and a sulfur precursor in the presence of the first semiconductor nanocrystal containing silver, a group 13 element and a chalcogen element. The medium may be a reaction medium for the reaction. The method may further include adding a silver compound to the medium. Details about the semiconductor nanoparticle and the first semiconductor nanocrystal are the same as described herein.

The method may include pre-treating the medium.

In an embodiment, the method may include adding the first semiconductor nanocrystal and the gallium precursor, the sulfur precursor, or both to the (reaction) medium containing an organic solvent (and optionally the sulfur precursor). The medium (e.g., containing the sulfur precursor) may be pre-treated at a predetermined temperature under vacuum prior to the addition of the first semiconductor nanocrystal and/or the gallium precursor. The pre-treatment temperature may be lower than the reaction temperature. The pre-treatment temperature may be, for example, greater than or equal to about 80°C, greater than or equal to about 100°C, or greater than or equal to about 120°C, and less than or equal to about 200°C, or less than or equal to about 180°C.

In an embodiment, a manner of adding the first semiconductor nanocrystal, the gallium precursor, and the sulfur

precursor (e.g., the order or form of addition) is not particularly limited. The first semiconductor nanocrystal may be dispersed in an appropriate organic solvent and added to the reaction medium, but is not limited thereto. The gallium precursor may be dispersed in an appropriate organic solvent (e.g., octadecene, aliphatic or aromatic phosphine compounds such as TOP, or aliphatic or aromatic phosphine oxide compounds such as TOPO) and added to the reaction medium, but is not limited thereto.

A manner of adding the silver compound to the (reaction) medium (e.g., the order or form of addition) is also not particularly limited. The silver compound may be added in a dissolved state in an appropriate organic solvent (e.g., the organic solvent described herein, such as an amine solvent like oleylamine, a phosphine solvent like trioctylphosphine). The timing of adding the silver compound is also not particularly limited and can be appropriately selected. The silver compound may be added to the (reaction) medium before or after the addition of the first semiconductor nanocrystal, the gallium precursor, the sulfur precursor, or a combination thereof. In an embodiment, the silver compound may be added to the (reaction) medium after the pre-treatment.

The details of the first semiconductor nanocrystal are the same as described herein. The first semiconductor nanocrystal may include silver (Ag), indium, gallium, and sulfur. The method for preparing the first semiconductor nanocrystal is not particularly limited and can be appropriately selected. In an embodiment, the first semiconductor nanocrystal can be obtained by contacting (or reacting) the necessary precursors according to the composition, such as a silver precursor, an indium precursor, a gallium precursor, and a sulfur precursor, in a solution containing an organic ligand and an organic solvent at a predetermined core formation reaction temperature (e.g., from about 180°C to about 300°C or from about 200°C to about 280°C), and then separating them.

In an embodiment, the prepared first semiconductor nanocrystal can be separated and optionally washed. The separation and washing can be carried out by the manners described herein.

In the method of an embodiment, the predetermined temperature (e.g., a first temperature or a second temperature) can be greater than or equal to about 120°C, greater than or equal to about 180°C, greater than or equal to about 190°C, greater than or equal to about 200°C, greater than or equal to about 205°C, greater than or equal to about 210°C, greater than or equal to about 240°C, greater than or equal to about 245°C, greater than or equal to about 250°C, greater than or equal to about 255°C, greater than or equal to about 260°C, greater than or equal to about 265°C, greater than or equal to about 270°C, greater than or equal to about 275°C, greater than or equal to about 280°C, greater than or equal to about 285°C, greater than or equal to about 290°C, greater than or equal to about 295°C, greater than or equal to about 300°C, greater than or equal to about 305°C, greater than or equal to about 310°C, greater than or equal to about 315°C, greater than or equal to about 320°C, greater than or equal to about 330°C, greater than or equal to about 335°C, greater than or equal to about 340°C, or greater than or equal to about 345°C. The predetermined temperature can be less than or equal to about 380°C, less than or equal to about 375°C, less than or equal to about 370°C, less than or equal to about 365°C, less than or equal to about 360°C, less than or equal to about 355°C, less than or equal to about 350°C, less than or equal to about 340°C, less than or equal to about 330°C, less than or equal to about 320°C, less than or equal to about 310°C, less than or equal to about 300°C, less than or equal to about 290°C, less than or equal to about 280°C, less than or equal to about 270°C, less than or equal to about 260°C, or less than or equal to about 250°C.

In an embodiment, the method may include heating the medium (optionally containing the sulfur precursor) to a first temperature under vacuum or an inert atmosphere, and adding the first semiconductor nanocrystal, the gallium precursor, the sulfur precursor, or a combination thereof to the heated medium at the first temperature. The method of an embodiment may include heating a reaction mixture containing the first semiconductor nanocrystal, the gallium precursor, the sulfur precursor, and optionally the silver compound to a second temperature (e.g., a reaction temperature).

The first temperature may be greater than or equal to about 120°C (e.g., greater than or equal to about 180°C, greater than or equal to about 190°C, or greater than or equal to about 200°C) and less than or equal to about 280°C (e.g., less than or equal to about 250°C). The second temperature may be greater than or equal to about 190°C, greater than or equal to about 240°C, or greater than or equal to about 260°C and less than or equal to about 380°C, less than or equal to about 340°C, less than or equal to about 320°C or less than or equal to about 280°C.

The second temperature may be higher than the first temperature. A difference between the first temperature and the second temperature may be greater than or equal to about 5°C, greater than or equal to about 10°C, greater than or equal to about 15°C, greater than or equal to about 20°C, greater than or equal to about 30°C, greater than or equal to about 40°C, greater than or equal to about 50°C, greater than or equal to about 60°C, greater than or equal to about 70°C, greater than or equal to about 80°C, greater than or equal to about 90°C, or greater than or equal to about 100°C. A difference between the first temperature and the second temperature may be less than or equal to about 200°C, less than or equal to about 190°C, less than or equal to about 180°C, less than or equal to about 170°C, less than or equal to about 160°C, less than or equal to about 150°C, less than or equal to about 140°C, less than or equal to about 130°C, less than or equal to about 120°C, less than or equal to about 110°C, less than or equal to about 100°C, less than or equal to about 90°C, less than or equal to about 80°C, less than or equal to about 70°C, less than or equal to about 60°C, less than or equal to about 50°C, less than or equal to about 40°C, less than or equal to about 30°C, or less than or equal to about 20°C.

The first temperature may be greater than or equal to about 120°C, greater than or equal to about 190°C, greater

than or equal to about 200°C, greater than or equal to about 210°C, greater than or equal to about 220°C, greater than or equal to about 230°C, greater than or equal to about 240°C, or greater than or equal to about 250°C. The first temperature may be less than or equal to about 280°C, less than or equal to about 275°C, less than or equal to about 270°C, less than or equal to about 265°C, less than or equal to about 260°C, less than or equal to about 255°C, less than or equal to about 250°C, less than or equal to about 240°C, less than or equal to about 230°C, less than or equal to about 220°C, less than or equal to about 210°C, less than or equal to about 200°C, less than or equal to about 190°C, less than or equal to about 180°C, less than or equal to about 170°C, less than or equal to about 160°C, or less than or equal to about 150°C.

In an embodiment, the second temperature (e.g., a reaction temperature) may be greater than or equal to about 210°C, greater than or equal to about 220°C, greater than or equal to about 230°C, greater than or equal to about 240°C, greater than or equal to about 245°C, greater than or equal to about 250°C, greater than or equal to about 255°C, greater than or equal to about 260°C, greater than or equal to about 265°C, greater than or equal to about 270°C, greater than or equal to about 275°C, greater than or equal to about 280°C, greater than or equal to about 285°C, greater than or equal to about 290°C, greater than or equal to about 295°C, greater than or equal to about 300°C, greater than or equal to about 305°C, greater than or equal to about 310°C, greater than or equal to about 315°C, greater than or equal to about 320°C, greater than or equal to about 330°C, greater than or equal to about 335°C, greater than or equal to about 340°C, or greater than or equal to about 345°C. The second temperature may be less than or equal to about 380°C, less than or equal to about 375°C, less than or equal to about 370°C, less than or equal to about 365°C, less than or equal to about 360°C, less than or equal to about 355°C, less than or equal to about 350°C, less than or equal to about 340°C, less than or equal to about 330°C, less than or equal to about 320°C, less than or equal to about 310°C, less than or equal to about 300°C, less than or equal to about 290°C, less than or equal to about 280°C, less than or equal to about 270°C, less than or equal to about 260°C, or less than or equal to about 250°C.

The reaction time can be appropriately controlled considering the precursors and reaction temperature. The reaction time may be greater than or equal to about 30 minutes, greater than or equal to about 35 minutes, greater than or equal to about 40 minutes, greater than or equal to about 45 minutes, greater than or equal to about 50 minutes, greater than or equal to about 55 minutes, greater than or equal to about 60 minutes, greater than or equal to about 65 minutes, greater than or equal to about 70 minutes, greater than or equal to about 75 minutes, or greater than or equal to about 80 minutes. The reaction time may be less than or equal to about 10 hours, less than or equal to about 7 hours, less than or equal to about 5 hours, less than or equal to about 4 hours, less than or equal to about 3 hours, less than or equal to about 2 hours, or less than or equal to about 90 minutes.

In an embodiment, adding a silver compound at the reaction between the gallium precursor and the sulfur precursor in the presence of the first semiconductor nanocrystal may prevent undesirable changes in the first semiconductor nanocrystal (e.g., particle agglomeration or a compositional change). According to the method of an embodiment, a greater number of semiconductor nanoparticles can be formed in a crude solution (e.g., a resulting reaction solution obtained after the reaction).

The silver compound may be added to the reaction medium in an amount of greater than or equal to about 0.01 mol%, greater than or equal to about 0.03 mol%, greater than or equal to about 0.04 mol%, greater than or equal to about 0.05 mol%, greater than or equal to about 0.07 mol%, greater than or equal to about 0.09 mol%, greater than or equal to about 0.1 mol%, greater than or equal to about 0.3 mol%, greater than or equal to about 0.5 mol%, greater than or equal to about 1 mol%, or greater than or equal to about 2 mol%, relative to the gallium precursor (for example, based on the gallium precursor). The amount of the silver compound may be greater than or equal to about 0.01 mol%, greater than or equal to about 0.02 mol%, greater than or equal to about 0.03 mol%, greater than or equal to about 0.04 mol%, greater than or equal to about 0.045 mol%, greater than or equal to about 0.05 mol%, greater than or equal to about 0.052 mol%, greater than or equal to about 0.06 mol%, greater than or equal to about 0.07 mol%, greater than or equal to about 0.09 mol%, greater than or equal to about 0.1 mol%, greater than or equal to about 0.3 mol%, greater than or equal to about 0.5 mol%, greater than or equal to about 0.6 mol%, greater than or equal to about 0.7 mol%, greater than or equal to about 0.8 mol%, greater than or equal to about 0.9 mol%, greater than or equal to about 1 mol%, greater than or equal to about 2 mol%, greater than or equal to about 3 mol%, greater than or equal to about 4 mol%, greater than or equal to about 5 mol%, greater than or equal to about 6 mol%, greater than or equal to about 7 mol%, greater than or equal to about 8 mol%, greater than or equal to about 9 mol%, greater than or equal to about 10 mol%, greater than or equal to about 11 mol%, greater than or equal to about 12 mol%, greater than or equal to about 13 mol%, greater than or equal to about 14 mol%, or greater than or equal to about 15 mol% relative to the gallium precursor. The amount of the silver compound may be less than or equal to about 50 mol%, less than or equal to about 30 mol%, less than or equal to about 25 mol%, less than or equal to about 20 mol%, less than or equal to about 18 mol%, less than or equal to about 17 mol%, less than or equal to about 16 mol%, less than or equal to about 15 mol%, less than or equal to about 14 mol%, less than or equal to about 13 mol%, less than or equal to about 12 mol%, less than or equal to about 11 mol%, less than or equal to about 10 mol%, less than or equal to about 9 mol%, less than or equal to about 8 mol%, less than or equal to about 7 mol%, less than or equal to about 6 mol%, less than or equal to about 5 mol%, less than or equal to about 4 mol%, or less than or equal to about 3 mol% relative to the gallium precursor. The amount of the silver compound may be greater than or equal to about 1 mol% and less than or equal to about 12 mol%

relative to the gallium precursor.

The silver compound may include a silver powder, an alkylated silver compound, a silver alkoxide, a silver carboxylate, a silver acetylacetonate, a silver nitrate, a silver sulfate, a silver halide, a silver cyanide, a silver hydroxide, a silver oxide, a silver peroxide, a silver carbonate, or a combination thereof. The silver compound may include a silver nitrate, a silver acetate, a silver acetylacetonate, a silver chloride, a silver bromide, a silver fluoride, or a combination thereof.

In an embodiment, the method may further include preparing an additional reaction medium containing an organic solvent and an organic ligand; heating the additional reaction medium; and in the additional reaction medium, contacting (reacting) a zinc precursor, a gallium precursor, and a sulfur precursor, for example, at a reaction temperature, in the presence of the first semiconductor nanocrystal containing indium, gallium, silver, and sulfur or a particle including the same (e.g., the formed semiconductor nanoparticle) to further form a third semiconductor nanocrystal on the formed semiconductor nanoparticle. The third semiconductor nanocrystal may include a zinc gallium sulfide (ZnGaS). Details about the third semiconductor nanocrystal are the same as described herein.

The method may further include preparing an additional reaction medium containing an organic ligand in an organic solvent; heating the additional reaction medium; and in the presence of the formed semiconductor nanoparticle, contacting (e.g., reacting) a zinc precursor and a chalcogen precursor (e.g., a sulfur precursor), for example, at a reaction temperature, to provide a fourth semiconductor nanocrystal or an outer layer containing a zinc chalcogenide on a surface of the semiconductor nanoparticle. Details about the fourth semiconductor nanocrystal are the same as described herein.

In an embodiment, the reaction temperature for forming the third semiconductor nanocrystal or the fourth semiconductor nanocrystal may be greater than or equal to about 120°C, greater than or equal to about 130°C, greater than or equal to about 150°C, greater than or equal to about 180°C, greater than or equal to about 200°C, greater than or equal to about 205°C, greater than or equal to about 208°C, and less than or equal to about 240°C, less than or equal to about 230°C, less than or equal to about 225°C, or less than or equal to about 215°C. The reaction time for forming the third semiconductor nanocrystal or the fourth semiconductor nanocrystal may be greater than or equal to about 10 minutes, greater than or equal to about 30 minutes, greater than or equal to about 40 minutes, greater than or equal to about 1 hour, greater than or equal to about 80 minutes, or greater than or equal to about 90 minutes, and less than or equal to about 5 hours, less than or equal to about 4 hours, less than or equal to about 3 hours, less than or equal to about 2 hours, less than or equal to about 90 minutes, or less than or equal to about 70 minutes.

In the method, the manner of adding the precursor to the (e.g., heated) reaction medium may include a shot addition (e.g., a syringe addition), a dropwise addition, or a combination thereof.

A type of a silver precursor is not particularly limited, and may be selected appropriately. The silver precursor may include a silver powder, an alkylated silver compound, a silver alkoxide, a silver carboxylate, a silver acetylacetonate, a silver nitrate, a silver sulfate, a silver halide, a silver cyanide, a silver hydroxide, a silver oxide, a silver peroxide, a silver carbonate, or a combination thereof. The silver precursor may include a silver nitrate, a silver acetate, a silver acetylacetonate, or a combination thereof.

A type of an indium precursor is not particularly limited and may be selected appropriately. The indium precursor may include an indium powder, an alkylated indium compound, an indium alkoxide, an indium carboxylate, an indium nitrate, an indium perchlorate, an indium sulfate, an indium acetylacetonate, an indium halide, an indium cyanide, an indium hydroxide, an indium oxide, an indium peroxide, an indium carbonate, or a combination thereof. The indium precursor may include an indium carboxylate (such as indium oleate, indium myristate, and an indium acetate), an indium hydroxide, indium chloride, indium bromide, indium iodide, or a combination thereof.

A type of sulfur precursor is not particularly limited and may be appropriately selected. The sulfur precursor may be an organic solvent dispersion or a reaction product of sulfur and an organic solvent (for example, a octadecene sulfide (S-ODE), a trioctylphosphine-sulfide (S-TOP), a tributylphosphine-sulfide (S-TBP), a triphenylphosphine-sulfide (S-TPP), a trioctylamine-sulfide (S-TOA)), a trimethylsilylalkyl sulfide, a trimethylsilyl sulfide, a mercapto propyl silane, an ammonium sulfide, a sodium sulfide, a C1- C30 thiol compound (e.g., $\alpha$-toluene thiol, octane thiol, dodecanethiol, octadecene thiol, or the like), an isothiocyanate compound (e.g., cyclohexylisothiocyanate, or the like), alkylenetrithiocarbonate (e.g., ethylene trithiocarbonate or the like), allyl mercaptan, a thiourea compound (e.g., dialkylthiourea having a C1 to C40 alkyl group such as dimethylthiourea, diethyl thiourea, ethyl methyl thiourea, dipropyl thiourea, or the like), a thioacetamide compound, or a combination thereof.

The selenium precursor, if present, may include selenium-trioctylphosphine (Se-TOP), selenium-tributylphosphine (Se-TBP), selenium-triphenylphosphine (Se-TPP), or a combination thereof.

A type of zinc precursor is not particularly limited and may be appropriately selected. In an embodiment, the zinc precursor may include a Zn metal powder, an alkylated Zn compound, a Zn alkoxide, a Zn carboxylate, a Zn nitrate, a Zn perchlorate, a Zn sulfate, a Zn acetylacetonate, a Zn halide, a Zn cyanide, a Zn hydroxide, a Zn oxide, a Zn peroxide, or a combination thereof. The zinc precursor may be dimethyl zinc, diethyl zinc, zinc acetate, zinc acetylacetonate, zinc iodide, zinc bromide, zinc chloride, zinc fluoride, zinc carbonate, zinc cyanide, zinc nitrate, zinc oxide, zinc peroxide, zinc perchlorate, zinc sulfate, or a combination thereof. In an embodiment, when the semiconductor nanocrystal layer

containing zinc and sulfur is formed, the zinc precursor may include Zn halide, but is not limited thereto.

A type of a gallium precursor for example used for the preparation of the first semiconductor nanoparticle or the additional semiconductor nanocrystal is not particularly limited and may be appropriately selected. The gallium precursor may include a gallium powder, an alkylated gallium compound, a gallium alkoxide, a gallium carboxylate, a gallium nitrate, a gallium perchlorate, a gallium sulfate, a gallium acetylacetonate, a gallium halide, a gallium cyanide, a gallium hydroxide, a gallium oxide, a gallium peroxide, a gallium carbonate, or a combination thereof. The gallium precursor may include gallium chloride, gallium iodide, gallium bromide, a gallium acetate, a gallium acetylacetonate, gallium oleate, gallium palmitate, gallium stearate, gallium myristate, a gallium hydroxide, or a combination thereof.

The organic ligand may include RCOOH, $RNH_2$, $R_2NH$, $R_3N$, RSH, $RH_2PO$, $R_2HPO$, RsPO, $RH_2P$, $R_2HP$, $R_3P$, ROH, RCOOR', $RPO(OH)_2$, RHPOOH, $R_2POOH$ (wherein, R and R' are each independently substituted or unsubstituted C1 to C40 (or C3 to C24) aliphatic hydrocarbon group (e.g., an alkyl group, an alkenyl group, or an alkynyl group), or a substituted or unsubstituted C6 to C40 (or C6 to C24) aromatic hydrocarbon group (e.g., a C6 to C20 aryl group)), or a combination thereof. The organic ligand may be bound to the surface of the semiconductor nanoparticle. Examples of the organic ligand may include methane thiol, ethane thiol, propane thiol, butane thiol, pentane thiol, hexane thiol, heptane thiol, octane thiol, 1-nonanethiol, decanethiol, dodecane thiol, hexadecane thiol, octadecane thiol, benzyl thiol; methyl amine, ethyl amine, propyl amine, butyl amine, pentyl amine, hexyl amine, octyl amine, dodecyl amine, hexadecyl amine, octadecyl amine, dimethyl amine, diethyl amine, dipropyl amine; methanoic acid, ethanoic acid, propanoic acid, butanoic acid, pentanoic acid, hexanoic acid, heptanoic acid, octanoic acid, dodecanoic acid, hexadecanoic acid, octadecanoic acid, oleic acid, benzoic acid; substituted or unsubstituted methyl phosphine (e.g., trimethyl phosphine, methyldiphenyl phosphine, or the like), substituted or unsubstituted ethyl phosphine (e.g., triethyl phosphine, ethyldiphenyl phosphine, or the like), substituted or unsubstituted propyl phosphine, substituted or unsubstituted butyl phosphine, substituted or unsubstituted pentyl phosphine, substituted or unsubstituted octylphosphine (e.g., trioctylphosphine (TOP) or the like); a phosphine oxide such as substituted or unsubstituted methyl phosphine oxide (e.g., trimethyl phosphine oxide, methyldiphenyl phosphine oxide, or the like), substituted or unsubstituted ethyl phosphine oxide (e.g., triethyl phosphine oxide, ethyldiphenyl phosphine oxide, or the like), substituted or unsubstituted propyl phosphine oxide, substituted or unsubstituted butyl phosphine oxide, substituted or unsubstituted octylphosphine oxide (e.g., trioctylphosphine oxide (TOPO), or the like); diphenyl phosphine, a triphenyl phosphine compound, or an oxide compound thereof; phosphonic acid; a C5 to C20 alkyl phosphonic acid; a C5 to C20 alkylphosphinic acid such as hexylphosphinic acid, octylphosphinic acid, dodecanephosphinic acid, tetradecanephosphinic acid, hexadecanephosphinic acid, octadecanephosphinic acid, or the like, but embodiments are not limited thereto. The organic ligand may be used alone or as a mixture of two or more.

The first organic solvent or the second organic solvent, or the organic solvent may include an amine solvent (e.g., a C1-50 aliphatic amine), a nitrogen-containing heterocyclic compound such as pyridine; a C6 to C40 aliphatic hydrocarbon (e.g., alkane, alkene, alkyne, or the like) such as hexadecane, octadecane, octadecene, squalene, or the like; a C6 to C30 aromatic hydrocarbon such as phenyldodecane, phenyltetradecane, phenyl hexadecane, or the like; a phosphine substituted with a C6 to C22 alkyl group such as trioctylphosphine or the like; a phosphine oxide substituted with a C6 to C22 alkyl group such as trioctylphosphine oxide, or the like; a C12 to C22 aromatic ether such as a phenyl ether, a benzyl ether, or the like; or a combination thereof. The amine solvent may be a compound having one or more (e.g., two or three) C1-50, C2-45, C3-40, C4-35, C5-30, C6-25, C7-20, C8-15, or C6-22 aliphatic hydrocarbon groups (e.g., alkyl group, alkenyl group, or alkynyl group). In an embodiment, the amine solvent may be a C6-22 primary amine, such as hexadecyl amine, oleylamine, or the like; a C6-22 secondary amine, such as dioctyl amine or the like; a C6-22 tertiary amine, such as trioctylamine or the like; or a combination thereof.

Amounts of the organic ligand and the precursors in the reaction medium may be selected appropriately in consideration of the type of solvent, the type of the organic ligand and each precursor, and the size and composition of desired nanoparticles. Mole ratios between the precursors may be changed taking into consideration the desired mole ratios in the final nanoparticle, the reactivities among the precursors, or the like. In an embodiment, a manner of adding each of the precursors is not particularly limited. In an embodiment, a total or complete amount of a precursor may be added at one time. In an embodiment, a total amount of a precursor may be divided and added into greater than or equal to about 2 aliquots and less than or equal to about 10 aliquots. The precursors may be added simultaneously or sequentially in a predetermined order. The reaction may be carried out in an inert gas atmosphere, in air, or in a vacuum state, but is not limited thereto.

When a nonsolvent is added to the final reaction solution after completion of the reaction, (e.g., the organic ligand is coordinated) nanoparticles may be separated (e.g., precipitated). The nonsolvent may be a polar solvent that is miscible with the solvent used in the reaction but cannot disperse the nanocrystals. The nonsolvent may be selected depending on the solvent used in the reaction and may be for example, acetone, ethanol, butanol, isopropanol, ethanediol, water, tetrahydrofuran (THF), dimethylsulfoxide (DMSO), diethylether, formaldehyde, acetaldehyde, a solvent having a similar solubility parameter to the foregoing solvents, or a combination thereof. The separation may be performed by centrifugation, precipitation, chromatography, or distillation. Separated nanocrystals may be washed by adding to a washing solvent as needed. The washing solvent is not particularly limited, and a solvent having a solubility parameter similar to that of the

organic solvent or ligand may be used. The nonsolvent or washing solvent may be alcohols; alkane solvents, such as hexane, heptane, octane, or the like; aromatic solvents, such as toluene, benzene, or the like; halogenated solvent, such as chloroform or the like; or a combination thereof, but is not limited thereto.

The semiconductor nanoparticle thus prepared may be dispersed in a dispersion solvent. The semiconductor nanoparticle thus prepared may form an organic solvent dispersion. The organic solvent dispersion may not include water and/or an organic solvent miscible with water. The dispersion solvent may be appropriately selected. The dispersion solvent may include the aforementioned organic solvent. The dispersion solvent may include a substituted or unsubstituted C1 to C40 aliphatic hydrocarbon, a substituted or unsubstituted C6 to C40 aromatic hydrocarbon, or a combination thereof.

In one or more embodiments, a composite may include a matrix; and the semiconductor nanoparticle described herein, wherein the semiconductor nanoparticle may be dispersed in the matrix. The composite may further contain a metal oxide fine particle. The composite or the semiconductor nanoparticle may be configured to emit first light (e.g., green light or red light). In an embodiment, the composite may be in the form of a patterned film. The composite may further include a semiconductor nanoparticle configured to emit second light different from the first light. In an embodiment, the composite may have a sheet form. The sheet may further include a semiconductor nanoparticle (e.g., an additional semiconductor nanoparticle) configured to emit second light different from the first light.

The semiconductor nanoparticle described herein or the composite including the semiconductor nanoparticle may exhibit an increased level of blue light absorbance (e.g., an improved incident light absorbance) and/or improved optical properties (e.g., an increased luminescent efficiency and a narrower full width at half maximum), and may emit light of a desired wavelength (e.g., first light).

The composite may include the semiconductor nanoparticle or a population thereof (e.g., in a predetermined amount) and exhibit increased light absorbance. An incident light absorbance (e.g., blue light absorbance) of the composite may be greater than or equal to about 70%, greater than or equal to about 73%, greater than or equal to about 75%, greater than or equal to about 77%, greater than or equal to about 80%, greater than or equal to about 83%, greater than or equal to about 85%, greater than or equal to about 87%, greater than or equal to about 90%, greater than or equal to about 93%, greater than or equal to about 94%, greater than or equal to about 95%, greater than or equal to about 96%, greater than or equal to about 97%, greater than or equal to about 98%, or greater than or equal to about 99%. The incident light absorbance (e.g., blue light absorbance) of the composite may be about 70% to about 100%, about 80% to about 98%, about 95% to about 99%, about 96% to about 98%, or a combination thereof.

The incident light absorbance of the composite may be calculated according to Equation 5:

Equation 5

$$\text{incident light absorbance} = [(B-B')/B] \times 100\%$$

wherein, in Equation 5,

B is an amount of incident light provided to the composite, and
B' is an amount of incident light passing through the composite.

A light conversion efficiency (CE) (e.g., an external quantum efficiency or an internal quantum efficiency) of the composite may be greater than or equal to about 50%, greater than or equal to about 55%, greater than or equal to about 60%, greater than or equal to about 65%, greater than or equal to about 70%, or greater than or equal to about 75%:

Equation 2

$$\text{Internal quantum efficiency (\%)} = [A/(B-B')] \times 100$$

Equation 3

$$\text{External quantum efficiency (\%)} = [A/B] \times 100$$

wherein:

A: amount of the first light emitted from the composite
B: amount of the irradiated incident light
B': amount of the incident light passing through the composite.

The present inventors have found that the luminescent particle including semiconductor nanocrystals based on Group 11-13-16 compounds even achieving the desired level of optical properties may exhibit significantly reduced properties when being included in the composite for the application in an actual device. The semiconductor nanoparticle of an embodiment can provide a composite exhibiting an enhanced optical property by having the aforementioned compositional and/or structural features, and can exhibit the high optical property retention even in thin film form.

In an embodiment, the composite may be prepared from an ink composition. The ink composition may include a liquid vehicle; and a plurality of the semiconductor nanoparticles of an embodiment. The semiconductor nanoparticle may be dispersed in the liquid vehicle.

The liquid vehicle may include a liquid monomer, an organic solvent, or a combination thereof. The ink composition may further include metal oxide nanoparticle(s) e.g., dispersed in the liquid vehicle. The ink composition may further include a dispersant (for dispersing the nanoparticles and/or the metal oxide nanoparticles). The dispersant may include a carboxylic acid group-containing organic compound (a monomer or a polymer). The liquid vehicle may not include an (e.g., volatile) organic solvent. The ink composition may be a solvent-free system.

The liquid monomer may include a (photo)polymerizable monomer including a carbon-carbon double bond. The composition may optionally further include a (thermal or photo) initiator. The polymerization of the composition may be initiated by light or heat.

Details of the nanoparticle(s) in the composition (or composite) are as described herein. An amount of the semiconductor nanoparticle in the composition (or composite) may be appropriately adjusted in consideration of a desired end use (e.g., a color filter, or the like). In an embodiment, an amount of the semiconductor nanoparticle in the composition (or composite) may be greater than or equal to about 1 weight percent (wt%), for example, greater than or equal to about 2 wt%, greater than or equal to about 3 wt%, greater than or equal to about 4 wt%, greater than or equal to about 5 wt%, greater than or equal to about 6 wt%, greater than or equal to about 7 wt%, greater than or equal to about 8 wt%, greater than or equal to about 9 wt%, greater than or equal to about 10 wt%, greater than or equal to about 15 wt%, greater than or equal to about 20 wt%, greater than or equal to about 25 wt%, greater than or equal to about 30 wt%, greater than or equal to about 35 wt%, or greater than or equal to about 40 wt% based on the solid content of the composition or composite (hereinafter, the solid content may be a solid content of the composition or a solid content of the composite). The amount of the semiconductor nanoparticle may be less than or equal to about 70 wt%, for example, less than or equal to about 65 wt%, less than or equal to about 60 wt%, less than or equal to about 55 wt%, or less than or equal to about 50 wt%, based on the solid content of the composition or composite. A weight percentage of a given component with respect to a total solid content in a composition may represent an amount of the given component in the composite described herein.

In an embodiment, an ink composition may be a semiconductor nanoparticle-containing photoresist composition applicable in a photolithography manner. In an embodiment, an ink composition may be a semiconductor nanoparticle-containing composition capable of providing a pattern in a printing manner (e.g., a droplet discharging method such as an inkjet printing). The composition according to an embodiment may not include a conjugated (or conductive) polymer (except for a cardo binder to be described herein). The composition according to an embodiment may include a conjugated polymer. Herein, the conjugated polymer refers to a polymer (e.g., polyphenylenevinylene, or the like) having a conjugated double bond in the main chain.

In the composition according to an embodiment, the dispersant may ensure dispersibility of the nanoparticles. In an embodiment, the dispersant may be a binder (or a binder polymer). The binder may include a carboxylic acid group (e.g., in the repeating unit). The binder may be an insulating polymer. The binder may be a carboxylic acid group-containing compound (a monomer or a polymer).

In the composition (or the composite), an amount of the dispersant may be greater than or equal to about 0.5 wt%, for example, greater than or equal to about 1 wt%, greater than or equal to about 5 wt%, greater than or equal to about 10 wt%, greater than or equal to about 15 wt%, or greater than or equal to about 20 wt%, based on the total solid content of the composition (or composite). The amount of the dispersant may be less than or equal to about 55 wt%, less than or equal to about 35 wt%, less than or equal to about 33 wt%, or less than or equal to about 30 wt%, based on the total solid content of the composition (or composite).

In the composition (or liquid vehicle), a liquid monomer or a polymerizable (e.g., photopolymerizable) monomer (hereinafter, referred to as a monomer) including the carbon-carbon double bond may include a (e.g., photopolymerizable) (meth)acryl-containing monomer. The monomer may be a precursor for an insulating polymer.

An amount of the (photopolymerizable) monomer, based on a total weight or a total solid content of the composition, may be greater than or equal to about 0.5 wt%, for example, greater than or equal to about 1 wt%, greater than or equal to about 2 wt%, greater than or equal to about 3 wt%, greater than or equal to about 5 wt%, or greater than or equal to about 10 wt%. An amount of the (photopolymerizable) monomer, based on a total weight or a total solid content of the composition, may be less than or equal to about 30 wt%, for example, less than or equal to about 28 wt%, less than or equal to about 25 wt%, less than or equal to about 23 wt%, less than or equal to about 20 wt%, less than or equal to about 18 wt%, less than or equal to about 17 wt%, less than or equal to about 16 wt%, or less than or equal to about 15 wt%.

The (photo)initiator included in the composition may be used for (photo)polymerization of the aforementioned

monomer. The initiator is a compound accelerating a radical reaction (e.g., radical polymerization of monomer) by producing radical chemical species under a mild condition (e.g., by heat or light). The initiator may be a thermal initiator or a photoinitiator. The initiator is not particularly limited and may be appropriately selected.

In the composition, an amount of the initiator may be appropriately adjusted considering types and amounts of the polymerizable monomers. In an embodiment, the amount of the initiator may be greater than or equal to about 0.01 wt%, for example, greater than or equal to about 1 wt%, and less than or equal to about 10 wt%, for example, less than or equal to about 9 wt%, less than or equal to about 8 wt%, less than or equal to about 7 wt%, less than or equal to about 6 wt%, or less than or equal to about 5 wt%, based on the total weight of the composition (or the total solid content), but is not limited thereto.

The composition (or composite) may further include a (multi- or monofunctional) thiol compound having at least one thiol group at the terminal end (or a moiety derived therefrom, such as a moiety produced by a reaction between a thiol and a carbon-carbon double bond, for example, a sulfide group), metal oxide particulate, or a combination thereof.

The metal oxide particulates may include $TiO_2$, $SiO_2$, BaTiOs, $Ba_2TiO_4$, ZnO, or a combination thereof. In the composition (or composite), an amount of the metal oxide particulates may be greater than or equal to about 1 wt%, greater than or equal to about 2 wt%, greater than or equal to about 3 wt%, greater than or equal to about 5 wt%, or greater than or equal to about 10 wt% and less than or equal to about 50 wt%, less than or equal to about 40 wt%, less than or equal to about 30 wt%, less than or equal to about 25 wt%, less than or equal to about 20 wt%, less than or equal to about 15 wt%, less than or equal to about 10 wt%, less than or equal to about 7 wt%, less than or equal to about 5 wt%, or less than or equal to about 3 wt%, based on the total solid content.

A diameter of the metal oxide particulates is not particularly limited, and may be appropriately selected. The diameter of the metal oxide particulates may be greater than or equal to about 100 nm, for example greater than or equal to about 150 nm, or greater than or equal to about 200 nm and less than or equal to about 1000 nm, or less than or equal to about 800 nm.

The polythiol compound may be a dithiol compound, a trithiol compound, a tetrathiol compound, or a combination thereof. For example, the thiol compound may be ethylene glycol bis(3-mercaptopropionate), ethylene glycol dimercapto acetate, trimethylolpropane tris(3-mercaptopropionate), pentaerythritol tetrakis(3-mercaptopropionate), pentaerythritol tetrakis(2-mercaptoacetate), 1,6-hexanedithiol, 1,3-propanedithiol, 1,2-ethanedithiol, polyethylene glycol dithiol including 1 to 10 ethylene glycol repeating units, or a combination thereof.

An amount of the thiol compound (or moieties derived therefrom) may be less than or equal to about 50 wt%, less than or equal to about 40 wt%, less than or equal to about 30 wt%, less than or equal to about 20 wt%, less than or equal to about 10 wt%, less than or equal to about 9 wt%, less than or equal to about 8 wt%, less than or equal to about 7 wt%, less than or equal to about 6 wt%, or less than or equal to about 5 wt%, based on the total solid content. The amount of the thiol compound (or moieties derived therefrom) may be greater than or equal to about 0.1 wt%, for example, greater than or equal to about 0.5 wt%, greater than or equal to about 1 wt%, greater than or equal to about 5 wt%, greater than or equal to about 10 wt%, greater than or equal to about 15 wt%, greater than or equal to about 18 wt%, or greater than or equal to about 20 wt%, based on the total solid content.

The composition or the liquid vehicle may include an organic solvent. In an embodiment, the composition or the liquid vehicle may not include an organic solvent. If present, the type of organic solvent that may be used is not particularly limited. The type and amount of the organic solvent is appropriately determined in consideration of the types and amounts of the aforementioned main components (i.e., nanoparticles, dispersants, polymerizable monomers, initiators, thiol compounds, or the like, if present) and other additives to be described herein. The composition may include a solvent in a residual amount except for a desired amount of the (non-volatile) solid. In an embodiment, examples of the organic solvent may be an ethylene glycols, such as ethylene glycol, diethylene glycol, polyethylene glycol, and the like; a glycol ether solvent, such as ethylene glycol monomethylether, ethylene glycol monoethyl ether, diethylene glycol monomethyl ether, ethylene glycol diethyl ether, diethylene glycol dimethyl ether, or the like; a glycol ether acetate solvent, such as ethylene glycol acetate, ethylene glycol monoethyl ether acetate, diethylene glycol monoethyl ether acetate, diethylene glycol monobutyl ether acetate, or the like; a propylene glycol solvent, such as propylene glycol, or the like; a propylene glycol ether solvent, such as propylene glycol monomethyl ether, propylene glycol monoethyl ether, propylene glycol monopropyl ether, propylene glycol monobutyl ether, propylene glycol dimethyl ether, dipropylene glycol dimethyl ether, propylene glycol diethyl ether, dipropylene glycol diethyl ether, or the like; a propylene glycol ether acetate solvent, such as propylene glycol monomethyl ether acetate, dipropylene glycol monoethyl ether acetate, or the like; an amide solvent, such as N-methylpyrrolidone, dimethyl formamide, dimethyl acetamide, or the like; a ketone solvent, such as methylethylketone (MEK), methylisobutylketone (MIBK), cyclohexanone, or the like; a petroleum solvent, such as toluene, xylene, solvent naphtha, or the like; an ester solvent, such as ethyl acetate, butyl acetate, ethyl lactate, ethyl 3-ethoxy propionate, or the like; an ether solvent, such as diethyl ether, dipropyl ether, dibutyl ether, or the like; chloroform, a C1 to C40 aliphatic hydrocarbon solvent (e.g., alkane, alkene, or alkyne), a halogen (e.g., chloro) substituted C1 to C40 aliphatic hydrocarbon solvent (e.g., dichloroethane, trichloromethane, or the like), a C6 to C40 aromatic hydrocarbon solvent (e.g., toluene, xylene, or the like), a halogen (e.g., chloro) substituted C6 to C40 aromatic hydrocarbon solvent; or a combination

thereof.

In addition to the aforementioned components, the composition (or composite) of an embodiment may further include an additive such as a light diffusing agent, a leveling agent, a coupling agent, or a combination thereof. Components (binder, monomer, solvent, additives, thiol compound, cardo binder, or the like) included in the composition of an embodiment may be appropriately selected, and for specific details thereof, for example, US-2017-0052444-A1 may be referred to.

In the preparation of the composition according to an embodiment, each of the above-described components may be manufactured sequentially or simultaneously mixed, and the order thereof is not particularly limited.

The composition may provide a color conversion layer (or a patterned film of the composite) by (e.g., radical) polymerization. The color conversion layer (or the patterned film of the composite) may be produced using a photoresist composition. Referring to FIG. 1A, this method may include forming a film of the aforementioned composition on a substrate (S1); prebaking the film according to selection (S2); exposing a selected region of the film to light (e.g., having a wavelength of less than or equal to about 400 nm) (S3); and developing the exposed film with an alkali developing solution to obtain a pattern of a quantum dot-polymer composite (S4).

Referring to FIG. 1A, the aforementioned composition may be applied to a predetermined thickness on a substrate using an appropriate method such as spin coating or slit coating to form a film. The formed film may be optionally subjected to a pre-baking (PRB) step. The pre-baking may be performed by selecting an appropriate condition from known conditions of a temperature, time, an atmosphere, or the like.

The formed (or optionally prebaked) film may be exposed to light having a predetermined wavelength under a mask having a predetermined pattern (EXP). A wavelength and intensity of the light may be selected considering types and amounts of the photoinitiator, types, and amounts of the quantum dots, or the like.

The exposed film may then be treated with an alkali developing solution (e.g., dipping or spraying) to dissolve an unexposed region and obtain a desired pattern (DEV). The obtained pattern may be, optionally, post-exposure baked (POB) to improve crack resistance and solvent resistance of the pattern, for example, at a temperature of about 150°C to about 230°C for a predetermined time (e.g., greater than or equal to about 10 minutes, or greater than or equal to about 20 minutes) (S5).

When the color conversion layer or the patterned film of the nanoparticle composite has a plurality of repeating sections (that is, color conversion regions), each repeating section may be formed by preparing a plurality of compositions including quantum dots (e.g., red light emitting quantum dots, green light emitting quantum dots, or optionally, blue light emitting quantum dots) having desired luminous properties (photoluminescence peak wavelength or the like) and repeating the aforementioned pattern-forming process as many times as necessary (e.g., 2 times or more, or 3 times or more) for each composition, resultantly obtaining a nanoparticle-polymer composite having a desired pattern (S6). For example, the nanoparticle-polymer composite may have a pattern of at least two repeating color sections (e.g., RGB color sections). This nanoparticle-polymer composite pattern may be used as a photoluminescence type color filter in a display device.

The color conversion layer or patterned film of the nanoparticle composite may be produced using an ink composition configured to form a pattern in an inkjet manner. Referring to FIG. 1B, such a method may include preparing an ink composition according to an embodiment, providing a substrate (e.g., with pixel areas patterned by electrodes and optionally banks or trench-type partition walls, or the like), and depositing an ink composition on the substrate (or the pixel area) to form, for example, a first composite layer (or first region). The method may include depositing an ink composition on the substrate (or the pixel area) to form, for example, a second composite layer (or second region). The first and second composite layers may be first and second quantum dot layers, respectively. The forming of the first composite layer and forming of the second composite layer may be simultaneously or sequentially performed.

The depositing of the ink composition may be performed using an appropriate liquid crystal discharger, for example an inkjet or nozzle printing system (having an ink storage and at least one print head). The deposited ink composition may provide a (first or second) composite layer through the solvent removal and polymerization by the heating. The method may provide a highly precise nanoparticle-polymer composite film or patterned film for a short time by the simple method.

In the nanoparticle-polymer composite (e.g., first composite) of an embodiment, the (polymer) matrix may include the components described herein with respect to the composition. In the composite, an amount of the matrix, based on a total weight of the composite, may be greater than or equal to about 10 wt%, greater than or equal to about 20 wt%, greater than or equal to about 30 wt%, greater than or equal to about 40 wt%, greater than or equal to about 50 wt%, or greater than or equal to about 60 wt%. The amount of the matrix may be, based on a total weight of the composite, less than or equal to about 95 wt%, less than or equal to about 90 wt%, less than or equal to about 80 wt%, less than or equal to about 70 wt%, less than or equal to about 60 wt%, or less than or equal to about 50 wt%.

The (polymer) matrix may include a dispersant (e.g., a carboxylic acid group-containing binder polymer), a polymerization product (e.g., an insulating polymer) of a polymerizable monomer including (at least one, for example, at least two, at least three, at least four, or at least five) carbon-carbon double bonds, a polymerization product of the

polymerizable monomer and a polythiol compound having at least two thiol groups (e.g., at a terminal end), or a combination thereof. The matrix may include a linear polymer, a crosslinked polymer, or a combination thereof. The (polymer) matrix may not include a conjugated polymer (excluding cardo resin). The matrix may include a conjugated polymer.

The crosslinked polymer may include a thiol-ene resin, a crosslinked poly(meth)acrylate, a crosslinked polyurethane, a crosslinked epoxy resin, a crosslinked vinyl polymer, a crosslinked silicone resin, or a combination thereof. In an embodiment, the crosslinked polymer may be a polymerization product of the aforementioned polymerizable monomers and optionally a polythiol compound.

The linear polymer may include a repeating unit derived from a carbon-carbon unsaturated bond (e.g., a carbon-carbon double bond). The repeating unit may include a carboxylic acid group. The linear polymer may include an ethylene repeating unit.

The carboxylic acid group-containing repeating unit may include a unit derived from a monomer including a carboxylic acid group and a carbon-carbon double bond, a unit derived from a monomer having a dianhydride moiety, or a combination thereof.

The (polymer) matrix may include a carboxylic acid group-containing compound (e.g., a binder, a binder polymer, or a dispersant) (e.g., for dispersion of nanoparticles or a binder).

The first composite (or film or pattern thereof) may have, for example, a thickness of less than or equal to about 25 μm, less than or equal to about 20 μm, less than or equal to about 15 μm, less than or equal to about 10 μm, less than or equal to about 8 μm, or less than or equal to about 7 μm to greater than about 2 μm, for example, greater than or equal to about 3 μm, greater than or equal to about 3.5 μm, greater than or equal to about 4 μm, greater than or equal to about 5 μm, greater than or equal to about 6 μm, greater than or equal to about 7 μm, greater than or equal to about 8 μm, greater than or equal to about 9 μm, or greater than or equal to about 10 μm.

The semiconductor nanoparticle(s), the composite (or pattern thereof) including the semiconductor nanoparticle(s), or a color conversion panel including the same may be included in an electronic device. Such an electronic device may include a display device, a light emitting diode (LED), an organic light emitting diode (OLED), a quantum dot LED, a sensor, a solar cell, an imaging sensor, a photodetector, or a liquid crystal display device, but embodiments are not limited thereto. The aforementioned quantum dot may be included in an electronic apparatus. Such an electronic apparatus may include, but is not limited to, a portable terminal device, a monitor, a notebook PC, a television, an electric sign board, a camera, a car, or the like, but embodiments are not limited thereto. The electronic apparatus may be a portable terminal device, a monitor, a laptop personal computer, or a television including a display device (or a light emitting device) including quantum dots. The electronic apparatus may be a camera or a mobile terminal device including an image sensor including quantum dots. The electronic apparatus may be a camera or a vehicle including a photodetector including quantum dots.

An embodiment provides a color conversion layer (e.g., a color conversion structure or a color conversion panel) including a color conversion region including the semiconductor nanoparticle described herein. The color conversion panel may include a color conversion layer including a color conversion region and optionally a partition wall defining each region of the color conversion layer. The color conversion region may include a first region corresponding to a first pixel, and the first region may include the semiconductor nanoparticles or the semiconductor nanoparticle composite. In the color conversion panel of an embodiment, the semiconductor nanoparticle composite may be in the form of a patterned film. In another embodiment, the semiconductor nanoparticle composite may have a sheet form. The first region may include a first composite, and the first composite may include a matrix and semiconductor nanoparticles dispersed in the matrix and may be configured to emit first light. An embodiment provides the semiconductor nanoparticles or a population thereof.

The color conversion layer (e.g., a color conversion structure) may include the semiconductor nanoparticle composite or a patterned film thereof according to an embodiment. FIG. 2A is a schematic cross-sectional view of a color conversion panel according to an embodiment. Referring to FIG. 2A, the color conversion panel may optionally further include a partition wall (e.g., a black matrix (BM), a bank, or a combination thereof) that defines each region of the color conversion layer (e.g., a color conversion structure). FIG. 2B illustrates an electronic device (a display device) including a color conversion panel and a light source according to another embodiment. In the electronic device of an embodiment, a color conversion panel including a color conversion layer or a color conversion structure may be disposed on an LED on a chip (e.g., a micro LED on a chip). Referring to FIG. 3B, a circuit (e.g., Si driver integrated circuit (IC)) configured to drive the light source may be disposed under a light source (e.g., blue LED) configured to emit incident light (e.g., a blue light). The color conversion layer may include a first composite including a semiconductor nanoparticle emitting a first light (e.g., a green light), and a second composite including a semiconductor nanoparticle emitting a second light (e.g., a red light), or a third composite that emits or passes a third light (e.g., incident light or a blue light). A partition wall (PW) (e.g., including an inorganic material, such as silicon or silicon oxide, or based on an organic material), may be disposed between respective composites. The partition wall may include a trench hole, a via hole, or a combination thereof. A first optical element (e.g., an absorption type color filter) may be disposed on a light extraction surface of a color conversion layer. An additional optical element, such as a micro lens, may be further disposed on the first optical element.

The color conversion region may include a first region configured to emit the aforementioned first light (or green light) (e.g., by irradiation with an incident light). In an embodiment, the first region may correspond to a green pixel. The first region may include a first composite (e.g., a luminescence type composite). The first light may have a peak emission wavelength within a wavelength range to be described later. The first light will be described in more detail for the semiconductor nanoparticles described herein. The peak emission wavelength of the green light may be greater than or equal to about 500 nm, greater than or equal to about 501 nm, greater than or equal to about 504 nm, greater than or equal to about 505 nm, or greater than or equal to about 520 nm. The peak emission wavelength of the green light may be less than or equal to about 580 nm, less than or equal to about 560 nm, less than or equal to about 550 nm, less than or equal to about 530 nm, less than or equal to about 525 nm, less than or equal to about 520 nm, less than or equal to about 515 nm, or less than or equal to about 510 nm.

The color conversion region may further include a (e.g., one or more) second region that is configured to emit a second light (e.g., a red light) different from the first light (e.g., by irradiation with excitation light). The second region may include a second composite. The semiconductor nanoparticle composite in the second region may include a semiconductor nanoparticle (e.g., a quantum dot) being configured to emit a light of a different wavelength (e.g., a different color) from the semiconductor nanoparticle composite disposed in the first region.

The second light may be a red light having a peak emission wavelength of about 600 nm to about 650 nm (e.g., about 620 nm to about 650 nm). The color conversion panel may further include (one or more) third regions that emit or pass a third light (e.g., a blue light) different from the first light and the second light. An incident light may include the third light (e.g., a blue light and optionally a green light). The third light may include a blue light having a peak emission wavelength of greater than or equal to about 380 nm (e.g., greater than or equal to about 440 nm, greater than or equal to about 445 nm, greater than or equal to about 450 nm, or greater than or equal to about 455 nm) to less than or equal to about 480 nm (e.g., less than or equal to about 475 nm, less than or equal to about 470 nm, less than or equal to about 465 nm, or less than or equal to about 460 nm).

In an embodiment, the color conversion panel or the color conversion layer may include a plurality of first regions, and the semiconductor nanoparticle composite may constitute a predetermined pattern to be respectively disposed in the first regions of the color conversion panel. The semiconductor nanoparticle composite (or a pattern thereof) may be prepared from the (ink) composition by any method, for example, in a photolithography manner or in an inkjet printing manner. Accordingly, an embodiment may relate to a composition including a semiconductor particle, which was described herein in further detail.

In an embodiment, the electronic device or the display device (e.g., display panel) may further include a color conversion layer (or a color conversion panel) and optionally, a light source. The light source may provide incident light to the color conversion layer or the color conversion panel. In an embodiment, the display panel may include a light emitting panel (or a light source), the aforementioned color conversion panel, and a light transmitting layer located between the aforementioned light emitting panel and the aforementioned color conversion panel. The color conversion panel may include a substrate, and the color conversion layer may be disposed on the substrate.

When present, the light source or the light emitting panel may provide an incident light to the color conversion layer or the color conversion panel. The incident light may have a peak emission wavelength of greater than or equal to about 440 nm, for example, greater than or equal to about 450 nm, and less than or equal to about 580 nm, for example, less than or equal to about 480 nm, less than or equal to about 470 nm, or less than or equal to about 460 nm.

In an embodiment, the electronic device (e.g., a photoluminescent device) may further include a sheet of the nanoparticle composite. Referring to FIG. 3B, the device 400 may include a backlight unit 410 and a liquid crystal panel 420, optionally wherein the backlight unit 410 may include a quantum dot polymer composite sheet (QD sheet). For example, the backlight unit 410 may have a structure that a reflector, a light guide plate (LGP), a light source (a blue LED or the like), the quantum dot polymer composite sheet (QD sheet), and an optical film (a prism, a double brightness enhance film (DBEF, or the like) may be stacked. The liquid crystal panel 420 may be disposed on the backlight unit 410 and have a structure where a thin film transistor (TFT), liquid crystals (LC), and a color filter (color filter) are included between two polarizers (Pol). The quantum dot polymer composite sheet (QD sheet) may include semiconductor nanoparticles (e.g., quantum dots) emitting a red light and a green light after absorbing light from the light source. A blue light provided from the light source may be combined with the red light and the green light emitted from the respective semiconductor nanoparticles, while passing the quantum dot polymer composite sheet, and converted into a white light. The white light may be separated into a blue light, a green light, and a red light by a color filter in the liquid crystal panel, and then emitted to the outside for each pixel. Referring to Fig. 4, the backlight unit (BLU) may be a direct type of a BLU without a light guide plate, and may include a plurality of LEDs (e.g., mini LEDs) and a photoconversion sheet or a QD sheet may be disposed on the BLU.

The color conversion panel may include a substrate, and the color conversion layer may be disposed on the substrate. The color conversion layer or the color conversion panel may include a patterned film of the nanoparticle composite. The patterned film may include a repeating section that is configured to emit light of a desired wavelength. The repeating section may include a second region. The second region may be a red light-emitting section. The repeating

section may include a first region. The first region may be a green light-emitting section. The repeating section may include a third region. The third region may include a section that emits or transmits a blue light. Details of the first, second, and third regions are as described herein.

The light emitting panel or the light source may be an element emitting an incident light (e.g., an excitation light). The incident light may include a blue light, and, optionally, a green light. The light source may include an LED. The light source may include an organic LED (OLED). The light source may include a micro LED. On the front surface (light emitting surface) of the first region and the second region, an optical element to block (e.g., reflect or absorb) a blue light (and optionally a green light) for example, a blue light (and optionally a green light) blocking layer or a first optical filter that will be described herein may be disposed. In an embodiment, the light source may include an organic light emitting diode to emit a blue light and an organic light emitting diode to emit a green light, and a green light removing filter may be further disposed on a third region through which a blue light is transmitted.

The light emitting panel or the light source may include a plurality of light emitting units respectively corresponding to the first region and the second region, and the light emitting units may include a first electrode and a second electrode facing each other, and an (organic) electroluminescent layer located between the first electrode and the second electrode. The electroluminescent layer may include an organic light emitting material. For example, each light emitting unit of the light source may include an electroluminescent device (e.g., an organic light emitting diode (OLED)) structured to emit light of a predetermined wavelength (e.g., a blue light, a green light, or a combination thereof). Structures and materials of the electroluminescent device and the organic light emitting diode (OLED) are not particularly limited.

Hereinafter, the display panel and the color conversion panel will be described in further detail with reference to the drawings.

Referring to FIGS. 3A and 3C, the display panel 1000 according to an embodiment may include a light emitting panel 40 and a color conversion panel 50. The display panel or the electronic device may further include a light transmitting layer 60 disposed between the light emitting pan 40 and the color conversion panel 50, and a binding material 70 binding the light emitting panel 40 and the color conversion panel 50. The light transmitting layer may include a passivation layer, a filling material, an encapsulation layer, or a combination thereof (not shown). A material for the light transmitting layer may be appropriately selected without particular limitation. The material for the light transmitting layer may be an inorganic material, an organic material, an organic/inorganic hybrid material, or a combination thereof.

The light emitting panel 40 and the color conversion panel 50 each may have a surface opposite the other, i.e., the two respective panels may face each other, with the light transmitting layer (or the light transmitting panel) 60 disposed between the two panels. The color conversion panel 50 may be disposed in a direction such that for example, light emitting from the light emitting panel 40 may irradiate the light transmitting layer 60. The binding material 70 may be disposed along edges of the light emitting panel 40 and the color conversion panel 50, and may be, for example, a sealing material.

FIG. 5A is a plan view of an embodiment of a pixel arrangement of a display panel. Referring to FIG. 5A, the display panel 1000 may include a display area 1000D displaying an image and a non-display area 1000P positioned in a peripheral area of the display area 1000D and disposed with a binding material.

The display area 1000D may include a plurality of pixels PX arranged along a row (e.g., an x direction), and a column (e.g., a y direction), and each representative pixel PX may include a plurality of sub-pixels $PX_1$, $PX_2$, and $PX_3$ expressing, e.g., displaying, different colors from each other. An embodiment may be idealized with a structure in which three sub-pixels $PX_1$, $PX_2$, and $PX_3$ are configured to provide a pixel. An embodiment may further include an additional sub-pixel, such as a white sub-pixel, and may further include, e.g., at least one, sub-pixel expressing, e.g., displaying the same colors. The plurality of pixels PX may be aligned, for example, in a Bayer matrix, a matrix sold under the trade designation PenTile, a diamond matrix, or the like, or a combination thereof.

The sub-pixels $PX_1$, $PX_2$, and $PX_3$ may express, e.g., display, three primary colors or a color of a combination of three primary colors, for example, may express, e.g., display, a color of red, green, blue, or a combination thereof. For example, the first sub-pixel $PX_1$ may express, e.g., display, a red color, and the second sub-pixel $PX_2$ may express, e.g., display, a green color, and the third sub-pixel $PX_3$ may express, e.g., display, a blue color.

In the drawing, all sub-pixels are idealized to have the same size, but these are not limited thereto, and at least one of the sub-pixels may be larger or smaller than other sub-pixels. In the drawing, all sub-pixels are idealized to have the same shape, but it is not limited thereto and at least one of the sub-pixels may have a different shape from the other sub-pixels.

In the display panel or electronic device according to an embodiment, the light emitting panel may include a substrate and a TFT (e.g., an oxide-containing TFT, or the like) disposed on the substrate. A light emitting device (e.g., having a tandem structure, or the like) may be disposed on the TFT.

The light emitting device may include a light emitting layer (e.g., a blue light emitting layer, a green light emitting layer, or a combination thereof) located between the first electrode and the second electrode facing each other. A charge generation layer may be disposed between each of the light emitting layers. Each of the first electrode and the second electrode may be patterned with a plurality of electrode elements to correspond to the pixel. The first electrode may be an anode or a cathode. The second electrode may be a cathode or an anode.

The light emitting device may include an organic LED, a nanorod LED, a mini LED, a micro LED, or a combination thereof.

FIGS. 5B to 5E are cross-sectional views showing light emitting devices of an embodiment, respectively. In an embodiment, "a mini LED" may have a size of greater than or equal to about 100 micrometers, greater than or equal to about 150 micrometers, or greater than or equal to about 200 micrometers and less than or equal to about 1 millimeter, less than or equal to about 0.5 millimeters, less than or equal to about 0.15 millimeters, or less than or equal to about 0.12 millimeters, but is not limited thereto. In an embodiment, "a micro LED" may have a size of less than about 100 micrometers, less than or equal to about 50 micrometers, or less than or equal to about 10 micrometers. The size of the micro LED may be greater than or equal to about 0.1 micrometers, greater than or equal to about 0.5 micrometers, greater than or equal to about 1 micrometer, or greater than or equal to about 5 micrometers, but is not limited thereto.

Referring to FIG. 5B, the light emitting device 180 may include a first electrode 181 and a second electrode 182 facing each other; a light emitting layer 183 located between the first electrode 181 and the second electrode 182; and optionally auxiliary layers 184 and 185 located between the first electrode 181 and the light emitting layer 183, and located between the second electrode 182 and the light emitting layer 183, respectively.

The first electrode 181 and the second electrode 182 may be disposed to face each other along a thickness direction (for example, a z direction), and any one of the first electrode 181 and the second electrode 182 may be an anode and the other may be a cathode. The first electrode 181 may be a light transmitting electrode, a semi-transparent electrode, or a reflective electrode, and the second electrode 182 may be a light transmitting electrode or a semi-transparent electrode. The light transmitting electrode or semi-transparent electrode may be, for example, made of a thin single layer or multiple layers of a metal thin film including conductive metal oxides, such as indium tin oxide (ITO), indium zinc oxide (IZO), zinc oxide (ZnO), tin oxide (SnO), aluminum tin oxide (AlTO), fluorine-doped tin oxide (FTO), or the like; or silver (Ag), copper (Cu), aluminum (Al), magnesium (Mg), magnesium-silver (Mg-Ag), magnesium-aluminum (Mg-Al), or a combination thereof. The reflective electrode may include a metal, a metal nitride, or a combination thereof, for example, silver (Ag), copper (Cu), aluminum (Al), gold (Au), titanium (Ti), chromium (Cr), nickel (Ni), an alloy thereof, a nitride thereof (e.g., TiN), or a combination thereof, but embodiments are not limited thereto.

The light emitting layer(s) 183 may include a first light emitting body emitting light with a blue emission spectrum, a second light emitting body emitting light with a green emission spectrum, or a combination thereof.

The blue emission spectrum may have a peak emission wavelength in a wavelength region of greater than or equal to about 400 nm to less than about 500 nm and within the range, in a wavelength region of about 410 nm to about 490 nm, about 420 nm to about 480 nm, about 430 nm to about 470 nm, about 440 nm to about 465 nm, about 445 nm to about 460 nm, or about 450 nm to about 458 nm.

The green emission spectrum may have a peak emission wavelength in a wavelength region of greater than or equal to about 500 nm to less than about 590 nm and within the range, in a wavelength region of about 510 nm to about 580 nm, about 515 nm to about 570 nm, about 520 nm to about 560 nm, about 525 nm to about 555 nm, about 530 nm to about 550 nm, or about 535 nm to about 545 nm.

For example, the light emitting layers 183 or the light emitting body included therein may include a phosphorescent material, a fluorescent material, or a combination thereof. For example, the light emitting body may include an organic light emitting body, wherein the organic light emitting body may be a low molecular compound, a polymer compound, or a combination thereof. Specific types of the phosphorescent material and the fluorescent material are not particularly limited but may be appropriately selected from known materials. For example, the light emitting body may include an inorganic light emitting body, and the inorganic light emitting body may be an inorganic semiconductor, a quantum dot, a perovskite, or a combination thereof. The inorganic semiconductor may include metal nitride, metal oxide, or a combination thereof. The metal nitride, the metal oxide, or the combination thereof may include a Group III metal, such as aluminum, gallium, indium, thallium, or the like, a Group IV metal such as silicon, germanium, tin, or a combination thereof. In an embodiment, the light emitting body may include an inorganic light emitting body, and the light emitting device 180 may be a quantum dot light emitting diode, a perovskite light emitting diode, or a micro light emitting diode ($\mu$LED). Materials usable as the inorganic light emitting body may be selected appropriately.

In an embodiment, the light emitting device 180 may further include an auxiliary layer 184 and 185. The auxiliary layer 184 and 185 may be disposed between a first electrode 181 and a light emitting layer 183, and between a second electrode 182 and a light emitting layer 183, respectively. The auxiliary layer 184 and 185 may be a charge auxiliary layer for controlling injection and/or mobility of charges. The auxiliary layers 184 and 185 may include at least one layer or two layers, and for example, may include a hole injection layer, a hole transport layer, an electron blocking layer, an electron injection layer, an electron transport layer, a hole blocking layer, or a combination thereof. At least one of the auxiliary layers 184 and 185 may be omitted, if desired. The auxiliary layer may be formed of a material appropriately selected from materials known for an organic electroluminescent device, or the like.

The light emitting devices 180 disposed in each of the subpixels $PX_1$, $PX_2$, and $PX_3$ may be the same or different from each other. The light emitting devices 180 in each of the subpixels $PX_1$, $PX_2$, and $PX_3$ may emit a light having the same or different emission spectra. The light emitting devices 180 in each of the subpixels $PX_1$, $PX_2$, and $PX_3$ may emit, for

example, light having a blue emission spectrum, light having a green emission spectrum, or a combination thereof. The light emitting devices 180 in each of the subpixels $PX_1$, $PX_2$, and $PX_3$ may be separated by a pixel defining layer (not shown).

Referring to FIG. 5C, the light emitting device 180 may be a light emitting device having a tandem structure, and may include a first electrode 181 and a second electrode 182 facing each other; a first light emitting layer 183a and a second light emitting layer 183b located between the first electrode 181 and the second electrode 182; a charge generation layer 186 located between the first light emitting layer 183a and the second light emitting layer 183b, and optionally auxiliary layers 184 and 185 located between the first electrode 181 and the first light emitting layer 183a, and/or between the second electrode 182 and the second light emitting layer 183b, respectively.

Details of the first electrode 181, the second electrode 182, and the auxiliary layers 184 and 185 are as described herein.

The first light emitting layer 183a and the second light emitting layer 183b may emit a light having the same or different emission spectra. In an embodiment, the first light emitting layer 183a or the second light emitting layer 183b may emit light having a blue emission spectrum or light having a green emission spectrum, respectively. The charge generation layer 186 may inject an electric charge into the first light emitting layer 183a and/or the second light emitting layer 183b, and may control a charge balance between the first light emitting layer 183a and the second light emitting layer 183b. The charge generation layer 186 may include, for example, an n-type layer and a p-type layer, and may include, for example, an electron transport material and/or a hole transport material including an n-type dopant and/or a p-type dopant. The charge generation layer 186 may include one layer or two or more layers.

Referring to FIG. 5D, a light emitting device (having a tandem structure) may include a first electrode 181 and a second electrode 182 facing each other; a first light emitting layer 183a, a second light emitting layer 183b, and a third light emitting layer 183c located between the first electrode 181 and the second electrode 182; a first charge generation layer 186a located between the first light emitting layer 183a and the second light emitting layer 183b; a second charge generation layer 186b located between the second light emitting layer 183b and the third light emitting layer 183c; and optionally, auxiliary layers 184 and 185 located between the first electrode 181 and the first light emitting layer 183a, and/or between the second electrode 182 and the third light emitting layer 183c, respectively.

Details of the first electrode 181, the second electrode 182, and the auxiliary layers 184 and 185 are as described herein.

The first light emitting layer 183a, the second light emitting layer 183b, and the third light emitting layer 183c may emit a light having the same or different emission spectra. The first light emitting layer 183a, the second light emitting layer 183b, and the third light emitting layer 183c may emit a blue light. In an embodiment, the first light emitting layer 183a and the third light emitting layer 183c may emit light of a blue emission spectrum, and the second light emitting layer 183b may emit light of a green emission spectrum. In another embodiment, the first light emitting layer 183a and the third light emitting layer 183c may emit light of a green emission spectrum, and the second light emitting layer 183b may emit light of a blue emission spectrum.

The first charge generation layer 186a may inject an electric charge into the first light emitting layer 183a and/or the second light emitting layer 183b, and may control charge balances between the first light emitting layer 183a and the second light emitting layer 183b. The second charge generation layer 186b may inject an electric charge into the second light emitting layer 183b and/or the third light emitting layer 183c, and may control charge balances between the second light emitting layer 183b and the third light emitting layer 183c. Each of the first and second charge generation layers 186a and 186b may include one layer or two or more layers, respectively.

Referring to FIG. 5E, in an embodiment, the light emitting device 180 may include a light emitting layer 183, a first electrode 181, a second electrode 182, and a plurality of nanostructures 187 arranged in the light emitting layer 183.

One of the first electrode 181 and the second electrode 182 may be an anode and the other may be a cathode. The first electrode 181 and the second electrode 182 may be an electrode patterned according to a direction of an arrangement of the plurality of nanostructures 187, and may include, for example, a conductive oxide such as indium tin oxide (ITO), indium zinc oxide (IZO), zinc oxide (ZnO), tin oxide (SnO), aluminum tin oxide (AlTO), fluorine-doped tin oxide (FTO), or the like; or silver (Ag), copper (Cu), aluminum (Al), gold (Au), titanium (Ti), chromium (Cr), nickel (Ni), an alloy thereof, a nitride thereof (e.g., TiN); or a combination thereof, but embodiments are not limited thereto.

The light emitting layer 183 may include a plurality of nanostructures 187, and each of the subpixels $PX_1$, $PX_2$, and $PX_3$ may include a plurality of nanostructures 187. In an embodiment, the plurality of nanostructures 187 may be arranged in one direction, but embodiments are not limited thereto. The nanostructures 187 may be a compound-containing semiconductor that is configured to emit light of a predetermined wavelength for example with an application of an electric current, and may be, for example, a linear nanostructure, such as a nanorod or a nanoneedle. A diameter or a long diameter of the nanostructures 187 may be, for example, several nanometers to several hundreds of nanometers, and aspect ratios of the nanostructures 187 may be greater than about 1, greater than or equal to about 1.5, greater than or equal to about 2.0, greater than or equal to about 3.0, greater than or equal to about 4.0, greater than or equal to about 4.5 or greater than or equal to about 5.0 to less than or equal to about 20, for example, greater than about 1 to about 20, about 1.5

to about 20, about 2.0 to about 20, about 3.0 to about 20, about 4.0 to about 20, about 4.5 to about 20, or about 5.0 to about 20.

Each of the nanostructures 187 may include a p-type region 187p, an n-type region 187n, and a multiple quantum well region 187i, and may be configured to emit light from the multiple quantum well region 187i. The nanostructure 187 may include, for example, gallium nitride (GaN), indium gallium nitride (InGaN), aluminum gallium nitride (AlGaN), or a combination thereof, and may have, for example, a core-shell structure.

The plurality of nanostructures 187 may each emit light having the same or different emission spectra. In an embodiment, the nanostructure may emit light of a blue emission spectrum, for example, light of a blue emission spectrum having a peak emission wavelength in a wavelength region of greater than or equal to about 400 nm to less than 500 nm, about 410 nm to about 490 nm, or about 420 nm to about 480 nm.

FIG. 6 is a schematic cross-sectional view of a device (or a display panel) according to an embodiment. Referring to FIG. 6, the light source (or the light emitting panel) may include an organic light emitting diode that emits a blue light (B) (and optionally a green light (G)). The organic light emitting diode (OLED) may include at least two pixel electrodes 90a, 90b, 90c formed on the substrate 100, pixel defining layers 150a, 150b formed between the adjacent pixel electrodes 90a, 90b, 90c, organic light emitting layers 140a, 140b, 140c formed on each pixel electrode 90a, 90b, 90c, and a common electrode layer 130 formed on the organic light emitting layer 140a, 140b, 140c. A thin film transistor (TFT) and a substrate may be disposed under the organic light emitting diode (OLED), which are not shown. Pixel areas of the OLED may be disposed corresponding to the first, second, and third regions described herein. In an embodiment, the color conversion panel and the light emitting panel may be separated as shown in FIG. 6. In an embodiment, the color conversion panel may be stacked directly on the light emitting panel.

A laminated structure including the luminescent nanostructure composite pattern 170 (e.g., a first region 11 or R including red light emitting luminescent nanostructures, a second region 21 or G including green light emitting luminescent nanostructures, and a third region 31 or B including or not including a luminescent nanostructure, e.g., a blue light emitting luminescent nanostructure) and the substrate 240 may be disposed on the light source. The blue light emitted from the light source may enter the first region and second region and may emit a red light and a green light, respectively. The blue light emitted from the light source may pass through the third region. An element (first optical filter 160 or excitation light blocking layer) configured to block the excitation light may be disposed between the luminescent nanostructure composite layers R and G and the substrate, if desired. In an embodiment, the excitation light may include a blue light and a green light, and a green light blocking filter (not shown) may be added to the third region. The first optical filter or the excitation light blocking layer will be described in more detail herein.

Such a (display) device may be produced by separately producing the aforementioned laminated structure and LED or OLED (e.g., emitting a blue light) and then combining the laminated structure and LED or OLED. The (display) device may be produced by directly forming the luminescent nanostructure composite pattern on the LED or OLED.

In the color conversion panel or a display device, a substrate may be a substrate including an insulation material. The substrate may include glass; a polymer, such as a polyester of poly(ethylene terephthalate) (PET), poly(ethylene naphthalate) (PEN), or the like, a polycarbonate, or a polyacrylate; a polysiloxane (e.g. PDMS, or the like); an inorganic material such as $Al_2O_3$, ZnO, or the like; or a combination thereof, but embodiments are not limited thereto. A thickness of the substrate may be appropriately selected taking into consideration a substrate material but is not particularly limited. The substrate may have flexibility. The substrate may have a transmittance of greater than or equal to about 50%, greater than or equal to about 60%, greater than or equal to about 70%, greater than or equal to about 80%, or greater than or equal to about 90% for light emitted from the semiconductor nanoparticle.

A wire layer including a thin film transistor or the like may be formed on the substrate. The wire layer may further include a gate line, a sustain voltage line, a gate insulating film, a data line, a source electrode, a drain electrode, a semiconductor layer, a protective layer, or the like. The detailed structure of the wire layer may vary depending on an embodiment. The gate line and the sustain voltage line may be electrically separated from each other, and the data line may be insulated, crossing the gate line and the sustain voltage line. The gate electrode, the source electrode, and the drain electrode may form a control terminal, an input terminal, and an output terminal of the thin film transistor, respectively. The drain electrode may be electrically connected to the pixel electrode that will be described herein.

The pixel electrode may function as an electrode (e.g., anode) of the display device. The pixel electrode may be formed of a transparent conductive material, such as indium tin oxide (ITO) or indium zinc oxide (IZO). The pixel electrode may be formed of a material having a light blocking property, such as gold (Au), platinum (Pt), nickel (Ni), tungsten (W), chromium (Cr), molybdenum (Mo), iron (Fe), cobalt (Co), copper (Cu), palladium (Pd), or titanium (Ti). The pixel electrode may have a two-layered structure where the transparent conductive material and the material having light blocking properties are stacked sequentially.

Between two adjacent pixel electrodes, a pixel define layer (PDL) may overlap with a terminal end of the pixel electrode to divide the pixel electrode into a pixel unit. The pixel define layer is an insulating layer which may electrically block the at least two pixel electrodes.

The pixel define layer may cover a portion of the upper surface of the pixel electrode, and the remaining region of

the pixel electrode where it is not covered by the pixel define layer may provide an opening. An organic light emitting layer that will be described herein may be formed on the region defined by the opening.

The organic light emitting layer may define each pixel area by the aforementioned pixel electrode and the pixel define layer. In other words, one pixel area may be defined as an area where it is formed with one organic light emitting unit layer which is contacted with one pixel electrode divided by the pixel define layer. In the display device according to an embodiment, the organic light emitting layer may be defined as a first pixel area, a second pixel area, and a third pixel area, and each pixel area may be spaced apart from each other leaving a predetermined interval by the pixel define layer.

In an embodiment, the organic light emitting layer may emit a third light belonging to a visible light region or belonging to an ultraviolet (UV) region. Each of the first to the third pixel areas of the organic light emitting layer may emit a third light. In an embodiment, the third light may be a light having a higher energy in a visible light region, and for example, may be a blue light (and optionally a green light). In an embodiment, all pixel areas of the organic light emitting layer may be designed to emit the same light, and each pixel area of the organic light emitting layer may be formed of materials that are the same or similar or may show the same or similar properties. Thus, a process of forming the organic light emitting layer may be simplified, and the display device may be easily applied for, e.g., made by, a large scale/large area process. However, the organic light emitting layer according to an embodiment is not necessarily limited thereto, but the organic light emitting layer may be designed to emit at least two different lights, e.g., at least two different colored lights.

The organic light emitting layer may include an organic light emitting unit layer in each pixel area, and each organic light emitting unit layer may further include an auxiliary layer (e.g., a hole injection layer, a hole transport layer, an electron transport layer, or the like) besides the light emitting layer.

The common electrode may function as a cathode of the display device. The common electrode may be formed of a transparent conductive material, such as indium tin oxide (ITO) or indium zinc oxide (IZO). The common electrode may be formed on the organic light emitting layer and may be integrated therewith.

A planarization layer or a passivation layer (not shown) may be formed on the common electrode. The planarization layer may include a (e.g., transparent) insulating material for ensuring electrical insulation with the common electrode.

In an embodiment, the display device may further include a lower substrate, a polarizing plate disposed under the lower substrate, and a liquid crystal layer disposed between the laminated structure and the lower substrate, and in the laminated structure, the photoluminescence layer (i.e., light emitting layer) may be disposed to face the liquid crystal layer. The display device may further include a polarizing plate located between the liquid crystal layer and the light emitting layer. The light source may further include LED, and, if desired, a light guide plate.

In an embodiment, the display device (e.g., a liquid crystal display device) are illustrated with a reference to a drawing. FIG. 7A is a schematic cross-sectional view showing a liquid crystal display device according to an embodiment. Referring to FIG. 7A, the display device of an embodiment may include a liquid crystal panel 200, a polarizing plate 300 disposed under the liquid crystal panel 200, and a backlight unit disposed under the polarizing plate 300.

The liquid crystal panel 200 may include a lower substrate 210, a stacked structure, and a liquid crystal layer 220 disposed between the stack structure and the lower substrate. The stack structure may include a transparent substrate 240, a first optical filter layer 310, a photoluminescent layer 230 including a pattern of a semiconductor nanoparticle polymer composite, and a second optical filter layer 311.

The lower substrate 210, also referred to as an array substrate, may be a transparent insulating material substrate. The substrate may be as described herein. A wire plate 211 may be provided on an upper surface of the lower substrate 210. The wire plate 211 may include a plurality of gate wires (not shown) and data wires (not shown) that define a pixel area, a thin film transistor disposed adjacent to a crossing region of gate wires and data wires, and a pixel electrode for each pixel area, but embodiments are not limited thereto. Details of such a wire plate are not particularly limited.

A liquid crystal layer 220 may be provided on the wire plate 211. The liquid crystal panel 200 may include an alignment layer 221 on and under the liquid crystal layer 220 to initially align the liquid crystal material included therein. Details (e.g., a liquid crystal material, an alignment layer material, a method of forming liquid crystal layer, a thickness of liquid crystal layer, or the like) of the liquid crystal layer and the alignment layer are not particularly limited.

A lower polarizing plate 300 may be provided under the lower substrate. Materials and structures of the polarizing plate 300 are not particularly limited. A backlight unit (e.g., emitting a blue light) may be disposed under the polarizing plate 300. An upper optical element or the polarizing plate 300 may be provided between the liquid crystal layer 220 and the transparent substrate 240, but is not limited thereto. For example, the upper polarizing plate may be disposed between the liquid crystal layer 220 and the photoluminescent layer 230. The polarizing plate may be any polarizer that can be used in a liquid crystal display device. The polarizing plate may be triacetyl cellulose (TAC) having a thickness of less than or equal to about 200 $\mu$m, but is not limited thereto. In another embodiment, the upper optical element may be a coating that controls a refractive index without a polarization function.

The backlight unit may include a light source 110. The light source may emit a blue light or a white light. The light source may include, but is not limited to, a blue LED, a white LED, a white OLED, or a combination thereof.

The backlight unit may further include a light guide plate 120. In an embodiment, the backlight unit may be of an

edge type. For example, the backlight unit may include a reflector (not shown), a light guide plate (not shown) provided on the reflector and providing a planar light source to the liquid crystal panel 200, and/or at least one optical sheet (not shown) on the light guide plate, for example, a diffusion plate, a prism sheet, and the like, but the present disclosure is not limited thereto. The backlight unit may not include a light guide plate. In an embodiment, the backlight unit may be direct lighting. For example, the backlight unit may have a reflector (not shown) and a plurality of fluorescent lamps on the reflector at regular intervals, or may have an LED operating substrate on which a plurality of light emitting diodes, a diffusion plate thereon, and optionally at least one optical sheet may be disposed. Details (e.g., each component of a light emitting diode, a fluorescent lamp, a light guide plate, various optical sheets, and a reflector) of such a backlight unit are known and are not particularly limited.

A black matrix 241 may be provided under the transparent substrate 240 and may have openings and hide a gate line, a data line, and a thin film transistor of the wire plate on the lower substrate. For example, the black matrix 241 may have a grid shape. The photoluminescent layer 230 may be provided in the opening of the black matrix 241 and has a nanoparticle-polymer composite pattern including a first region R configured to emit a first light (e.g., a red light), a second region G configured to emit a second light (e.g., a green light), and a third region B configured to emit/transmit a third light, for example a blue light. If desired, the photoluminescent layer may further include at least a fourth region. The fourth region may include a quantum dot that emits light of a different color from the light emitted from the first to third regions (e.g., cyan, magenta, and yellow light).

In the photoluminescent layer 230, sections forming the pattern may be repeated corresponding to pixel areas formed on the lower substrate. A transparent common electrode 231 may be provided on the photoluminescent layer 230.

The third region (B) configured to emit/transmit a blue light may be a transparent color filter that does not change the emission spectrum of the light source. In this case, the blue light emitted from the backlight unit may enter in a polarized state and may be emitted through the polarizing plate and the liquid crystal layer as is. If needed, the third region may include a quantum dot emitting a blue light.

As described herein, if desired, the display device or light emitting device according to an embodiment may further include an excitation light blocking layer or a first optical filter layer (hereinafter, referred to as a first optical filter layer). The first optical filter layer may be disposed between the bottom surface of the first region (R) and the second region (G) and the substrate (e.g., the upper substrate 240) or on the upper surface of the substrate. The first optical filter layer may be a sheet having an opening in a portion corresponding to a pixel area (third region) displaying blue, and thus may be formed in portions corresponding to the first and second regions. That is, the first optical filter layer may be integrally formed at positions other than the position overlapped with the third region as shown in FIGS. 1A, 1B, 6 and/or 7A, but is not limited thereto. Two or more first optical filter layers may be spaced apart from each other at positions overlapped with the first and second regions, and optionally, the third region. When the light source includes a green light emitting device, a green light blocking layer may be disposed on the third region.

The first optical filter layer may block light, for example, in a predetermined wavelength region in the visible light region and may transmit light in the other wavelength regions, and for example, it may block a blue light (or a green light) and may transmit light except the blue light (or the green light). The first optical filter layer may transmit, for example, a green light, a red light, and/or a yellow light that is a mixed color thereof. The first optical filter layer may transmit a blue light and block a green light, and may be disposed on the blue light emitting pixel.

The first optical filter layer may substantially block excitation light and transmit light in a desired wavelength region. The transmittance of the first optical filter layer for the light in a desired wavelength range may be greater than or equal to about 70%, greater than or equal to about 80%, greater than or equal to about 90%, or even about 100%.

The first optical filter layer configured to selectively transmit a red light may be disposed at a position overlapped with the red light emitting section, and the first optical filter layer configured to selectively transmit a green light may be disposed at a position overlapped with the green light emitting section. The first optical filter layer may include a first filter region that blocks (e.g., absorbs) the blue light and the red light and selectively transmits light of a predetermined range (e.g., greater than or equal to about 500 nm, greater than or equal to about 510 nm, or greater than or equal to about 515 nm to less than or equal to about 550 nm, less than or equal to about 545 nm, less than or equal to about 540 nm, less than or equal to about 535 nm, less than or equal to about 530 nm, less than or equal to about 525 nm, or less than or equal to about 520 nm); a second filter region that blocks (e.g., absorbs) a blue light and a green light and selectively transmits light of a predetermined range (e.g., greater than or equal to about 600 nm, greater than or equal to about 610 nm, or greater than or equal to about 615 nm to less than or equal to about 650 nm, less than or equal to about 645 nm, less than or equal to about 640 nm, less than or equal to about 635 nm, less than or equal to about 630 nm, less than or equal to about 625 nm, or less than or equal to about 620 nm); or the first filter region and the second filter region. In an embodiment, the light source may emit a blue and a green mixed light, and the first optical filter layer may further include a third filter region that selectively transmits a blue light and blocks a green light.

The first filter region may be disposed at a position overlapped with the green light emitting section. The second filter region may be disposed at a position overlapped with the red light emitting section. The third filter region may be disposed at a position overlapped with the blue light emitting section.

The first filter region, the second filter region, and, optionally, the third filter region may be optically isolated. Such a first optical filter layer may contribute to improvement of color purity of the display device.

The display device may further include a second optical filter layer (e.g., a recycling layer of red/green light or yellow light) that is disposed between the photoluminescent layer and the liquid crystal layer (e.g., between the photoluminescent layer and the upper polarizing plate), transmits at least a portion of the third light (excitation light), and reflects at least a portion of the first light and/or the second light. The first light may be a red light, the second light may be a green light, and the third light may be a blue light. The second optical filter layer may transmit only the third light (B) in a blue light wavelength region having a wavelength region of less than or equal to about 500 nm and light in a wavelength region of greater than about 500 nm, which is green light (G), yellow light, red light (R), or the like, may be not passed through the second optical filter layer and reflected. The reflected green light and red light may pass through the first and second regions to be emitted to the outside of the display device.

The second optical filter layer or the first optical filter layer may be formed as an integrated layer having a relatively planar surface.

The first optical filter layer may include a polymer thin film including a dye and/or a pigment absorbing light in a wavelength which is to be blocked. The second optical filter layer or the first optical filter layer may include a single layer having a low refractive index, and may be, for example, a transparent thin film having a refractive index of less than or equal to about 1.4:1, less than or equal to about 1.3, or less than or equal to about 1.2. The second optical filter layer or the first optical filter layer having a low refractive index may include, for example, a porous silicon oxide, a porous organic material, a porous organic-inorganic composite, or the like, or a combination thereof.

The first optical filter layer or the second optical filter layer may include a plurality of layers having different refractive indexes. The first optical filter layer or the second optical filter layer may be formed by laminating two layers having different refractive indexes. For example, the first/second optical filter layer may be formed by alternately laminating a material having a high refractive index and a material having a low refractive index.

In an embodiment, the electronic device may include a light emitting device (e.g., an electroluminescent device) including the nanoparticles described above. FIG. 7B is a schematic cross-sectional view of a light emitting device (electroluminescent device) according to an embodiment. Referring to FIG. 7B, the light emitting device may include an anode 1 and a cathode 5 facing each other; a quantum dot light emitting layer 3 disposed between the anode and the cathode, including a plurality of quantum dots; and a hole auxiliary layer 2 located between the anode and the quantum dot light emitting layer. The hole auxiliary layer may further include a hole injecting layer (HIL), a hole transporting layer (HTL), an electron blocking layer (EBL), or a combination thereof. The hole auxiliary layer may include any organic/inorganic material having hole characteristics. The quantum dot light emitting device may further include an electron auxiliary layer 4 located between the cathode and the quantum dot light emitting layer. The electron auxiliary layer may include an electron injecting layer (EIL), an electron transporting layer (ETL), a hole blocking layer (HBL), or a combination thereof. The electron auxiliary layer may include any organic/inorganic material having electronic properties.

Hereinafter, the exemplary embodiments are illustrated in further detail with reference to examples. However, embodiments of the present disclosure are not limited to the examples.

## EXAMPLES

### Analysis Methods

#### [1] Photoluminescence Analysis

A photoluminescence (PL) spectrum of the nanoparticles produced and a composite including the same was obtained using a Hitachi F-7000 spectrophotometer at an excitation wavelength of 450 nm.

#### [2] Blue Light Absorbance, Quantum efficiency, and Light Conversion Efficiency (CE) of the composite

An amount of incident light of a wavelength of 450 nm (B) was measured by using an integrating sphere or an integrating hemisphere of an absolute quantum efficiency-measuring device (e.g., QE-2100, Otsuka Electronics Co., Ltd.). Subsequently, a semiconductor nanoparticle (quantum dot, QD) polymer composite was placed in the integrating (hemi)sphere, and then, the incident light was irradiated to measure an amount of first light from the composite (A), and an amount of the incident light passing the composite (B'), respectively.

Using the measured amounts, an incident light absorbance, the light conversion efficiency (for example, an internal quantum efficiency) and a quantum efficiency (for example, an external quantum efficiency) were calculated according to Equations 2 to 4:

$$\text{Equation 2:} \quad \text{Incident light absorbance (\%)} = [(B-B')/B] \times 100\%$$

$$\text{Equation 3:} \quad \text{Internal Quantum efficiency (\%)} = [A/(B-B')] \times 100\%$$

$$\text{Equation 4:} \quad \text{External Quantum efficiency (\%)} = [A/B] \times 100\%$$

wherein, in Equations 2 to 4,

A is an amount of a first light emitted from the first composite,
B is an amount of incident light provided to the first composite, and
B' is an amount of incident light passing through the first composite.

[3] Process Maintenance Percentage

The semiconductor nanoparticle-polymer composite obtained by polymerization was heat-treated at 180°C for 30 minutes, and a process maintenance percentage was measured according to the following equation:

Equation 5

$$\text{Process Maintenance percentage (\%)} = [IQE2/IQE1] \times 100\%$$

wherein in Equation 5, IQE1 is the internal quantum efficiency of the semiconductor nanoparticle-polymer composite before the heat treatment after polymerization, and IQE2 is the internal quantum efficiency of the semiconductor nanoparticle-polymer composite after heat treatment.

[4] ICP Analysis

Inductively coupled plasma atomic emission spectroscopy (ICP-AES) was performed using a Shimadzu ICPS-8100.

Example 1:

Sulfur was dissolved in oleylamine to prepare a 1 molar (M) sulfur precursor containing solution (hereinafter, abbreviated as "sulfur precursor"). In a 100 mL reaction flask, octadecene (ODE), oleylamine, silver acetate, indium acetate, and gallium acetylacetonate were added and vacuum-treated at room temperature for 10 minutes. Nitrogen gas is introduced into the reaction flask, and the sulfur precursor and dodecanethiol were added to the flask. The flask was heated at a reaction temperature of 210°C, and a reaction proceeded for 60 minutes. After decreasing the temperature of the flask to 180°C, trioctylphosphine (TOP) was added to the flask, hexane and ethanol were then added to facilitate precipitation. The obtained first semiconductor nanocrystals were separated and recovered by centrifugation and re-dispersed in toluene. The molar ratio of the silver precursor, the indium precursor, the gallium precursor, and the sulfur precursor used was 0.8:0.95:1.1:4.

Gallium bromide and gallium chloride were dissolved in a trioctylphosphine solution ($GaCl_3$:$GaBr_3$ = 0.25:0.75, mole ratio) to prepare a 1 M gallium precursor-containing solution (hereinafter referred to as the gallium precursor). A silver compound (silver acetate 0.06 M) was dispersed in oleylamine to prepare a silver compound dispersion.

Dimethylthiourea (DMTU), oleyl amine, and octadecene were placed in a reaction flask and then vacuum-treated at 120°C for 10 minutes. Following the introduction of nitrogen gas into the reaction flask, the flask is heated at 240°C, the gallium precursor, the first semiconductor nanocrystal, and the silver compound dispersion were added to the reaction flask. Then, the reaction flask was heated to 260°C (a second temperature) to perform a reaction for about 200 minutes (a first time). The reaction solution was cooled to 180°C, and trioctylphosphine was added to the flask and the reaction mixture was cooled to room temperature. A poor solvent (i.e., an antisolvent) was added to the flask to facilitate precipitation of semiconductor nanoparticles, which were separated and recovered via centrifugation and redispersed in toluene.

A mole ratio of the gallium precursor to the sulfur precursor as used was 16.8:22.4. The silver compound was used in an amount of about 5 mol% with respect to the gallium precursor.

An ICP-AES analysis and a photoluminescence analysis were performed on the manufactured semiconductor nanoparticle, and the results are summarized in Tables 1 and 2.

Example 2

A semiconductor nanoparticle was prepared in the same manner as in Example 1, except that the mole ratio among the precursors used in the formation of the first semiconductor nanocrystal was changed to Ag:In:Ga:S = 0.8:1.0:1.0:4, and the reaction temperature and reaction time were set to 260°C for 140 minutes followed by 280°C for 60 minutes.

An ICP-AES analysis and a photoluminescence analysis were performed on the manufactured semiconductor nanoparticles, and the results are summarized in Tables 1 and 2.

Comparative Example 1

A semiconductor nanoparticle was prepared in a similar manner as in Example 1, except that gallium chloride was used as the gallium precursor instead of gallium bromide, and the reaction temperature and time were adjusted to 260°C for 70 minutes.

An ICP-AES analysis and a photoluminescence analysis were performed on the manufactured semiconductor nanoparticle, and the results are summarized in Tables 1 and 2.

Comparative Example 2

A semiconductor nanoparticle was prepared in a similar manner as in Example 1, except that as a gallium precursor, gallium iodide was used instead of gallium bromide, the amount of the silver compound was doubled, and the reaction temperature and time were adjusted to 260°C and 130 minutes, respectively.

An ICP-AES analysis and a photoluminescence analysis were performed on the manufactured semiconductor nanoparticles, and the results are summarized in Tables 1 and 2.

Table 1

| | Mole ratio | | | |
|---|---|---|---|---|
| | Ga:In | Ag:In | S:In | (In+Ga):Ag |
| Example 1 | 6.74:1 | 5.21:1 | 13.37:1 | 1.48:1 |
| Example 2 | 7.51:1 | 5.19:1 | 13.35:1 | 1.64:1 |
| Comp. Example 1 | 4.20:1 | 2.97:1 | 8.78:1 | 1.75:1 |
| Comp. Example 2 | 5.19:1 | 3.91:1 | 8.77:1 | 1.58:1 |

Table 2

| | Peak emission wavelength | Full width at half maximum | Relative QY | trap emission ratio |
|---|---|---|---|---|
| Example 1 | 519 nm | 33 nm | 138% | 4.0% |
| Example 2 | 521 nm | 37 nm | 133% | 4.4% |
| Comp. Example 1 | 523 nm | 36 nm | 100% | 7.1% |
| Comp. Example 2 | 525 nm | 35 nm | 103% | 6.6% |

Relative QY: Absolute quantum yield (QY) of the given semiconductor nanoparticle / Absolute quantum yield (QY) of Comparative Example 1

A trap emission ratio: The percentage of the spectrum area in the wavelength range of the emission peak wavelength + 50 nm or longer to the total area of the photoluminescence spectrum

As shown in the results of Table 2, the semiconductor nanoparticles of the examples exhibited significantly improved luminescence characteristics, compared with the semiconductor nanoparticles of the comparative examples.

Experimental Example 1

A toluene solution of the semiconductor nanoparticle prepared in each of Examples 1 and 2 and Comparative Examples 1 and 2 was mixed with a binder (a quaternary copolymer of methacrylic acid, benzyl methacrylate, hydroxyethylmethacrylate, and styrene, having an acid value of 130 mg potassium hydroxide per gram (KOH/g), and a

molecular weight of 8000 grams per mole) solution (in propylene glycol monomethyl ether acetate (PGMEA), at a concentration 30 wt%), to obtain a semiconductor nanoparticle-binder dispersion, respectively.

To each of semiconductor nanoparticle-binder dispersion, hexaacrylate with the following structure as a photopolymerizable monomer, ethylene glycol bis(3-mercaptopropionate) (hereinafter, 2T), an oxime-ester compound as an initiator, $TiO_2$ as a light diffusing agent, and PGMEA were added and mixed together to provide a composition.

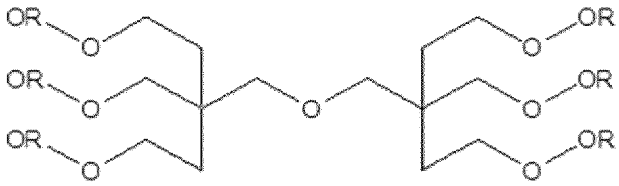

OR=

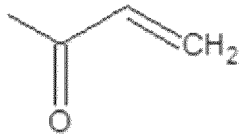

The compositions thus prepared included 20 wt% of semiconductor nanoparticles based on a total solid weight thereof, respectively.

Each of the compositions were respectively spin-coated on a glass substrate at 600 revolutions per minute (rpm) for 5 seconds to obtain a film. The film thus obtained was pre-baked (PRB) at 100°C. The pre-baked film was irradiated with light (at a wavelength of 395 nm and an intensity of 4J) to obtain a nanoparticle-polymer composite film (having a thickness of about 7 μm).

It was confirmed that the composites containing the semiconductor nanoparticle of the examples all exhibited an incident light absorption of over 90%. The photoconversion efficiency (internal quantum efficiency) for each of the composites containing the semiconductor nanoparticles of the examples and comparative examples was measured, and the results are summarized in Table 3 below.

For each of the obtained films, the relative internal quantum efficiency and relative process maintenance after POB were measured, as well. The results are shown in Table 3 below.

Table 3

| Semiconductor nanoparticle in the composite | Relative Internal Quantum Efficiency after POB | Relative Process Maintenance |
|---|---|---|
| Example 1 | 131% | 108% |
| Example 2 | 130% | 106% |
| Comp. Example 1 | 100% | 100% |
| Comp. Example 2 | 76% | 90% |

Relative Internal Quantum Efficiency after POB (%): [Internal Quantum Efficiency of the given composite after POB/Internal Quantum Efficiency of the composite of Comparative Example 1 after POB] * 100%

Relative Process Maintenance (%): ([Process maintenance percentage of the given composite/Process maintenance percentage of the composite of Comparative Example 1] * 100%

From the results in Table 3, it was confirmed that the semiconductor nanoparticles of the examples can exhibit improved luminescence efficiency in the composite and relatively increased process maintenance (i.e., enhanced stability) compared to the semiconductor nanoparticle of the comparative examples.

Example 3

A semiconductor nanoparticle was prepared in the same manner as in Example 1, except that the amount of the Ag compound and the amount of DMTU were increased by 2.76 times and 1.5 times, respectively, and the amount of the

first semiconductor nanocrystal used was reduced by half.

An ICP-AES analysis was performed on the manufactured semiconductor nanoparticle, and the results are summarized in Table 4.

Example 4

A semiconductor nanoparticle was prepared in the same manner as in Example 1, except that the molar ratio of the precursors used in the synthesis of the first semiconductor nanocrystals was adjusted to Ag:In:Ga:S = 0.8:0.5:1.1:4, and the reaction temperature and time were adjusted to 260°C and 120 minutes.

An ICP-AES analysis was performed on the manufactured semiconductor nanoparticle, and the results are summarized in Table 4.

Example 5

A semiconductor nanoparticle was prepared in the same manner as in Example 1, except that the amount of the Ag compound was increased by 4.14 times, the amount of the cores was reduced to one-fourth, and only the $GaBr_3$ (without $GaCl_3$) was used as the gallium precursor.

An ICP-AES analysis was performed on the manufactured semiconductor nanoparticle, and the results are summarized in Table 4.

Comparative Example 3

A semiconductor nanoparticle was prepared in the same manner as in Example 1, except that gallium chloride was used as the gallium precursor instead of gallium bromide, the amount of the DMTU was increased by 1.6 times, and the reaction temperature and time were adjusted to 260°C and 130 minutes.

An ICP-AES analysis was performed on the manufactured semiconductor nanoparticle, and the results are summarized in Table 3.

Table 4

| | Mole ratio | | | |
|---|---|---|---|---|
| | Ga:In | Ag:In | S:In | (In+Ga):Ag |
| Example 3 | 15.71:1 | 11.82:1 | 30.29:1 | 1.41:1 |
| Example 4 | 16.12:1 | 11.94:1 | 29.76:1 | 1.43:1 |
| Example 5 | 23.38:1 | 15.77:1 | 36.77:1 | 1.55:1 |
| Comp. Example 3 | 4.98:1 | 3.67:1 | 8.53:1 | 1.63:1 |

Experimental Example 2

Semiconductor nanoparticle-polymer composite films were prepared in the same manner as in Experimental Example 1, except that the toluene solutions of the semiconductor nanoparticles obtained in Examples 3, 4, 5, and Comparative Example 3 were used, respectively. For the obtained composite films, the process maintenance percentage and the increase of the trap emission after POB were evaluated, and the results are summarized in Table 5 below.

Table 5

| Semiconductor nanoparticle in the composite | Process maintenance percentage | Increase of Trap Emission after POB |
|---|---|---|
| Example 3 | 77% | 269% |
| Example 4 | 91% | 258% |
| Example 5 | 92% | 179% |
| Comp. Example 3 | 75% | 503% |

Increase of Trap Emission after POB (%) is calculated as follows:

[Trap emission in the Photoluminescence Spectrum of the Composite after POB /Trap emission in the Semiconductor Nanoparticle Solution] * 100%

From the results in Table 5, it was confirmed that in comparison with the semiconductor nanoparticle of the comparative example, the semiconductor nanoparticles of the examples exhibit improved stability within the composite, and the increase in trap emission is also suppressed.

While this disclosure has been described in connection with what is presently considered to be practical embodiments, it is to be understood that the present subject matter is not limited to the disclosed exemplary embodiments. On the contrary, it is intended to cover various modifications and equivalent arrangements included within the scope of the appended claims.

## Claims

1. A semiconductor nanoparticle comprising silver, indium, gallium, and sulfur, wherein in the semiconductor nanoparticle, a mole ratio of gallium to indium (Ga:In) is greater than or equal to 6.7:1 and less than or equal to 40:1, and a mole ratio of silver to indium (Ag:In) is greater than or equal to 5:1 and less than or equal to 30:1,
wherein the semiconductor nanoparticle is configured to emit light, and a full width at half maximum of a luminescent spectrum of the light is greater than or equal to 10 nm and less than or equal to 50 nm.

2. The semiconductor nanoparticle of claim 1, wherein
the semiconductor nanoparticle comprises a first semiconductor nanocrystal comprising silver, indium, gallium, and sulfur, and a second semiconductor nanocrystal comprising silver, gallium, and sulfur.

3. The semiconductor nanoparticle of claims 1 or 2, wherein in the semiconductor nanoparticle, the mole ratio of gallium to indium is greater than or equal to 10.5:1 and less than or equal to 37:1, and the mole ratio of silver to indium is greater than or equal to 7:1 and less than or equal to 25:1;
preferably wherein the mole ratio of gallium to indium is greater than or equal to 15:1 and less than or equal to 35:1, and the mole ratio of silver to indium is greater than or equal to 10:1 and less than or equal to 17:1.

4. The semiconductor nanoparticle of any of claims 1-3, wherein
in the semiconductor nanoparticle, a mole ratio of a sum of indium and gallium to silver [(In+Ga):Ag] is greater than or equal to 1.3:1, and less than or equal to 1.65:1.

5. The semiconductor nanoparticle of any of claims 1-4, wherein

    in the semiconductor nanoparticle, a mole ratio of indium to sulfur (In:S) is greater than or equal to 0.005:1 and less than 0.1:1, or
    a mole ratio of gallium to sulfur (Ga:S) is greater than or equal to 0.3:1 and less than or equal to 0.55:1, or
    a mole ratio of silver to sulfur (Ag:S) is greater than or equal to 0.33:1 and less than or equal to 0.45:1.

6. The semiconductor nanoparticle of any of claims 1-5, wherein

    in the semiconductor nanoparticle, a mole ratio of silver to a sum of silver, indium, and gallium [Ag:(Ag+In+Ga)] is greater than or equal to 0.31:1 and less than or equal to 0.42:1, or
    a mole ratio of sulfur to a sum of silver, indium, and gallium [S:(Ag+In+Ga)] is greater than or equal to 0.8:1 and less than or equal to 1.12:1.

7. The semiconductor nanoparticle of any of claims 1-6, wherein in the semiconductor nanoparticle, the mole ratio of gallium to indium is greater than or equal to 20:1; and/or
wherein the semiconductor nanoparticle has a peak emission wavelength of greater than or equal to 500 nm and less than or equal to 580 nm, and a quantum efficiency of greater than or equal to 40%.

8. The semiconductor nanoparticle of any of claims 1-7, wherein
in an ultraviolet-visible absorption spectroscopy, the semiconductor nanoparticle exhibits a ratio of absorption at 350 nanometers to absorption at 370 nanometers that is greater than or equal to 0.1:1 and less than or equal to 1.2:1

9. A method of preparing the semiconductor nanoparticle of claim 1, the method comprising

combining a first semiconductor nanocrystal comprising, silver, a group 13 element, and a chalcogen element,
a sulfur precursor,
a gallium precursor comprising gallium bromide,
optionally, an organic ligand, a silver compound, or a combination thereof, and
a medium comprising an organic solvent to provide a reaction mixture; and
heating the reaction mixture to provide the semiconductor nanoparticle.

10. The method of claim 9, wherein the method further comprises adding a silver compound to the medium.

11. The method of claim 10, wherein the silver compound is added to the medium in an amount of greater than or equal to 1 mole percent and less than or equal to 50 mole percent; and/or
wherein the silver compound comprises a silver carboxylate, a silver acetylacetonate, a silver halide, or a combination thereof.

12. An ink composition, comprising:
the semiconductor nanoparticle of any of claims 1-8, and a liquid vehicle.

13. A semiconductor nanoparticle composite, wherein the semiconductor nanoparticle composite comprises a matrix and the semiconductor nanoparticle of any of claims 1-8 dispersed in the matrix;

preferably wherein
a semiconductor nanoparticle-polymer composite exhibits an internal quantum efficiency of greater than or equal to 50% and the internal quantum efficiency is defined by Equation 2:

Equation 2

$$\text{Internal quantum efficiency (\%)} = [A/(B-B')] \times 100$$

wherein:

A: amount of a first light emitted from the semiconductor nanoparticle-polymer composite
B: amount of irradiated incident light
B': amount of the irradiated incident light passing through the semiconductor nanoparticle-polymer composite.

14. A color conversion structure, wherein the color conversion structure comprises a color conversion layer comprising a color conversion region and, optionally, a partition wall defining each region of the color conversion layer, wherein the color conversion region comprises a first region corresponding to a first pixel, and the first region comprises the semiconductor nanoparticle of any of claims 1-8.

15. An electronic device comprising the semiconductor nanoparticle of any of claims 1-8.

# FIG. 1A

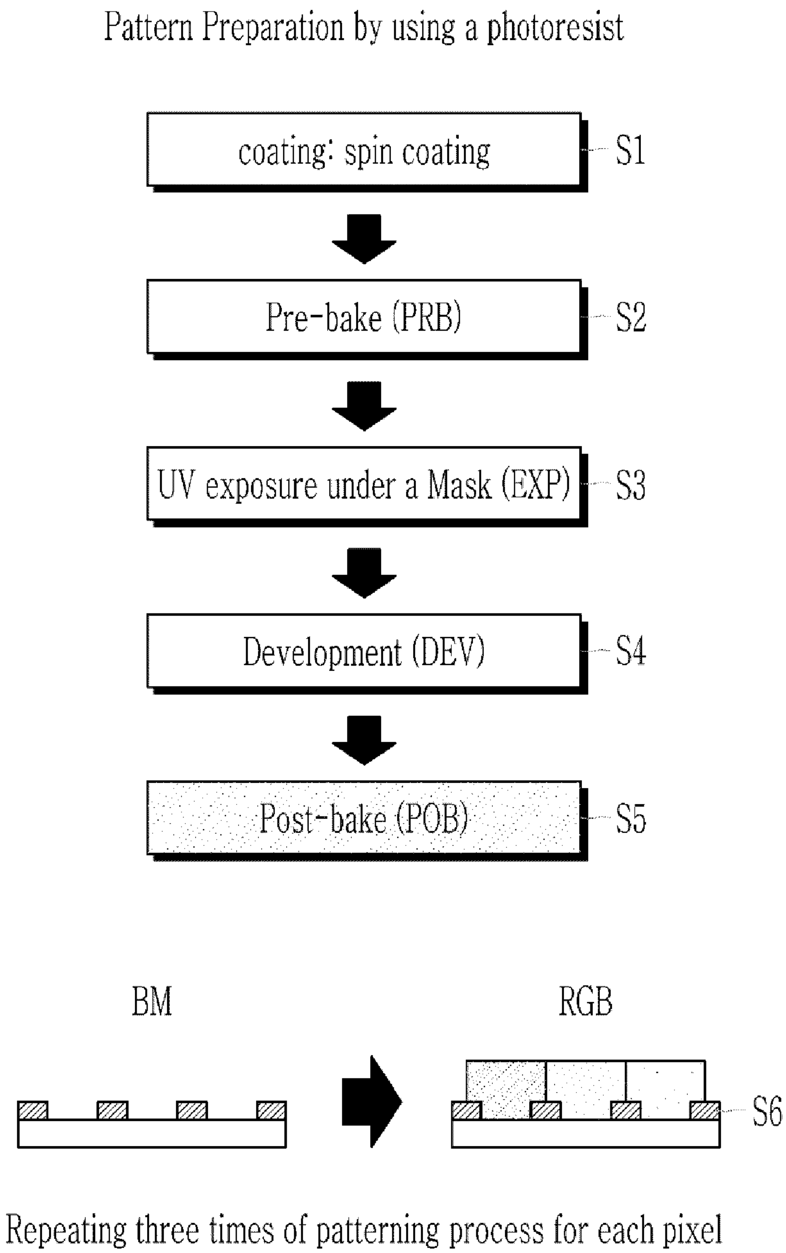
Pattern Preparation by using a photoresist
coating: spin coating
S1
Pre-bake (PRB)
S2
UV exposure under a Mask (EXP)
S3
Development (DEV)
S4
Post-bake (POB)
S5
BM
RGB
S6
Repeating three times of patterning process for each pixel

FIG. 1B

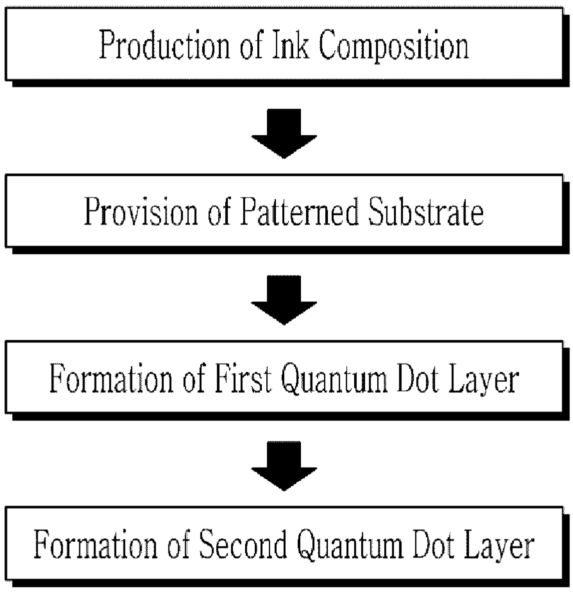
Production of Ink Composition
Provision of Patterned Substrate
Formation of First Quantum Dot Layer
Formation of Second Quantum Dot Layer

FIG.2A

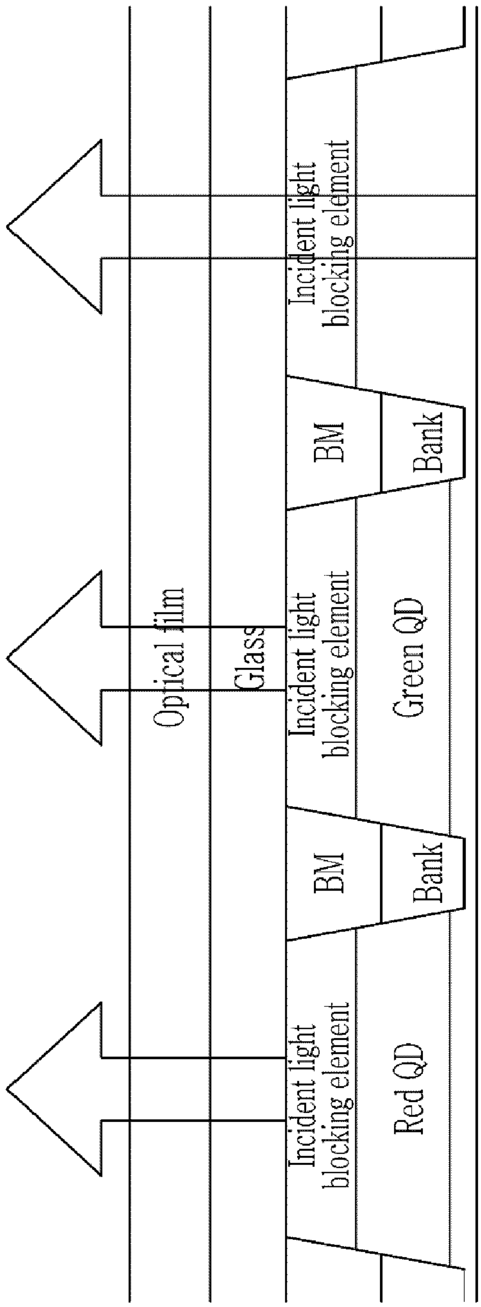
Optical film
Glass
Incident light blocking element
Incident light blocking element
Incident light blocking element
Red QD
Green QD
BM
BM
Bank
Bank

FIG. 2B

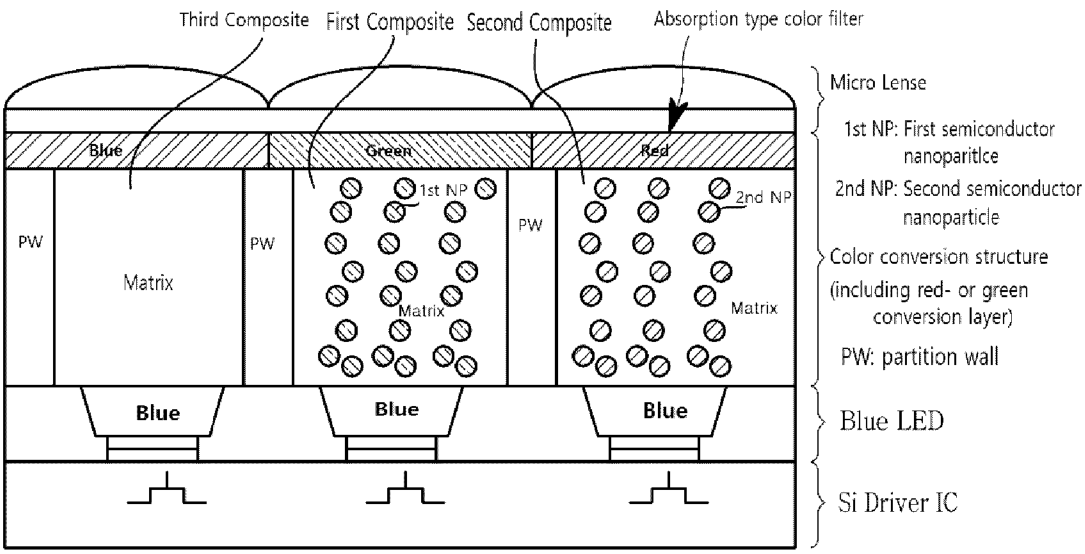
Third Composite
First Composite
Second Composite
Absorption type color filter
Blue
Green
Red
PW
Matrix
1st NP
2nd NP
Micro Lense
1st NP: First semiconductor nanoparitlce
2nd NP: Second semiconductor nanoparticle
Color conversion structure (including red- or green conversion layer)
PW: partition wall
Blue LED
Si Driver IC

FIG. 3A

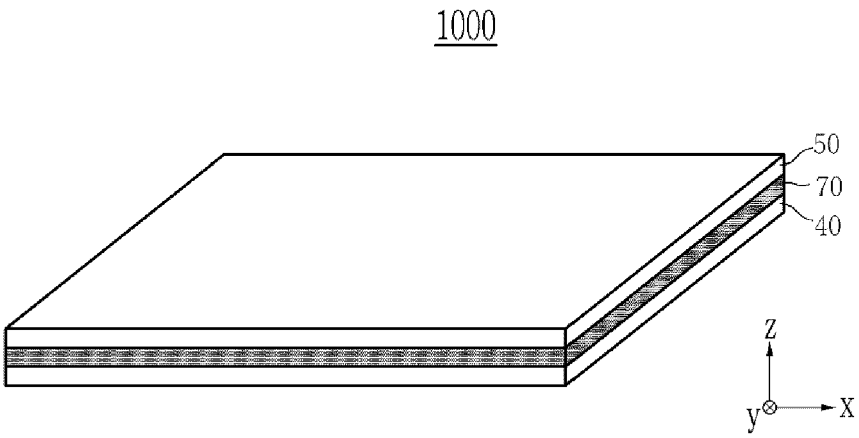

FIG. 3B

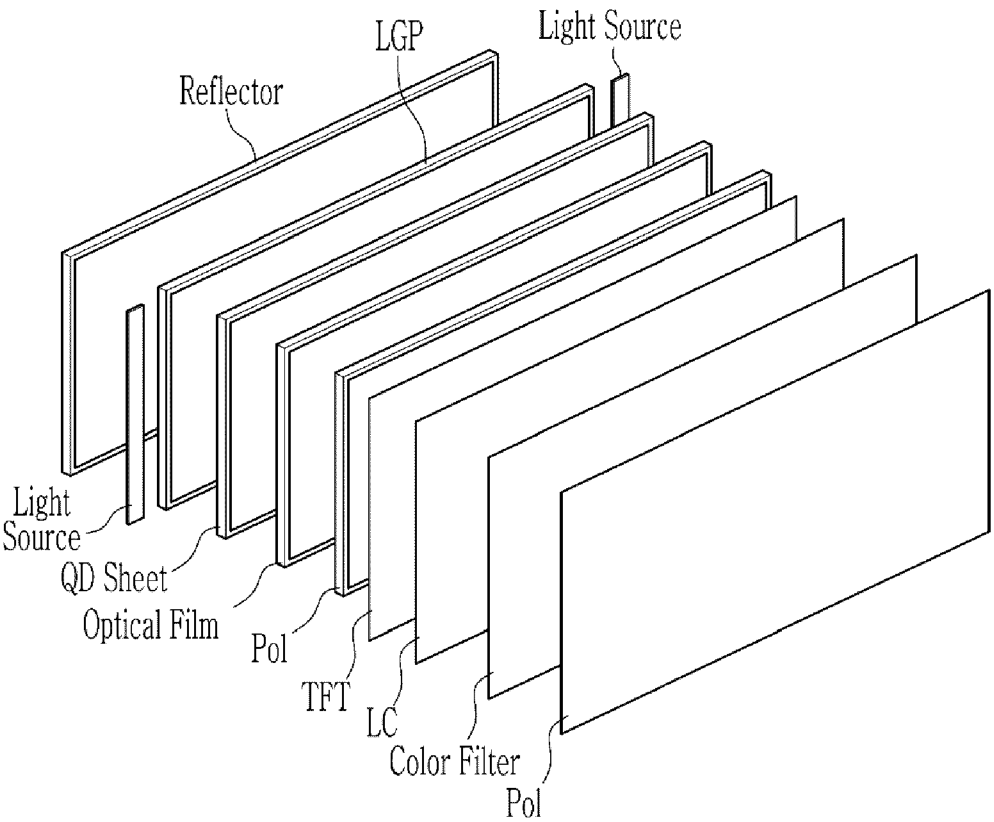
LGP
Light Source
Reflector
Light Source
QD Sheet
Optical Film
Pol
TFT
LC
Color Filter
Pol

FIG. 3C

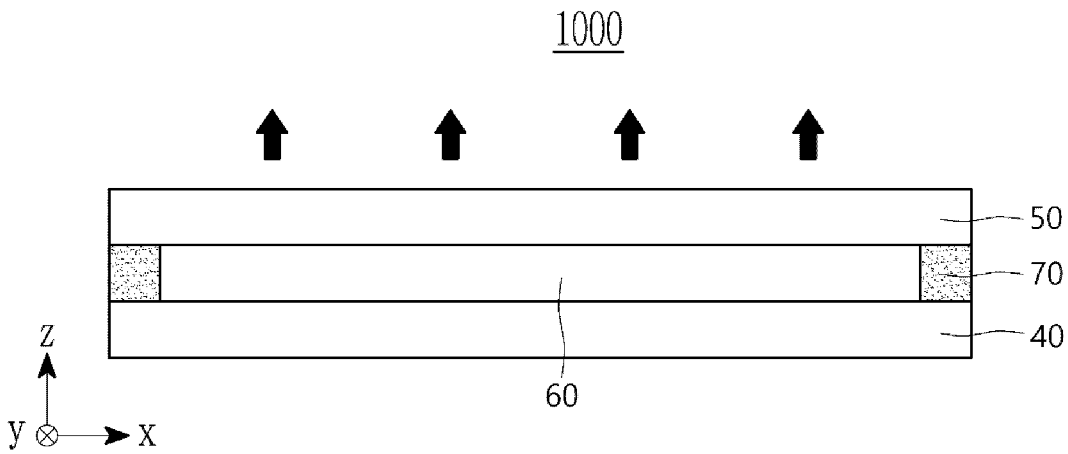

FIG. 4

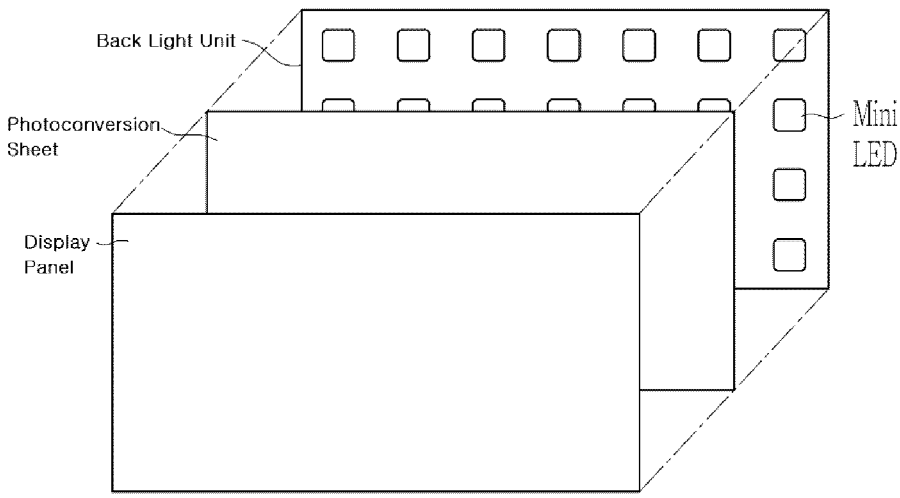
Back Light Unit
Photoconversion Sheet
Display Panel
Mini LED

FIG. 5A

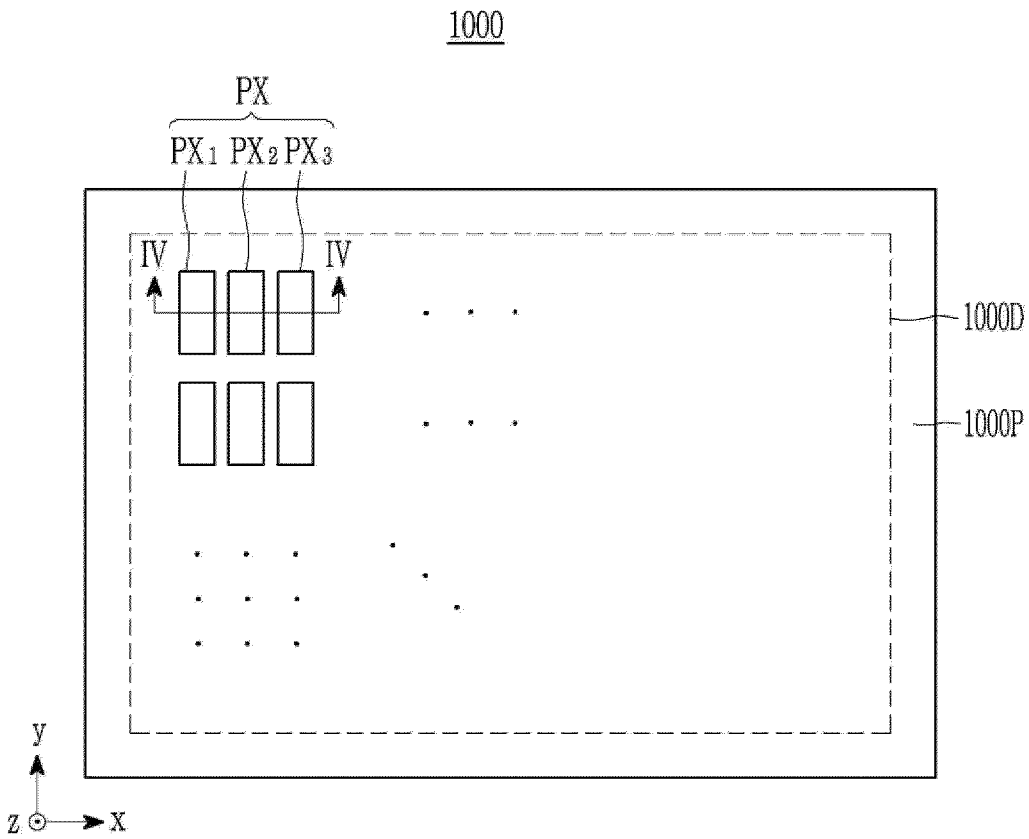
1000
PX
PX1 PX2 PX3
IV
IV
1000D
1000P
y
z
x

FIG. 5B

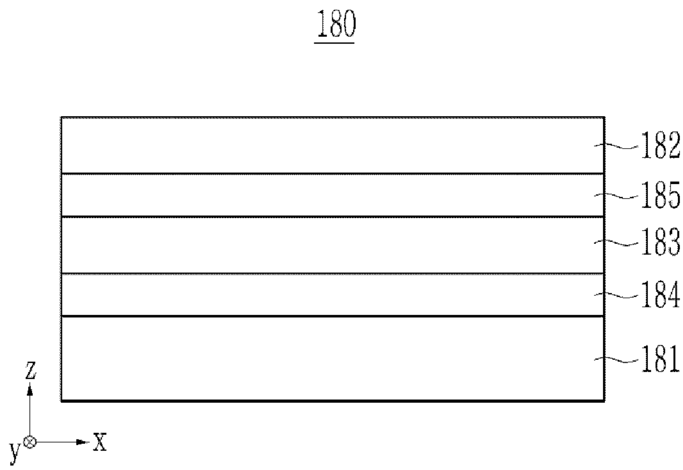
180
182
185
183
184
181
z
y
x

FIG. 5C

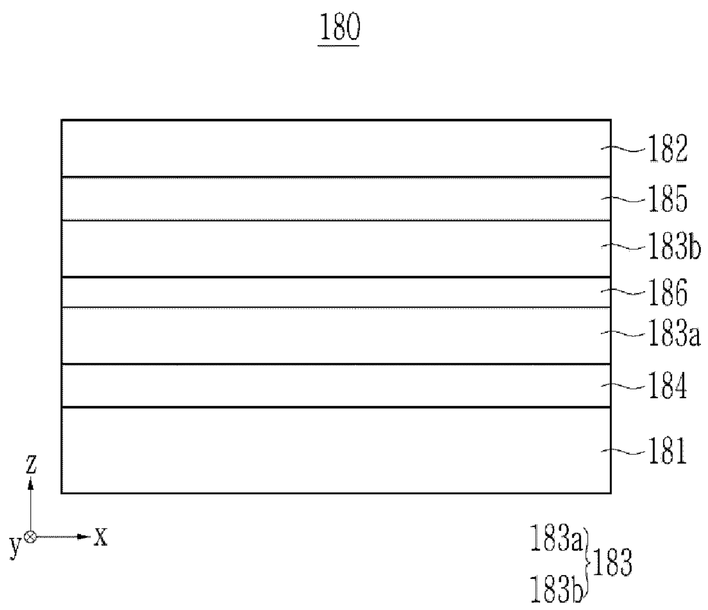
180
182
185
183b
186
183a
184
181
z
y
x
183a
183b
183

FIG. 5D

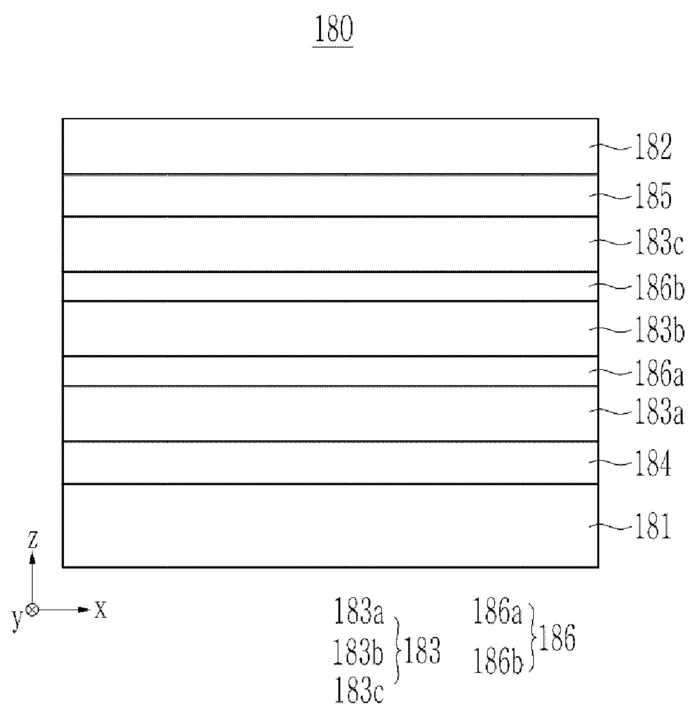
180
182
185
183c
186b
183b
186a
183a
184
181
z
y
x
183a
183b
183c
183
186a
186b
186

FIG. 5E

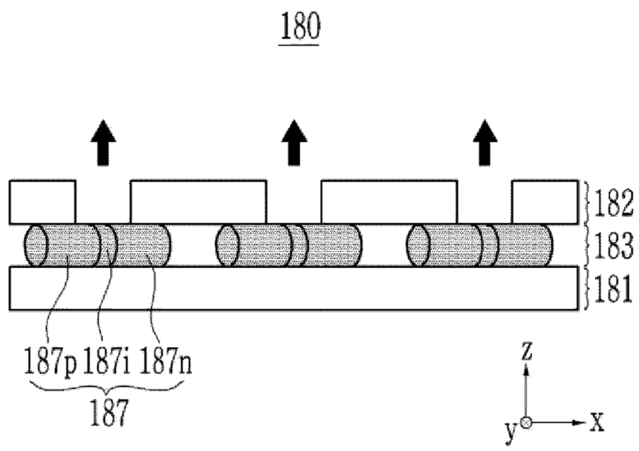

FIG. 6

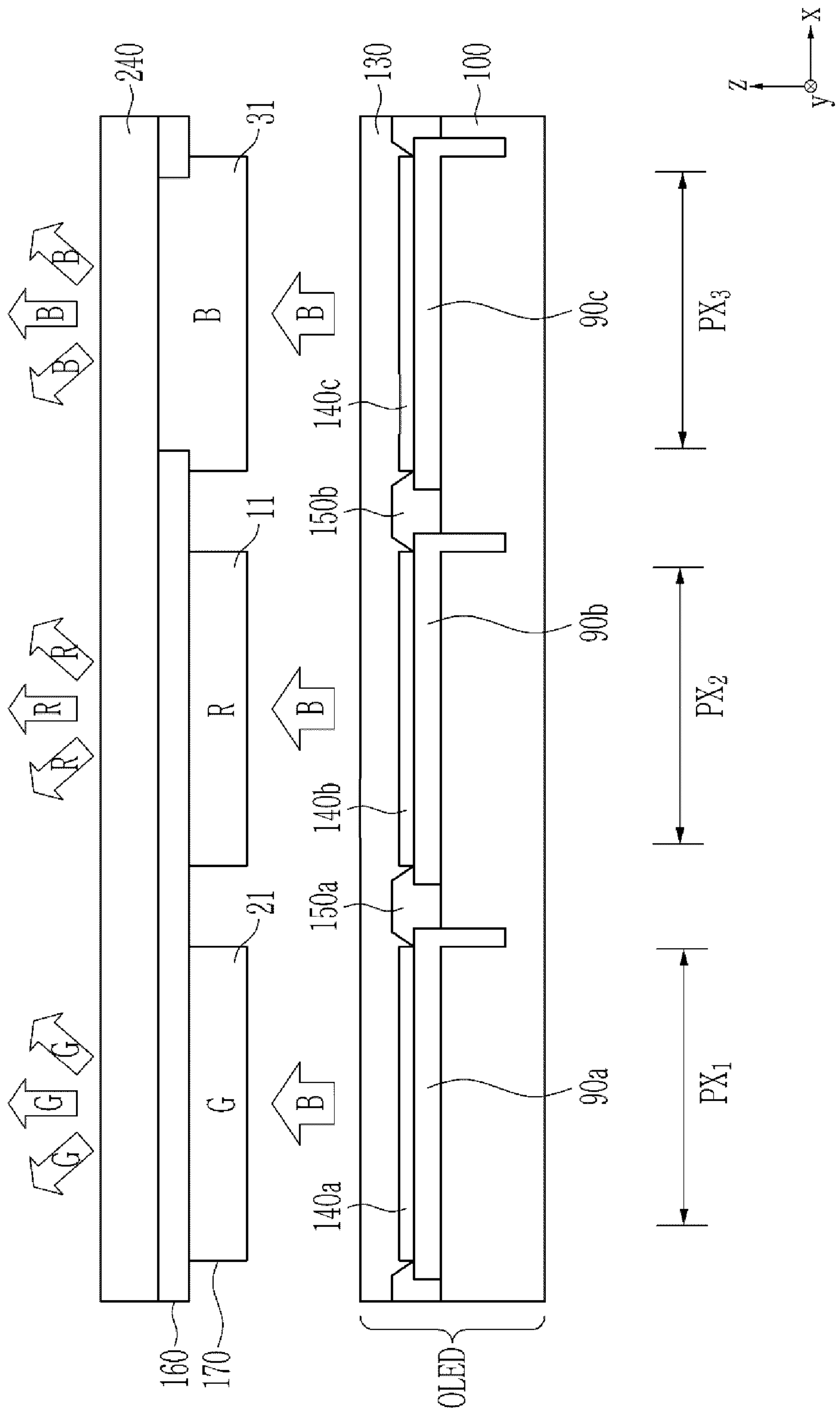
240
31
B
B
B
B
B
11
R
R
R
R
B
21
G
G
G
G
B
160
170
130
100
140c
150b
140b
150a
140a
90c
90b
90a
PX3
PX2
PX1
OLED
X
Z
y

FIG. 7A

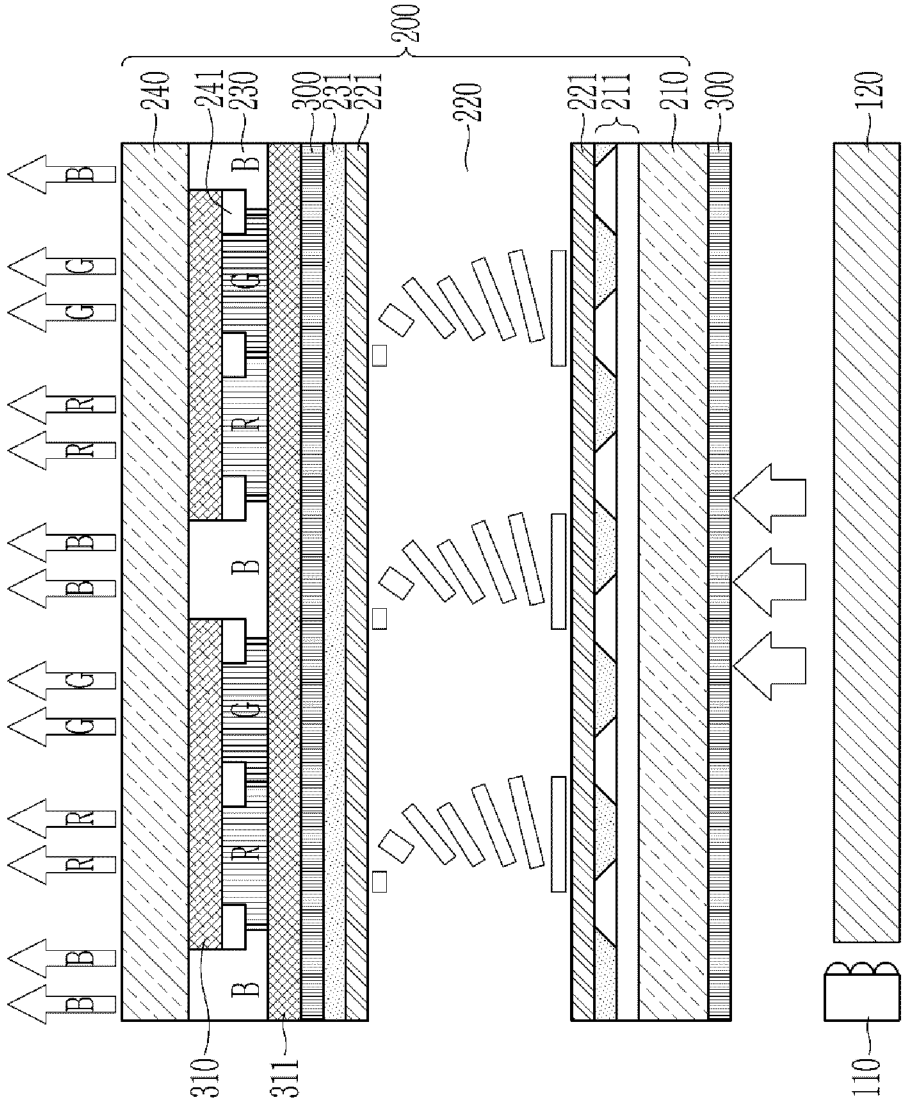
200
240
241
230
300
231
221
220
221
211
210
300
120
310
311
110
B
G
R

FIG. 7B

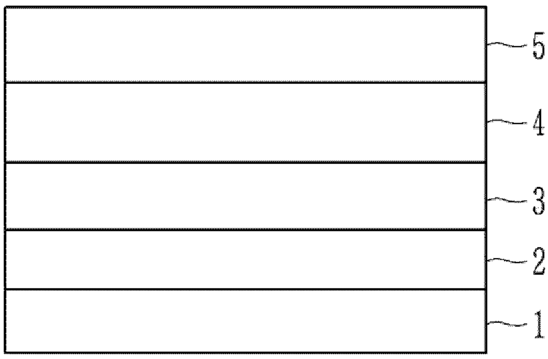

FIG. 8

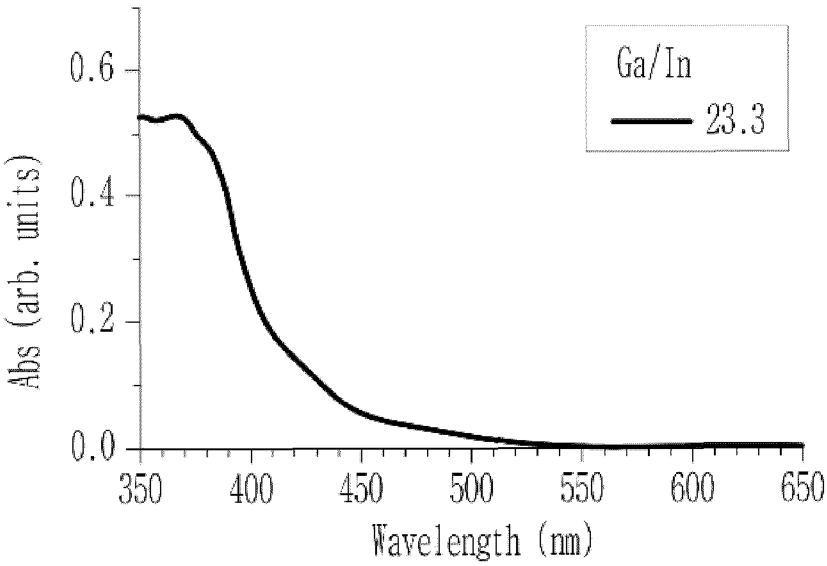
Ga/In
23.3
0.6
0.4
0.2
0.0
Abs (arb. units)
350
400
450
500
550
600
650
Wavelength (nm)

Europäisches Patentamt
European Patent Office
Office européen des brevets

# EUROPEAN SEARCH REPORT

Application Number
EP 25 15 4346

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 4 306 611 A1 (NATIONAL UNIV CORPORATION TOKAI NATIONAL HIGHER EDUCATION AND RESEARCH) 17 January 2024 (2024-01-17)<br>* paragraphs [0020], [0042], [0122] - [0124]; claims; examples *<br>----- | 1-15 | INV.<br>C09K11/62 |
| X | US 2023/002672 A1 (TANGIRALA RAVISUBHASH [US] ET AL) 5 January 2023 (2023-01-05)<br>* claims; examples; tables 8,9,11 *<br>----- | 1-8, 12-15 | |

TECHNICAL FIELDS SEARCHED (IPC)

C09K

The present search report has been drawn up for all claims

1

| Place of search | Date of completion of the search | Examiner |
|---|---|---|
| The Hague | 12 June 2025 | Lehnert, Andreas |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

# ANNEX TO THE EUROPEAN SEARCH REPORT ON EUROPEAN PATENT APPLICATION NO. EP 25 15 4346

This annex lists the patent family members relating to the patent documents cited in the above-mentioned European search report. The members are as contained in the European Patent Office EDP file on
The European Patent Office is in no way liable for these particulars which are merely given for the purpose of information.

12-06-2025

| Patent document cited in search report | Publication date | Patent family member(s) | Publication date |
|---|---|---|---|
| EP 4306611 A1 | 17-01-2024 | CN 116941051 A | 24-10-2023 |
| | | EP 4306611 A1 | 17-01-2024 |
| | | JP WO2022191032 A1 | 15-09-2022 |
| | | WO 2022191032 A1 | 15-09-2022 |
| US 2023002672 A1 | 05-01-2023 | US 2023002672 A1 | 05-01-2023 |
| | | US 2024209257 A1 | 27-06-2024 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 20170052444 A1